(19) Europäisches Patentamt
European Patent Office
Office européen des brevets

(11) EP 3 030 627 B1

(12) # EUROPEAN PATENT SPECIFICATION

(45) Date of publication and mention of the grant of the patent:
**03.01.2018 Bulletin 2018/01**

(21) Application number: **14741807.3**

(22) Date of filing: **17.07.2014**

(51) Int Cl.:
***C09K 11/06*** (2006.01) ***H05B 33/14*** (2006.01)
***H01L 51/50*** (2006.01) ***H01L 51/00*** (2006.01)

(86) International application number:
**PCT/EP2014/001955**

(87) International publication number:
**WO 2015/018480 (12.02.2015 Gazette 2015/06)**

(54) **FORMULATION FOR THE PREPARATION OF ORGANIC ELECTRONIC (OE) DEVICES COMPRISING A POLYMERIC BINDER**

FORMULIERUNG ZUR HERSTELLUNG VON ORGANISCHEN ELEKTRONISCHEN VORRICHTUNGEN MIT EINEM POLYMEREN BINDEMITTEL

FORMULATION POUR LA PRÉPARATION DE DISPOSITIFS ÉLECTRONIQUES ORGANIQUES (OE) COMPRENANT UN LIANT POLYMÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.08.2013 EP 13003947**

(43) Date of publication of application:
**15.06.2016 Bulletin 2016/24**

(73) Proprietor: **Merck Patent GmbH**
**64293 Darmstadt (DE)**

(72) Inventors:
- **MAY, Philip Edward**
  **Sidcup DA15 9AS (GB)**
- **JAMES, Mark**
  **Romsey SO51 7LU (GB)**
- **WIERZCHOWIEC, Piotr**
  **Southampton SO16 4RG (GB)**
- **BAIN, Stephen**
  **Southampton SO16 3LS (GB)**
- **KLUGE, Edgar**
  **64521 Gross-Gerau (DE)**

(56) References cited:
**WO-A1-2007/082584 WO-A1-2011/076325**
**WO-A1-2011/090953**

- **MARIA LADA ET AL: "Morphology control via dual solvent crystallization for high-mobility functionalized pentacene-blend thin film transistors", JOURNAL OF MATERIALS CHEMISTRY, vol. 21, no. 30, 24 June 2011 (2011-06-24) , page 11232, XP055045320, ISSN: 0959-9428, DOI: 10.1039/c1jm11119a**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 030 627 B1

**Description**

## Field of the Invention

The present invention relates to novel formulations comprising an organic semiconductor (OSC), a polymeric binder and an organic solvent, to their use as conducting inks for the preparation of organic electronic (OE) devices, preferably organic photovoltaic (OPV) cells and organic light emitting diodes (OLED) devices, to methods for preparing OE devices using the novel formulations, and to OE devices, OPV cells and OLED devices prepared from such methods and formulations.

## Background and Prior Art

When preparing OE devices like OFETs, OPV cells or OLEDs, in particular flexible devices, usually printing or coating techniques like inkjet printing, roll to roll printing, slot dye coating or flexographic/gravure printing are used to apply the OSC layer. Based on low solubility of the most of the present organic compounds useful as OSC these techniques need the use of solvents in high amounts.

In order to improve the film forming ability binding agents can be used. These additives are especially needed with regard to light emitting materials and/or charge transporting materials having small molecular weight or polymeric compounds having a low molecular weight.

EP 1 883 124 A1 describes a formulation of a light-emitting material particularly suitable for forming displays and lamps via printing techniques comprising an organic-light emitting material housed in a protective porous matrix material, a binder and a solvent. However, the OLED material encompasses also polymeric materials. Furthermore, the binder material is disclosed as a long list without any detailed specification.

US 2007/0103059 discloses compositions comprising an OLED material and a polymer having very specific repeating units. The polymer having specific repeating units is added to improve the emitting efficiency of the OLED. Also polymeric OLED materials can be employed.

According to US 6,818,919 and US 7,115,430, polymers having a high glass transition temperature $T_g$ have to be used in order to process low molecular weight organic light emitting and charge transporting materials. However, these materials are expensive and limit the application of the compositions.

US 5,952,778 relates to an encapsulated organic light emitting device having an improved protective covering comprising a first layer of passivating metal, a second layer of an inorganic dielectric material and a third layer of polymer. The organic light emitting material can be polymeric or monomeric. The composition can contain a polymer binder. However, the binder material is disclosed in a long list without any detailed specification.

US 6,277,504 B1 discloses specific light emitting compounds and compositions comprising the same. The compositions may include a binder. However, no detailed specification of the binder is provided.

US 6,294,273 B1 describes light emitting compounds being soluble in methanol. The compositions comprising these compounds may contain a polymeric binders. However, the binder material is disclosed in a long list without any detailed specification.

WO 2005/055248 A2 relates to compositions comprising specific organic semiconductor compounds and an organic binder having a permittivity of 3.3 or less at 1000 Hz. However, the specific organic semiconductor compounds as disclosed in WO 2005/055248 A2 should form a layer having a high crystallinity in order to achieve a high efficiency. In contrast thereto, layers emitting light should usually have a low crystallinity for providing high efficiency. Therefore, the concept of WO 2005/055248 A2 cannot be applied to OLED layers.

WO 2007/082584 A1 discloses an electronic device, like an organic field emission transistor (OFET), which has a short source drain channel length and contains an organic semdiconducting formulation comprising a semiconducting binder.

WO 2011/076380 A1 discloses a composition comprising one or more organic semiconducting compounds and dimethyl anisole as solvent. However, no examples are provided using polymeric binders having a high molecular weight. Furthermore, WO 2011/076380 A1 relates to compositions for the preparation of OE devices having a viscosity below 15 mPas, preferred below 10 mPas.

WO 2011/076325 A1 describes a composition for the preparation of OLED devices comprising polymeric binders. However, no examples are provided using polymeric binders having a high molecular weight. Furthermore, preferred compositions comprise a viscosity below 15 mPas.

The prior art provides compositions being useful in order to process low molecular weight organic light emitting and charge transporting materials. However, it is a permanent desire to improve the performance of the OLED layer, such as efficiency, lifetime and sensitivity regarding oxidation or water.

In addition thereto, the formulation should enable a low-cost and easy printing process. The printing process should allow a high quality and high uniformity printing at high speed, for various print and coating processes including

e.g. flexo-, gravure-, screen- and stencil printing.

It is therefore desirable to have improved formulations comprising an OSC that are suitable for the preparation of OE devices, especially thin film transistors, diodes, OLED displays and OPV cells, which allow the manufacture of high efficient OE devices having a high performance, a long lifetime and a low sensitivity against water or oxidation. One aim of the present invention is to provide such improved formulations. Another aim is to provide improved methods of preparing an OE device from such formulations. Another aim is to provide improved OE devices obtained from such formulations and methods. Further aims are immediately evident to the person skilled in the art from the following description.

Surprisingly it has been found that these aims can be achieved, and the above-mentioned problems can be solved, by providing materials, devices and methods as claimed in the present invention.

## Summary of the Invention

The invention relates to a formulation comprising at least one organic semiconducting compound (OSC), at least one organic solvent, and at least one polymeric binder, wherein said at least one organic semiconducting compound is an organic light emitting material, wherein said at least one organic solvent comprises at least one aromatic and/or heteroaromatic compound and where said at least one polymeric binder is an inert binder, characterized in that said organic semiconducting compound has a molecular weight of at most 5.000 g/mol, said polymeric binder has a weight average molecular weight of at least 8.000.000 g/mol, determined by gel permeation chromatography, and said composition comprises a viscosity at 25°C of at least 15 mPas.

The invention further relates to the use of a formulation as described above and below as coating or printing ink for the preparation of OLED devices, in particular for rigid and flexible OLED devices.

The invention further relates to a process of preparing an organic electronic (OE) device, comprising the steps of

a) depositing the formulation as described above and below onto a substrate to form a film or layer, preferably by coating or printing, more preferably by flexographic or gravure printing, and

b) removing the at least one solvent.

The invention further relates to an OE device, preferably an OLED device, prepared from a formulation and/or by a process as described above and below.

The OE devices include, without limitation, organic field effect transistors (OFET), integrated circuits (IC), thin film transistors (TFT), Radio Frequency Identification (RFID) tags, organic light emitting diodes (OLED), organic light emitting electrochemical cell (OLEC), organic light emitting transistors (OLET), electroluminescent displays, organic photovoltaic (OPV) cells, organic solar cells (O-SC), flexible OPVs and O-SCs, organic laserdiodes (O-laser), organic integrated circuits (O-IC), lighting devices, sensor devices, electrode materials, photoconductors, photodetectors, electrophotographic recording devices, capacitors, charge injection layers, Schottky diodes, planarising layers, antistatic films, conducting substrates, conducting patterns, photoconductors, electrophotographic devices, organic memory devices, biosensors and biochips.

According to a preferred embodiment, the present invention provides organic light emitting diodes (OLED). OLED devices can for example be used for illumination, for medical illumination purposes, as signalling device, as signage devices, and in displays. Displays can be addressed using passive matrix driving, total matrix addressing or active matrix driving. Transparent OLEDs can be manufactured by using optically transparent electrodes. Flexible OLEDs are assessable through the use of flexible substrates.

The formulations, methods and devices of the present invention provide surprising improvements in the efficiency of the OE devices and the production thereof. Unexpectedly, the performance, the lifetime and the efficiency of the OE devices can be improved, if these devices are achieved by using a formulation of the present invention. Furthermore, it was surprisingly found that these formulations are suitable for printing techniques, especially for flexographic and gravure printing. Furthermore, the formulation of the present invention provides an astonishingly high level of film forming. Especially, the homogeneity and the quality of the films can be improved.

In addition thereto, the formulations enable a low-cost and easy printing process. The printing processes allow a high quality printing at high speed.

## Detailed Description of the Invention

The formulation of the present invention has a viscosity at 25°C of at least 15 mPas, preferably of at least 20 mPas and more preferably of at least 30 mPas. Preferably, the formulation has a viscosity in the range of 15 to 100 mPas, more preferably in the range from 20 to 90 mPas and most preferably in the range from 30 to 85 mPas. The viscosity is determined at a temperature of 25°C by measuring on AR-G2 rheometer manufactured by TA Instruments.

This is measured using a parallel plate geometry.

The viscosity of the formulation can be achieved by using appropriate solvents and other additives in suitable amounts.

Preferably, the formulation of the present invention comprises at least one organic solvent having a viscosity at 25°C of less than 15 mPas and a boiling point of at most 400°C. More preferably, the solvent comprises at least 80% by weight of compounds having a viscosity at 25°C of less than 15 mPas, most preferably of less than 10 mPas.

The solvent has a boiling point or sublimation temperature of < 400°C, preferably ≤ 350°C, more preferably ≤ 300°C, and most preferably ≤ 250°C, at the pressure employed, preferably at atmospheric pressure (1013 hPa). Evaporation can also be accelerated e.g. by applying heat and/or reduced pressure.

Further preferably the boiling point of the solvent, or of the lowest boiling solvent of the solvent blend, is at least 130°C, more preferably at least 150°C at atmospheric pressure (1013 hPa).

According to a preferred embodiment of the present invention, the formulation comprises a mixture of organic solvents having different boiling points and the boiling point of the compound with the lowest boiling point is at least 10°C below the boiling point of the compound with the highest boiling point.

Furthermore, the formulation comprises a mixture of organic solvents having boiling points and the boiling point of the compound with the lowest boiling point is at most 100°C below the boiling point of the compound with the highest boiling point.

The solvent comprises at least one aromatic and/or heteroaromatic compound.

Suitable and preferred solvents include for example aromatic hydrocarbons (e.g. halogenated aromatics) and aromatic hydrocarbons having an alkyl or alkoxy group having 1 to 8 carbon atoms and more preferably 1 to 6 carbon atoms especially toluene, dimethyl benzenes (xylenes), trimethyl benzenes, methyl naphthalenes, and 3-phenoxytoluene; and aromatic hydrocarbon compound having a cycloalkyl group, especially cyclopentyl benzene and cyclohexyl benzene.

According to a further embodiment of the present invention, aromatic compounds comprising hetero atoms may be used such as esters, ethers, nitriles or amides. Preferably, these compounds include aromatic alkoxy compunds such as 3-methylanisol, 2-isopropylanisol, 5-methoxyindan, 2-ethoxynaphthalene, aromatic esters such as butylbenzoate and ethylbenzoate. Furthermore, heteroaromatic compounds having at least one O, N or S atom in the aromatic ring are preferred. These compounds include e.g. 2-bromo-3-(bromomethyl)thiophene, 2-methylindole, 6-methyl quinoline and thiophene.

The solvents can be used as mixture of two, three or more solvents.

Astonishing improvements can be achieved with mixtures of hydrocarbon aromatic compounds. Preferably, the mixture comprises at least one aromatic hydrocarbon having an alkyl group having 1 to 8 carbon atoms and at least one aromatic hydrocarbon compound having a cycloalkyl group.

Preferred organic solvents can comprise Hansen Solubility parameters of $H_d$ in the range of 17.0 to 23.2 $MPa^{0.5}$, $H_p$ in the range of 0.2 to 12.5 $MPa^{0.5}$ and $H_h$ in the range of 0.0 to 20.0 $MPa^{0.5}$. More preferred organic solvents comprise Hansen Solubility parameters of $H_d$ in the range of 17.0 to 23.2 $MPa^{0.5}$, $H_p$ in the range of 0.2 to 10.5 $MPa^{0.5}$ and $H_h$ in the range of 0.0 to 5.0 $MPa^{0.5}$.

Usually, the organic solvent can comprise a surface tension in the range of 15 to 80 mN/m, preferably in the range of 20 to 60 mN/m and more preferably in the range of 25 to 40 mN/m. The surface tension can be measured using a FTA (First Ten Angstrom) 1000 contact angle goniometer at 25°C. Details of the method are available from First Ten Angstrom as published by Roger P. Woodward, Ph.D. "Surface Tension Measurements Using the Drop Shape Method". Preferably, the pendant drop method can be used to determine the surface tension.

According to a preferred aspect of the present invention a mixture of solvents can be used having different surface tensions. Preferably, the mixture can comprise at least one solvent having a surface tension of at most 35 mN/m, more preferably of at most 30 mN/m and at least one solvent having a surface tension of at least 30, more preferably of at least 32 mN/m and the difference of the surface tension is at least 1 mN/m, more preferably at least 2 mN/m.

The surface tension can be measured using a FTA (First Ten Angstrom) 125 contact angle goniometer at 25°C. Details of the method are available from First Ten Angstrom as published by Roger P. Woodward, Ph.D. "Surface Tension Measurements Using the Drop Shape Method". Preferably, the pendant drop method can be used to determine the surface tension.

For the purpose for making a rough estimate, the surface tension can be calculated using the Hansen Solubility Parameters by the formula expounded in Hansen Solubility Parameters: A User's Handbook, Second Edition, C. M. Hansen (2007), Taylor and Francis Group, LLC (HSPiP manual).

Surface tension = $0.0146\ x(2.28x\delta H_d^2+\delta H_p^2+\delta H_h^2)xMVol^{0.2}$, where:

$H_d$ refers to Dispersion contribution
Hp refers to Polar contribution
$H_h$ refers to Hydrogen bonding contribution

MVol refers to Molar Volume.

The Hansen Solubility Parameters can be determined according to the Hansen Solubility Parameters in Practice HSPiP 3rd edition, (Software version 3.0.38) with reference to the Hansen Solubility Parameters: A User's Handbook, Second Edition, C. M. Hansen (2007), Taylor and Francis Group, LLC) as supplied by Hanson and Abbot et al.

Table 1: Hansen Solubility Parameters of useful solvents

| **Solvent** | $H_d$ [$MPa^{0.5}$] | $H_h$ [$Mp_a{}^{0.5}$] | $H_p$ [$MPa^{0.5}$] | Surface Tension Calc (Actual) | Boiling Point Calc (Actual) |
|---|---|---|---|---|---|
| 1,2,3,4-tetrahydronaphthalene (tetralin) | 19.1 | 2.3 | 4 | 33.3 (33.2) | 206.9 (207) |
| 1,2,3,4-tetramethylbenzene | 18.7 | 1.8 | 1.6 | 32.0 | 198.5 () |
| 1,2,3,5-tetramethylbenzene | 18.7 | 1.8 | 1.6 | 32.0 | 198.5 () |
| 1,2,3-trimethylbenzene | 19.0 | 2.9 | 1.6 | 32.6 | 171.6 () |
| 1,2,4,5-tetramethylbenzene | 18.7 | 1.8 | 1.6 | 32.0 | 198.5 () |
| 1,2,4-trichlorobenzene | 20.5 | 6.9 | 2.7 | 39.0 | 204.8 () |
| 1,2,4-trimethylbenzene | 19.0 | 2.9 | 1.6 | 32.6 | 171.6 () |
| 1,2-dihydronaphthalene | 20.1 | 5.5 | 4.9 | 37.7 | 209.5 (206) |
| 1,2-dimethylnaphthalene | 17.6 | 1.7 | 5.2 | 29.9 | 261.5 (266) |
| 1,3,3-trimethyl-2-methyleneindole | 17.9 | 1 | 3 | 30.6 | 296.9 (248) |
| 1,3-benzodioxole | 19.7 | 7.4 | 7.9 | 37.1 | 169.5 () |
| 1,3-diisopropylbenzene | 17.5 | 0.2 | 1.1 | 29.2 | 200 () |
| 1,3-dimethylnaphthalene | 17.6 | 1.7 | 5.2 | 29.9 | 261.5 (263) |
| 1,4-benzodioxane | 19.5 | 8.7 | 7.2 | 37.8 | 178.7 () |
| 1,4-diisopropylbenzene | 17.5 | 0.6 | 1.6 | 29.2 | 206.7 () |
| 1,4-dimethylnaphthalene | 17.6 | 1.7 | 5.2 | 29.9 | 261.5 (262) |
| 1,5-dimethyltetralin | 19.3 | 5.5 | 2.6 | 36.2 | 243 () |
| 1-benzothiophene | 19.7 | 12.3 | 6.3 | 36.5 | 107.5 () |
| 1-bromonaphthalene | 20.1 | 10.3 | 6.1 | 37.9 | 262.8 (133) |
| 1-chloromethyl naphthalene | 19.6 | 9.9 | 5.3 | 36.6 | 285 (287) |
| 1-ethylnaphthalene | 18.8 | 7.8 | 4.4 | 33.2 | 254 (258) |
| 1-methoxynaphthalene | 19.1 | 10.5 | 7.5 | 35.2 | 260.8 (269) |
| 1-methyl naphthalene | 19.2 | 8.4 | 4.5 | 34.0 (36.3) | 240 (243) |
| 1-methylindane | 19.4 | 5.7 | 2.5 | 35.2 | 199.1 () |
| 1-methylindole | 19.2 | 8.1 | 10 | 35.7 | 90 (133) |
| 2,3,3-trimethoxyindolenine | 19.6 | 6.8 | 4.2 | 37.7 | 228.4 (228) |
| 2,3-benzofuran | 21.3 | 5.5 | 5.6 | 38.0 | 113.7 () |
| 2,3-dihydrobenzofuran | 19.9 | 9.5 | 6.6 | 39.0 | 180.4 () |
| 2,3-dimethylanisol | 18.9 | 4.6 | 4.5 | 33.7 | 192.8 () |
| 2,4-dimethylanisol | 18.9 | 4.6 | 4.5 | 33.7 | 192.8 () |
| 2,5-dimethylanisol | 18.9 | 4.6 | 4.5 | 33.7 | 192.8 () |

(continued)

| Solvent | $H_d$ [MPa$^{0.5}$] | $H_h$ [Mp$_a$$^{0.5}$] | $H_p$ [MPa$^{0.5}$] | Surface Tension Calc (Actual) | Boiling Point Calc (Actual) |
|---|---|---|---|---|---|
| 2,6-diisopropyl naphthalene | 16.8 | 3.5 | 2.2 | 28.3 | 299 (300) |
| 2,6-dimethylanisol | 18.9 | 4.6 | 4.5 | 33.7 | 192.8 () |
| 2,6-dimethylnaphthalene | 17.6 | 5 | 3 | 29.9 | 261.5 (262) |
| 2-bromo-3-(bromomethyl) thiophene | 19.3 | 7.3 | 6.6 | 36.4 | 236.4 () |
| 2-bromomethyl naphthalene | 19.6 | 9.4 | 7.2 | 37.4 | 289.6 (291) |
| 2-bromonaphthalene | 20.1 | 10.3 | 6.1 | 37.9 | 262.8 (281) |
| 2-ethoxynaphthalene | 18.7 | 10 | 7 | 34.3 | 271.6 (282) |
| 2-ethylnaphthalene | 18.8 | 7.8 | 4.4 | 33.2 | 254.1 (251) |
| 2-isopropylanisol | 17.7 | 4.3 | 5.4 | 30.8 | 201.5 () |
| 2-ethyl quinoline | 20.0 | 7.8 | 4 | 35.7 | 141.5 () |
| 2-methylanisol | 18.3 | 5.1 | 6.2 | 31.9 | 169 () |
| 2-methylindole | 17.8 | 9.7 | 4.8 | 29.6 | 134.3 (228) |
| 3,4-dimethyl anisole | 18.9 | 4.6 | 4.5 | 33.7 | 192.8 (201) |
| 3,5-dimethylanisol | 18.9 | 4.6 | 4.5 | 33.7 | 192.8 () |
| 3-bromoquinoline | 21.4 | 8.7 | 5.1 | 41.2 | 169.3 () |
| 3-isopropylbiphenyl | 19.1 | 1.3 | 1.9 | 35.3 | 277.1 0 |
| 3-methylanisol | 18.7 | 5.7 | 5.4 | 33.1 | 171.7 () |
| 4-isopropylbiphenyl | 19.0 | 2.5 | 1.9 | 35.2 | 282.4 |
| 4-methyl anisole | 18.6 | 5.9 | 7.2 | 33.8 | 178.5 (174) |
| 4-phenyl-2-butanone (benzyl acetone) | 18.3 | 8.8 | 5 | 34.4 | 241.4 |
| 5-decanolide | 17.1 | 7.8 | 3.8 | 30.7 | 278.4 |
| 5-methoxyindan | 19.8 | 9.8 | 4 | 39.7 | 235.9 (232.5) |
| 5-methoxyindole | 17.4 | 12.3 | 7.8 | 32.7 | 158.2 (176) |
| 5-tert-butyl-m-xylene | 17.6 | 3.4 | 2.2 | 30.1 | 213.8 |
| 6-methoxy-1,2,3,4-tetrahydronapthalene | 19.4 | 6.8 | 5.4 | 37.6 | 241 (269) |
| 3-methyl quinoline | 21.7 | 8.4 | 4.5 | 41.9 | 140.4 |
| 8-methyl quinoline | 21.7 | 8.4 | 4.5 | 41.9 | 140.4 |
| Acetophenone | 18.8 | 10.8 | 5.5 | 36.1 | 187.1 |
| Anisole | 18.5 | 5.5 | 5.2 | 31.4 (34.5) | 144.8 (154) |
| a-pinene | 17.4 | 3 | 3.2 | 28.5 (27.6) | 165.2 |
| Benzonitrile | 19.2 | 11.9 | 4.7 | 36.9 (39.0) | 193.7 |
| Benzothiazole | 21.3 | 5.5 | 5.6 | 38.0 | 113.7 |
| benzyl acetate | 18.2 | 7.3 | 6.4 | 33.5 | 215.8 |
| Bromobenzene | 19.8 | 7.6 | 4.3 | 35.8 | 162.9 |
| Butylbenzene | 17.6 | 2.6 | 1.7 | 28.7 | 183.1 |

(continued)

| **Solvent** | $H_d$ [$MPa^{0.5}$] | $H_h$ [$Mp_a{}^{0.5}$] | $H_p$ [$MPa^{0.5}$] | Surface Tension Calc (Actual) | Boiling Point Calc (Actual) |
|---|---|---|---|---|---|
| Butylbenzoate | 17.7 | 5.9 | 5.2 | 31.9 | 241.8 |
| Butyl phenyl ether | 17.8 | 4.1 | 5 | 30.9 | 208 (210) |
| Cyclohexylbenzene | 18.6 | 1 | 1.6 | 32.3 (34.3) | 238.7 (239) |
| Decahydronaphthalene | 17.5 | 0.4 | 1 | 28.2 (30.9) | 192 (189) |
| dimethoxytoluene | 18.8 | 6.5 | 7 | 35.8 | 225 |
| diphenyl ether | 19.9 | 2.9 | 3.3 | 37.1 | 268.4 (259) |
| ethyl phenyl keton (propiophenone) | 18.3 | 8.9 | 5.3 | 33.9 | 202.5 |
| Ethylbenzene | 18.2 | 2.7 | 2.1 | 29.3 (28.6) | 141.1 |
| Ethylbenzoate | 18.1 | 6.6 | 5.9 | 32.5 | 210 (212) |
| gamma-terpinene | 18.0 | 2.5 | 2.8 | 30.2 | 180.4 |
| Hexylbenzene | 17.4 | 2.9 | 1.6 | 29.2 | 226.2 |
| Indan | 19.7 | 7.3 | 5.8 | 37.0 | 188.9 (176) |
| ndene | 20.3 | 4.4 | 5.4 | 37.3 | 188.6 |
| iso-amylbenzene | 17.1 | 3.7 | 1.8 | 28.0 | 198.5 |
| iso-butylbenzene | 17.1 | 2.9 | 1.6 | 27.2 | 179.3 |
| Isochroman | 19.6 | 5.4 | 3.8 | 35.4 | 201 |
| isopropylbenzene (cumene) | 17.8 | 2 | 1.1 | 28.5 (27.4) | 155 |
| m-cymene | 18.1 | 2 | 2.1 | 30.3 | 173.7 |
| mesitylene | 19.0 | 2.9 | 1.6 | 32.6 (28.5) | 171.6 (166) |
| methyl benzoate | 18.5 | 7.9 | 6.4 | 34.8 | 215.8 |
| methylphenylacetate | 18.2 | 7.3 | 6.4 | 33.5 | 215.8 |
| m-xylene | 18.8 | 3.1 | 2.7 | 31.4 | 144.8 |
| n-butoxybenzene | 17.5 | 4.4 | 4.1 | 29.7 | 202.1 |
| n-butylbenzene | 17.6 | 2.6 | 1.7 | 28.7 | 183.1 |
| n-propyl benzoate (propyl benzoate) | 17.8 | 6.6 | 6.3 | 32.5 | 222.7 |
| n-propylbenzene | 17.8 | 3.4 | 2.8 | 29.1 | 161.5 |
| o-dichlorobenzene | 19.5 | 8.7 | 3.3 | 35.9 | 179.8 |
| o-diethylbenzenes | 17.7 | 0.7 | 1.9 | 32.6 | 321.3 |
| o-ethyltoluene | 18.0 | 1.9 | 2.8 | 29.4 | 161.5 |
| o-xylene | 18.4 | 2 | 2.9 | 29.9 (29.5) | 147.7 |
| pentylbenzene | 17.4 | 3 | 1.8 | 28.7 | 204.1 |
| p-ethyltoluene | 18.3 | 3.5 | 2.8 | 30.7 | 168.6 |
| phenetol | 18.1 | 4.6 | 4.6 | 30.5 | 163.7 (170) |
| phenyl acetate | 18.5 | 7.9 | 6.4 | 34.0 | 194.4 |
| p-isopropyltoluene (p-cymene) | 18.0 | 2.5 | 2.8 | 30.2 | 180.4 |

(continued)

| Solvent | $H_d$ [$MPa^{0.5}$] | $H_h$ [$Mpa^{0.5}$] | $H_p$ [$MPa^{0.5}$] | Surface Tension Calc (Actual) | Boiling Point Calc (Actual) |
|---|---|---|---|---|---|
| propiophenone | 18.3 | 8.9 | 5.3 | 33.9 | 202.5 |
| p-xylene | 18.7 | 3.3 | 3.3 | 31.3 (27.8) | 151.7 |
| sec-butylbenzene | 17.2 | 2.2 | 1.6 | 27.3 | 176.8 |
| t-butylbenzene | 17.2 | 1.3 | 2.9 | 27.5 | 168 |
| thiophene | 18.8 | 5.2 | 7.4 | 30.9 | 91.9 |
| toluene | 18.6 | 4 | 2.2 | 30.0 | 118.3 |
| veratrole | 18.2 | 6.3 | 8 | 33.1 | 190 (206) |
| $H_d$ refers to Dispersion contribution<br>$H_p$ refers to Polar contribution<br>$H_h$ refers to Hydrogen bonding contribution | | | | | |

Preferably, the solvent comprises a relative evaporation rate (Butyl acetate = 100) of at least 0.01, more preferably of at least 0.1, most preferably of at least 0.5, and in particular of at least 2. The relative evaporation rate can be determined according to DIN 53170:2009-08. For the purpose for making a rough estimate, the relative evaporation rate can be calculated using the Hansen Solubility Parameters with the HSPiP program as mentioned above and below.

The formulation of the present invention comprises preferably at least 70 % by weight, more preferably at least 80 % by weight and most preferably at least 90 % by weight of organic solvents.

Furthermore, the present formulation comprises at least one organic semiconducting compound (OSC), wherein said at least one organic semiconducting compound is an organic light emitting material. The OSC compounds can be selected from standard materials known to the skilled person and described in the literature. The OSC may be a monomeric compound (also referred to as "small molecule", as compared to a polymer or macromolecule), or a mixture, dispersion or blend containing one or more compounds selected from monomeric compounds.

According to an aspect of the present invention, the OSC is preferably a conjugated aromatic molecule, and contains preferably at least three aromatic rings, which can be fused or unfused. Unfused rings are connected e.g. via a linkage group, a single bond or a spiro-linkage. Preferred monomeric OSC compounds contain one or more rings selected from the group consisting of 5-, 6- or 7-membered aromatic rings, and more preferably contain only 5- or 6-membered aromatic rings.

Each of the aromatic rings optionally contains one or more hetero atoms selected from Se, Te, P, Si, B, As, N, O or S, preferably from N, O or S.

The aromatic rings may be optionally substituted with alkyl, alkoxy, polyalkoxy, thioalkyl, acyl, aryl or substituted aryl groups, halogen, particularly fluorine, cyano, nitro or an optionally substituted secondary or tertiary alkylamine or aryl-amine represented by $-N(R^x)(R^y)$, where $R^x$ and $R^y$ independently of each other denote H, optionally substituted alkyl, optionally substituted aryl, alkoxy or polyalkoxy groups. Where $R^x$ and/or $R^y$ denote alkyl or aryl these may be optionally fluorinated.

Preferred rings are optionally fused, or are optionally linked with a conjugated linking group such as $-C(T^1)=C(T^2)-$, $-C\equiv C-$, $-N(R^z)-$, $-N=N-$, $-(R^z)C=N-$, $-N=C(R^z)-$, wherein $T^1$ and $T^2$ independently of each other denote H, Cl, F, $-C\equiv N-$ or a lower alkyl group, preferably a $C_{1-4}$ alkyl group, and $R^z$ denotes H, optionally substituted alkyl or optionally substituted aryl. Where $R^z$ is alkyl or aryl these may be optionally fluorinated.

Preferred OSC compounds include small molecules (i.e. monomeric compounds), selected from condensed aromatic hydrocarbons such as tetracene, chrysene, pentacene, pyrene, perylene, coronene, or soluble substituted derivatives of the aforementioned; oligomeric para-substituted phenylenes such as p-quaterphenyl (p-4P), p-quinquephenyl (p-5P), p-sexiphenyl (p-6P), or soluble substituted derivatives of the aforementioned; pyrazoline compounds; benzidine compounds; stilbene compounds; triazines; substituted metallo- or metal-free porphines, phthalocyanines, fluorophthalocyanines, naphthalocyanines or fluoronaphthalocyanines; $C_{60}$ and $C_{70}$ fullerenes or derivatives thereof; *N,N'*-dialkyl, substituted dialkyl, diaryl or substituted diaryl-1,4,5,8-naphthalenetetracarboxylic diimide and fluoro derivatives; *N,N'*-dialkyl, substituted dialkyl, diaryl or substituted diaryl 3,4,9,10-perylenetetracarboxylic diimide; bathophenanthroline; diphenoquinones; 1,3,4-oxadiazoles; 11,11,12,12-tetracyanonaptho-2,6-quinodimethane; $\alpha,\alpha'$-bis(dithieno[3,2-b:2',3'-d]thiophene); 2,8-dialkyl, substituted dialkyl, diaryl or substituted diaryl anthradithiophene; 2,2'-bibenzo[1,2-b:4,5-b']dithiophene. Preferred compounds are those from the above list and derivatives thereof which are soluble.

The formulation of the present invention comprises between 0.01 and 20% by weight, preferably between 0.1

and 15% by weight, more preferably between 0.2 and 10% by weight and most preferably between 0.25 and 5% by weight of OSC materials or the corresponding blend. The percent data relate to 100% of the solvent or solvent mixture. The formulation comprises one or more than one, preferably 1, 2, 3 or more than three OSC compounds.

The organic semiconductor compound used here is either a pure component or a mixture of two or more components, at least one of which must have semiconducting properties. In the case of the use of mixtures, however, it is not necessary for each component to have semiconducting properties. Thus, for example, inert low-molecular-weight compounds can be used together with semiconducting low-molecular-weight compounds. It is likewise possible to use non-conducting polymers, which serve as inert matrix or binder, together with one or more low-molecular-weight compounds or further polymers having semiconducting properties. For the purposes of this application, the potentially admixed non-conducting component is taken to mean an electro-optically inactive, inert, passive compound.

The organic semiconducting compound of the present invention has preferably a molecular weight of 5000 g/mol or less, and more preferably a molecular weight of 2000 g/mol or less.

According to a preferred aspect of the present invention, the organic semiconducting compound preferably has a molecular weight of at least 550 g/mol, more preferably of at least 800 g/mol, most preferably of at least 900 g/mol and in particular of at least 950 g/mol.

Astonishing improvements can be achieved with one or more organic semiconducting compounds having a high solubility. Preferred organic semiconducting compounds comprise Hansen Solubility parameters of $H_d$ in the range of 17.0 to 20.0 $MPa^{0.5}$, Hp in the range of 0.0 to 10.0 $MPa^{0.5}$ and $H_h$ in the range of 0.0 to 15.0 $MPa^{0.5}$. More preferred organic semiconducting compounds comprise Hansen Solubility parameters of $H_d$ in the range of 17.5 to 19.0 $MPa^{0.5}$, Hp in the range of 0.5 to 5.0 $MPa^{0.5}$ and $H_h$ in the range of 0.5 to 5.0 $MPa^{0.5}$ (for information FADT Hd18, Hp 1 Hh 1.3).

Surprising effects can be achieved with organic semiconducting compounds having a radius of at least 3.0 $MPa^{0.5}$, preferably at least 4.5 $MPa^{0.5}$ and more preferably at least 5.0_$MPa^{0.5}$ determined according to Hansen Solubility parameters.

The Hansen Solubility Parameters can be determined according to the Hansen Solubility Parameters in Practice HSPiP 3rd edition, (Software version 3.0.38) with reference to the Hansen Solubility Parameters: A User's Handbook, Second Edition, C. M. Hansen (2007), Taylor and Francis Group, LLC) as supplied by Hanson and Abbot et al.

The positions $H_d$, Hp and $H_h$ are the coordinates in 3 dimensional space for the centre of the organic semiconducting compound, whilst the radius, gives the distance that the solubility extends, i.e. if the radius is large it will encompass more solvents that would dissolve the material and conversely if it was small then a restricted number of solvents would solubilise the organic semiconducting compound.

According to a preferred aspect of the present invention the organic semiconducting compound comprises a high glass transition temperature. Preferably, the organic semiconducting compound has a glass transition temperature of at least 70°C, more preferably at least 100°C and most preferably at least 125°C determined according to DIN 51005.

Preferred organic semiconducting compounds comprise groups providing solubility to the compounds. In addition thereto, other functional compounds useful for preparing OE devices, especially OLED devices may comprise solubilising groups. Other functional compounds include, e.g. host materials, hole-transport materials, electron- or exciton-blocking materials, matrix materials for fluorescent or phosphorescent compounds, hole-blocking materials or electron-transport materials.

Accordingly, these compounds may preferably be represented by general formula (I),

$$A[B]_k \qquad (I)$$

wherein

A is a functional structure element,
B is a solubilising structure element and
k is a integer in the range of 1 to 20,

and said solubilising structure element B has the general formula (L-I)

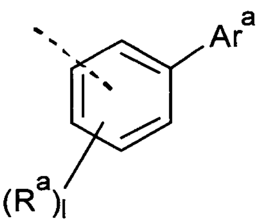

(L-I)

wherein

$Ar^a$ represents aryl or heteroaryl group which has from 4 to 120 carbon atoms and may be substituted by one or more arbitrary residues R,

$R^a$ represents hydrogen, a straight chain alkyl, alkoxy or thioalkoxy group having 1 to 40 carbon atoms or a branched or cyclic alkyl, alkoxy or thioalkoxy group having 3 to 40 carbon atoms, preferably an optionally substituted $C_7$-$C_{40}$ alkylaryloxy group; an optionally substituted $C_2$-$C_{40}$ alkoxycarbonyl group; an optionally substituted $C_7$-$C_{40}$ aryloxycarbonyl group; a cyano group (-CN); a carbamoyl group (-C(=O)$NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl or alkynylsilyl group; or a curable group or a substituted or unsubstituted aromatic or hetero aromatic ring system having 5 to 60 ring atoms, or an aryloxy or heteroaryloxy group having 5 to 60 ring atoms, or a combination thereof, wherein one or more of these groups $R^a$ may form a mono or polycyclic aliphatic or aromatic ring system together and/or the ring to which the group $R^a$ is bound; and

I is 0, 1, 2, 3 or 4;

wherein the dotted bond represents the bond to the functional structural element A.

Preferably, the index k of the general formula (I) is an integer of 2 or more, more preferably 3 or more.

For the purposes of the present invention, an aryl group contains at least 6 C atoms; for the purposes of the present invention, a heteroaryl group contains at least 2 C atoms and at least one heteroatom, with the proviso that the sum of C atoms and heteroatoms is at least 5. The heteroatoms are preferably selected from N, O and/or S. An aryl group or heteroaryl group here is taken to mean either a simple aromatic ring, i.e. benzene, or a simple heteroaromatic ring, for example pyridine, pyrimidine, or thiophene, or a condensed aryl or heteroaryl group, for example naphthalene, anthracene, pyrene, quinoline, or isoquinoline.

For the purposes of the present invention, an aromatic ring system contains at least 6 C atoms in the ring system. For the purposes of the present invention, a heteroaromatic ring system contains at least 2 C atoms and at least one heteroatom in the ring system, with the proviso that the sum of C atoms and heteroatoms is at least 5. The heteroatoms are preferably selected from N, O and/or S. For the purposes of the present invention, an aromatic or heteroaromatic ring system is intended to be taken to mean a system which does not necessarily contain only aryl or heteroaryl groups, but instead in which, in addition, a plurality of aryl or heteroaryl groups may be interrupted by a short non-aromatic unit (preferably less than 10% of the atoms other than H), such as, for example, an $sp^3$-hybridised C, N or O atom or a carbonyl group. Thus, for example, systems such as 9,9'-spirobifluorene, 9,9-diarylfluorene, triarylamine, diaryl ether, stilbene, and benzophenone, are also intended to be taken to be aromatic ring systems for the purposes of the present invention. An aromatic or heteroaromatic ring system is likewise taken to mean systems in which a plurality of aryl or heteroaryl groups are linked to one another by single bonds, for example biphenyl, terphenyl or bipyridine.

For the purposes of the present invention, a $C_1$- to $C_{40}$-alkyl group, in which, in addition, individual H atoms or $CH_2$ groups may be substituted by the above-mentioned groups, is preferably taken to mean the radicals methyl, ethyl, n-propyl, i-propyl, n-butyl, i-butyl, s-butyl, t-butyl, 2-methylbutyl, n-pentyl, s-pentyl, t-pentyl, 2-pentyl, neopentyl, cyclopentyl, n-hexyl, s-hexyl, t-hexyl, 2-hexyl, 3-hexyl, neohexyl, cyclohexyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2.2.2]octyl, 2-bicyclo[2.2.2]octyl, 2-(2,6-dimethyl)octyl, 3-(3,7-dimethyl)octyl, trifluoromethyl, pentafluoroethyl and 2,2,2-trifluoroethyl. A $C_2$- to $C_{40}$-alkenyl group is preferably taken to mean ethenyl, propenyl, butenyl, pentenyl, cyclopentenyl, hexenyl, cyclohexenyl, heptenyl, cycloheptenyl, octenyl or cyclooctenyl. A $C_2$- to $C_{40}$-alkynyl group is preferably taken to mean ethynyl, propynyl, butynyl, pentynyl, hexynyl, heptynyl or octynyl. A $C_1$- to $C_{40}$-alkoxy group is preferably taken to mean methoxy, trifluoromethoxy, ethoxy, n-propoxy, i-propoxy, n-butoxy, i-butoxy, s-butoxy, t-butoxy or 2-methylbutoxy. An aromatic or heteroaromatic ring system having 5 - 60 aromatic ring atoms, which may also in each case be substituted by the above-mentioned radicals R and which may be linked to the aromatic or heteroaromatic ring system via any desired positions, is preferably taken to mean groups derived from benzene, naphthalene, anthracene, phenanthrene, benz-anthracene, benzophenanthrene, pyrene, chrysene, perylene, fluoranthene, benzofluoranthene, naphthacene, pentacene, benzopyrene, biphenyl, biphenylene, terphenyl, terphenylene, fluorene, benzofluorene, dibenzofluorene, spirobifluorene, dihydrophenanthrene, dihydropyrene, tetrahydropyrene, cis- or trans-indenofluorene, cis- or trans-monobenzo-indenofluorene, cis- or trans-dibenzoindenofluorene, truxene, isotruxene, spirotruxene, spiroisotruxene, furan, benzofuran, isobenzofuran, dibenzo-furan, thiophene, benzothiophene, isobenzothiophene, dibenzothiophene, pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole,

pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, 1,5-diazaanthracene, 2,7-diazapyrene, 2,3-diazapyrene, 1,6-diazapyrene, 1,8-diazapyrene, 4,5-diazapyrene, 4,5,9,10-tetraazaperylene, pyrazine, phenazine, phenoxazine, phenothiazine, fluorubin, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole.

A curable group means a functional group being able to react irreversible in order to form a cross-linked material being insoluble. The cross-linking can be sustained by heating or UV-, microwave, x-ray or electron beam irradiation. Preferably, only a small amount of by-products is formed. Furthermore, the curable groups enable an easy cross-linking such that only small amounts of energy is needed in order to obtain cross-linking (e.g. < 200°C for thermic crosslinking).

Examples for curable groups are units comprising a double bond, a triple bond, precursors for forming double and/or triple bonds, units comprising a heterocyclic residue being able for addition polymerization.

Curable groups include e.g. vinyl, alkenyl, preferably ethenyl and propenyl, $C_{4-20}$-cycloalkenyl, azid, oxirane, oxetane, di(hydrocarbyl)amino, cyanat ester, hydroxy, glycidyl ether, $C_{1-10}$-alkylacrylat, $C_{1-10}$-alkylmethacrylat, alkenyloxy, preferably ethenyloxy, perfluoro alkenyloxy, preferably perfluorethenyloxy, alkinyl, preferably ethinyl, maleic imid, tri($C_{1-4}$)-alkylsiloxy and tri($C_{1-4}$)-alkylsilyl. Most preferred are vinyl und alkenyl.

Examples of the solubilising structure element B having the general formula (L-I) include:

| | | |
|---|---|---|
| 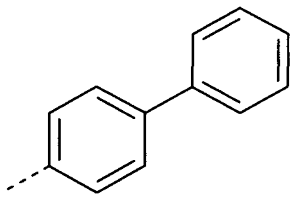 | 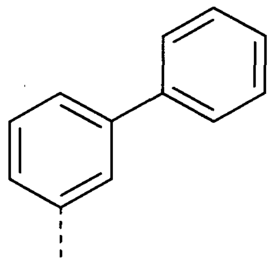 | 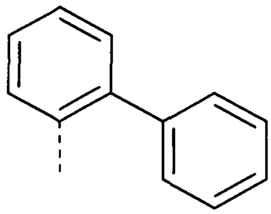 |
| L (I) 1 | L (I) 2 | L (I) 3 |
| 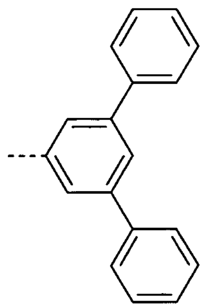 | 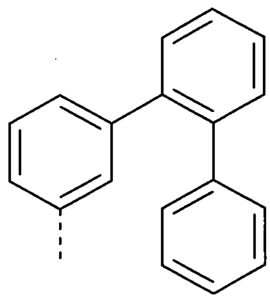 | 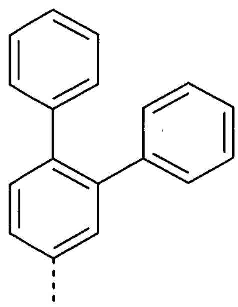 |
| L (I) 4 | L (I) 5 | L (I) 6 |
| 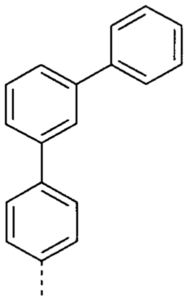 | 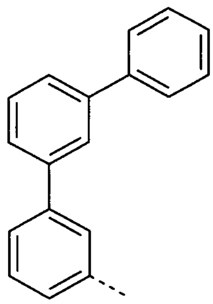 | 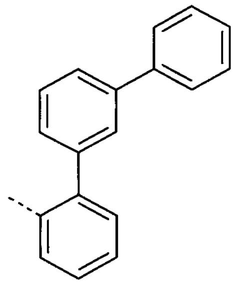 |
| L (I) 7 | L (I) 8 | L (I) 9 |

(continued)

| | | |
|---|---|---|
| 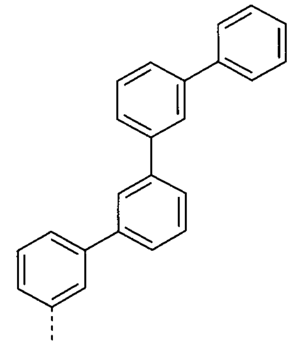 | 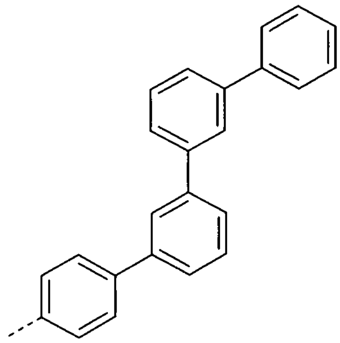 | 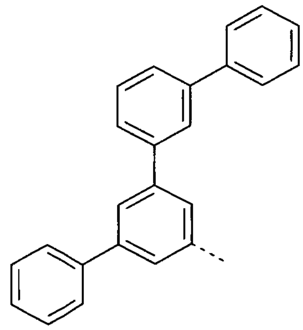 |
| L (I) 10 | L (I) 11 | L (I) 12 |
| 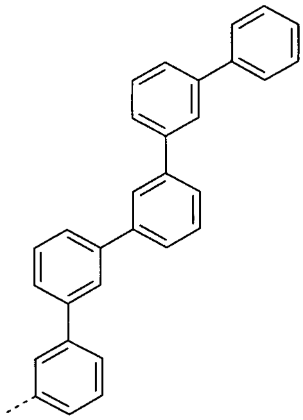 | 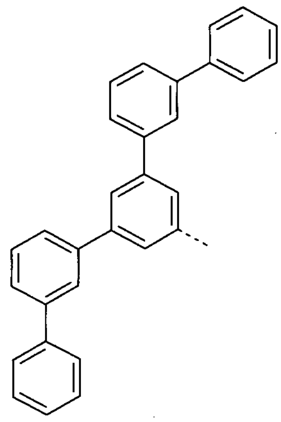 | |
| L (I) 13 | L (I) 14 | |

In the formulae above, the dotted bond represents the bond to the functional structural element A.

Preferably, the organic semiconducting compounds and/or other functional compounds may be represented by the general formula (II)

$$A[B]_k \qquad (II)$$

wherein

A is a functional structure element,
B is a solubilising structure element and
k is a integer in the range of 1 to 20,

and
said solubilising structure element B has the general formula (L-II)

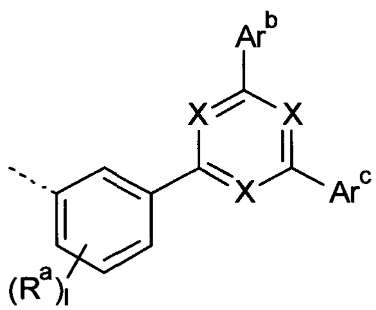

(L-II)

wherein

$Ar^b$, $Ar^c$ each independently are the same or different and each independently represents aryl or heteroaryl group which has from 4 to 60 carbon atoms and may be substituted by one or more arbitrary residues R,

X each independently represents N or $CR^b$, preferably CH,

$R^a$, $R^b$ each independently are the same or different represents hydrogen, a straight chain alkyl, alkoxy or thioalkoxy group having 1 to 40 carbon atoms or a branched or cyclic alkyl, alkoxy or thioalkoxy group having 3 to 40 carbon atoms, preferably an optionally substituted $C_7$-$C_{40}$ alkylaryloxy group; an optionally substituted $C_2$-$C_{40}$ alkoxycarbonyl group; an optionally substituted $C_7$-$C_{40}$ aryloxycarbonyl group; a cyano group (-CN); a carbamoyl group ($-C(=O)NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl or alkynylsilyl group; or a curable group or a substituted or unsubstituted aromatic or hetero aromatic ring system having 5 to 60 ring atoms, or an aryloxy or heteroaryloxy group having 5 to 60 ring atoms, or a combination thereof, wherein one or more of these groups $R^a$ and/or $R^b$ may form a mono- or polycyclic aliphatic or aromatic ring system together and/or the ring to which the group $R^a$ is bound; and

l is 0, 1, 2, 3 or 4;

wherein the dotted bond represents the bond to the functional structural element A.

Preferably, the index k of the general formula (II) is an integer of 2 or more, more preferably 3 or more.

In the compounds according to formulae (I) and/or (II) above, the residue R can preferably be selected from F, Cl, Br, I, $N(Ar)_2$, $N(R')_2$, CN, $NO_2$, $Si(R')_3$, $B(OR')_2$, C(=O)Ar, C(=O)R', $P(=O)(Ar)_2$, $P(=O)(R')_2$, S(=O)Ar, S(=O)R', $S(=O)_2Ar$, $S(=O)_2R'$, -CR'=CR'Ar, $OSO_2R'$, a straight-chain alkyl, alkoxy oder thioalkoxy group having 1 to 40 C atoms, preferably 1 to 20 C atoms or a branched or cyclic alkyl, alkoxy or thioalkoxy group having 3 to 40 C atoms, preferably 3 to 20 C atoms, each of which may be substituted by one or more radicals R', where one or more non adjacent $CH_2$ groups may be replaced by R'C=CR', C=C, $Si(R')_2$, $Ge(R')_2$, $Sn(R')_2$, C=O, C=S, C=Se, C=NR', P(=O)(R'), SO, $SO_2$, NR', O, S or CONR' and where one or more H atoms may be replaced by F, Cl, Br, I, CN or $NO_2$, a curable group or an aromatic or heteroaromatic ring system having 5 to 60 ring atoms, which may be substituted by one or more radicals R', or an aryloxy or heteroaryloxy group having 5 to 60 ring atoms, which may be substituted by one or more radicals R', or a combination of these systems; two or more substituents R here may also form a mono- or polycyclic, aliphatic or aromatic ring system with one another, wherein R' identically or differently on each occurrence represents H or an aliphatic or aromatic carbyl group having 1 to 20 C atoms and Ar represents an aryl or a heteroaryl group having 2 to 30 C atoms.

More preferably, the organic semiconducting compounds and/or other functional compounds may be represented by the general formula (III)

$$A{-}[B]_k \qquad \text{(III)}$$

wherein

A is a functional structure element,
B is a solubilising structure element and
k is a integer in the range of 1 to 20,

and
said solubilising structure element B has the general formula (L-III)

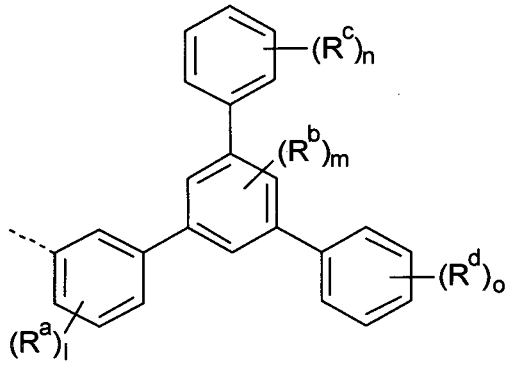

(L-III)

wherein

$R^a$, $R^b$, $R^c$, $R^d$ each independently are the same or different represents hydrogen, a straight chain alkyl, alkoxy or thioalkoxy group having 1 to 40 carbon atoms or a branched or cyclic alkyl, alkoxy or thioalkoxy group having 3 to 40 carbon atoms,preferably an optionally substituted $C_7$-$C_{40}$ alkylaryloxy group; an optionally substituted $C_2$-$C_{40}$ alkoxycarbonyl group; an optionally substituted $C_7$-$C_{40}$ aryloxycarbonyl group; a cyano group (-CN); a carbamoyl group (-C(=O)$NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl or alkynylsilyl group; or a curable group or a substituted or unsubstituted aromatic or heteroaromatic ring system having 5 to 60 ring atoms, or an aryloxy or heteroaryloxy group having 5 to 60 ring atoms, or a combination thereof, wherein one or more of these groups $R^a$, $R^b$, $R^c$ and/or $R^d$ may form a mono- or polycyclic aliphatic or aromatic ring system together and/or the ring to which the groups $R^a$, $R^b$, $R^c$ and/or $R^d$ are bound;

l is 0, 1, 2, 3 or 4;

m is 0, 1, 2 or 3; and

n, o each independently are the same or different represents 0, 1, 2, 3, 4 or 5;

wherein the dotted bond represents the bond to the functional structural element A.

Preferably, the residues $R^a$, $R^b$, $R^c$, $R^d$ represent hydrogen (l, m, n und o = 0), a straigth chain alkyl or alkoxy group having 1 to 20 carbon atoms or a branched or cyclic alkyl or alkoxy group having 3 to 40 carbon atoms.

Preferably, the index k of the general formula (III) is an integer of 2 or more, more preferably 3 or more.

According to a preferred aspect of the present invention, the weight ratio of the functional structure element A to the solubilizing structure element B in formulae (I), (II) and (III) is preferably in the range of 2:1 to 1:20, more preferably in the range of 1:1 to 1:3.

Preferred solubilising structure elements B include for example structure elements according to the following formulae:

| | |
|---|---|
| 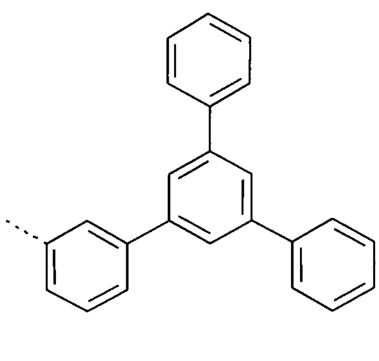 | 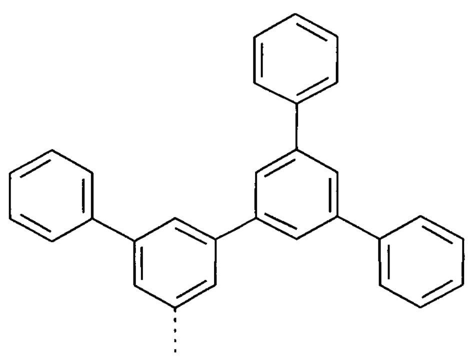 |

(continued)

| | |
|---|---|
| (L-IIIa) | (L-IIIb) |

In the formulae above, the dotted bond represents the bond to the functional structural element A.

More preferred solubilising structure elements B include for example structure elements according to the following formulae:

| | |
|---|---|
| 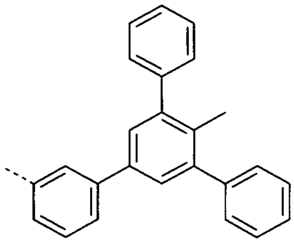 | 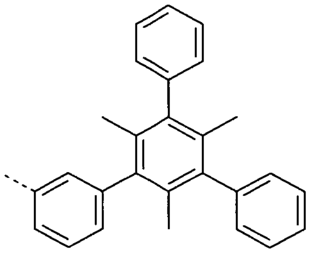 |
| (L-IIIa1) | (L-IIIa2) |
| 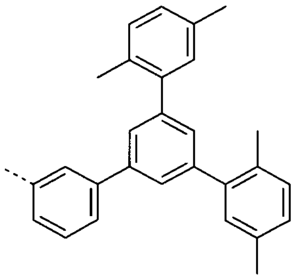 | 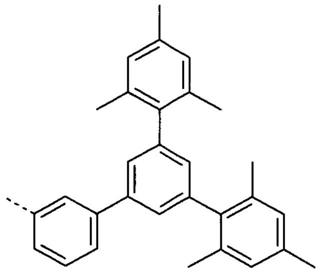 |
| (L-IIIa3) | (L-IIIa4) |
| 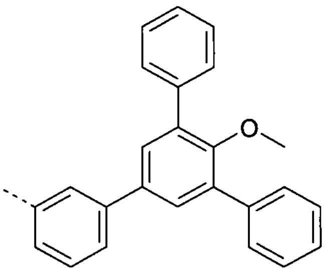 | 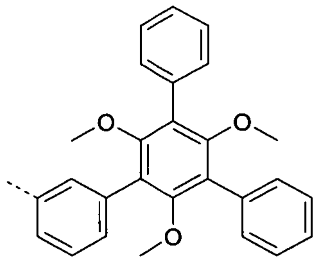 |
| (L-IIIa5) | (L-IIIa6) |
| 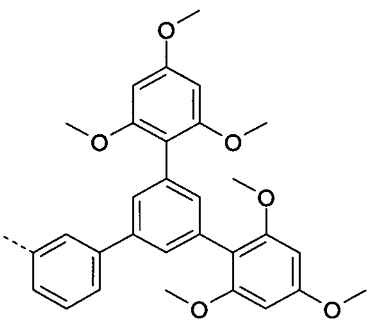 | 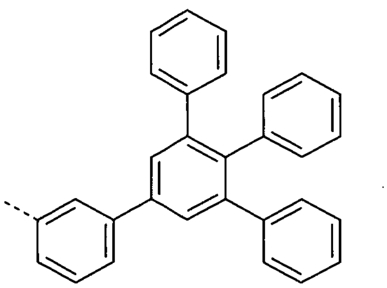 |
| (L-IIIa7) | (L-IIIa8) |

(continued)

| | |
|---|---|
| 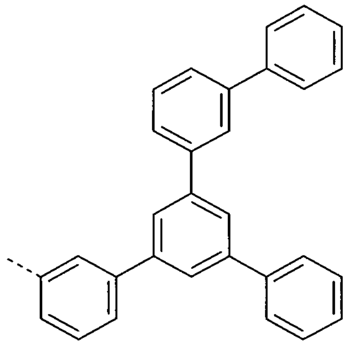 | 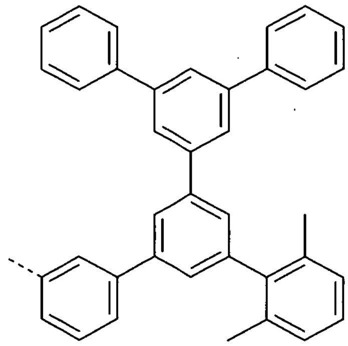 |
| (L-IIIa9) | (L-IIIa10) |
| 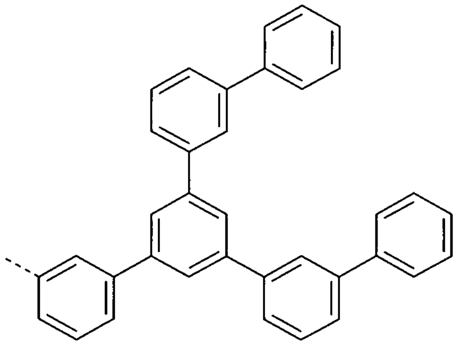 | 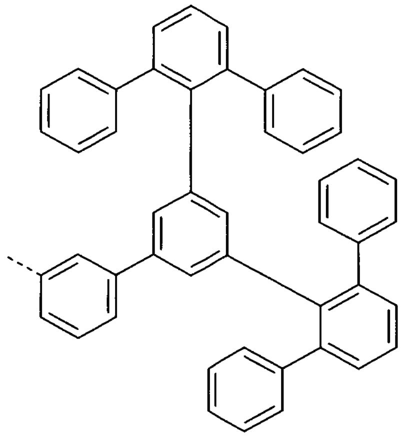 |
| (L-IIIa11) | (L-IIIa12) |
| 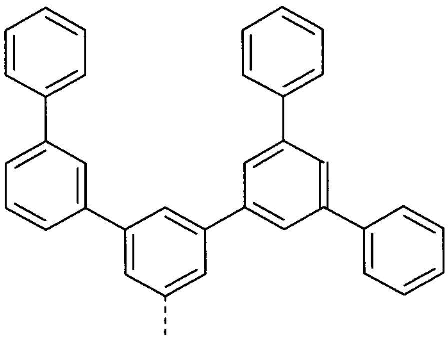 | 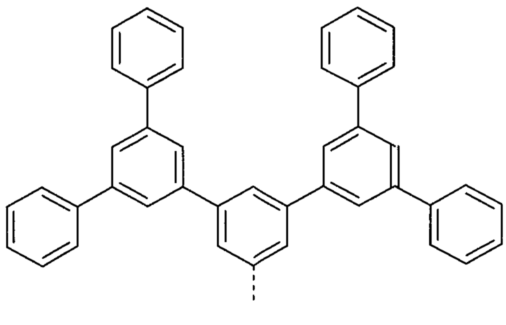 |
| (L-IIIb1) | (L-IIIb2) |

In the formulae above, the dotted bond represents the bond to the functional structural element A.

According to the present invention the OSC material is an organic light emitting material. The organic light emitting materials can be selected from standard materials known to the skilled person and described in the literature. An organic light emitting material according to the present application means a material which emits light having a $\lambda_{max}$ in the range from 400 to 700 nm.

Suitable phosphorescent compounds are, in particular, compounds which emit light, preferably in the visible region, on suitable excitation and in addition contain at least one atom having an atomic number greater than 20, preferably greater than 38 and less than 84, more preferably greater than 56 and less than 80. The phosphorescence emitters used are preferably compounds which contain copper, molybdenum, tungsten, rhenium, ruthenium, osmium, rhodium, iridium, palladium, platinum, silver, gold or europium, in particular compounds which contain iridium or platinum.

Particularly preferred organic phosphorescent compounds are compounds of formulae (1) to (4):

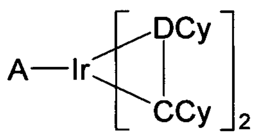

formula (1)

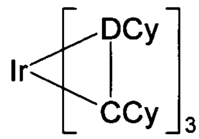

formula (2)

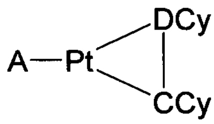

formula (3)

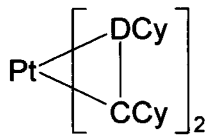

formula (4)

where

DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents $R^{18}$; the groups DCy and CCy are connected to one another via a covalent bond;

CCy is, identically or differently on each occurrence, a cyclic group which contains a carbon atom via which the cyclic group is bonded to the metal and which may in turn carry one or more substituents $R^{18}$;

A is, identically or differently on each occurrence, a monoanionic, bidentate chelating ligand, preferably a diketonate ligand;

$R^{18}$ are identically or differently at each instance, and are F, Cl, Br, I, $NO_2$, CN, a straight-chain, branched or cyclic alkyl or alkoxy group having from 1 to 20 carbon atoms, in which one or more non-adjacent $CH_2$ groups may be replaced by -O-, -S-, $-NR^{19}-$, $-CONR^{19}-$, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals, and a plurality of substituents $R^{18}$, either on the same ring or on two different rings, may together in turn form a mono- or polycyclic, aliphatic or aromatic ring system; and

$R^{19}$ are identically or differently at each instance, and are a straight-chain, branched or cyclic alkyl or alkoxy group having from 1 to 20 carbon atoms, in which one or more nonadjacent $CH_2$ groups may be replaced by -O-, -S-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals.

Formation of ring systems between a plurality of radicals $R^{18}$ means that a bridge may also be present between the groups DCy and CCy.

Furthermore, formation of ring systems between a plurality of radicals $R^{18}$ means that a bridge may also be present between two or three ligands CCy-DCy or between one or two ligands CCy-DCy and the ligand A, giving a polydentate or polypodal ligand system.

Preferably, the semiconducting compounds according to formulae (1), (2), (3) and (4) meet the requirements of formula (I), formula (II) and/or formula (III) and comprise at least one solubilizing structure element of formulae (L-I), (L-II) and (L-III), respectively.

Examples of the emitters described above are revealed by the applications WO 00/70655, WO 01/41512, WO 02/02714, WO 02/15645, EP 1191613, EP 1191612, EP 1191614, WO 04/081017, WO 05/033244, WO 05/042550, WO 05/113563, WO 06/008069, WO 06/061182, WO 06/081973 and DE 102008027005. In general, all phosphorescent complexes as are used in accordance with the prior art for phosphorescent OLEDs and as are known to the person skilled in the art in the area of organic electroluminescence are suitable, and the person skilled in the art will be able to use further phosphorescent compounds without an inventive step. In particular, it is known to the person skilled in the art which phosphorescent complexes emit with which emission colour.

Examples of preferred phosphorescent compounds are shown in the following table.

| | |
|---|---|
| 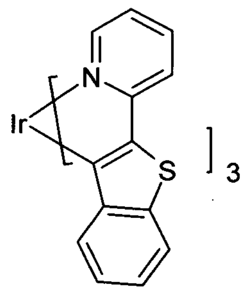 | 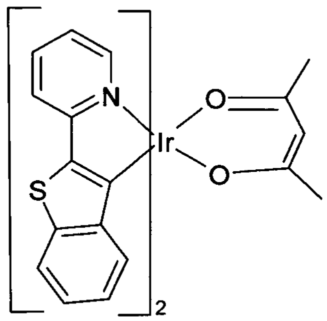 |
| (5) | (6) |
| 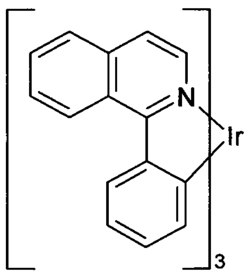 | 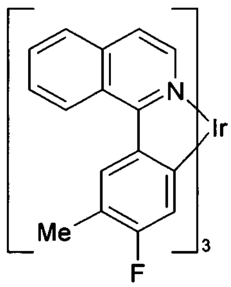 |
| (7) | (8) |
| 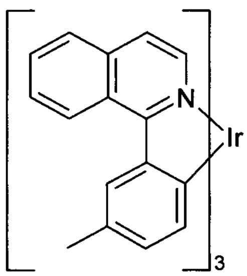 | 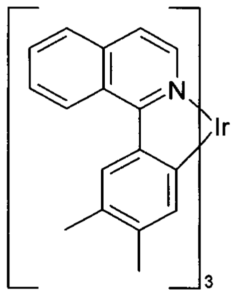 |
| (9) | (10) |
| 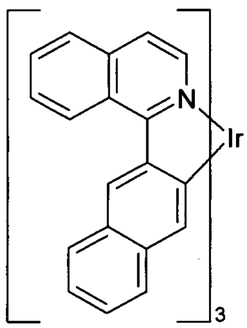 | 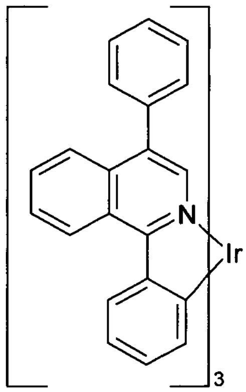 |
| (11) | (12) |

(continued)

| | |
|---|---|
| 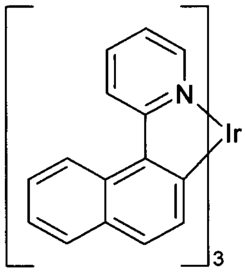 | 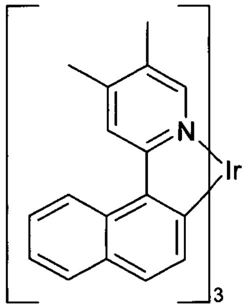 |
| (13) | (14) |
| 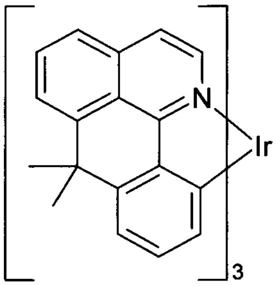 | 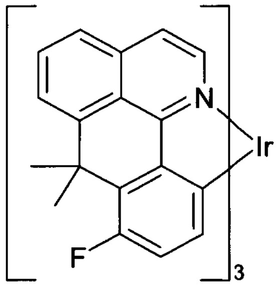 |
| (15) | (16) |
| 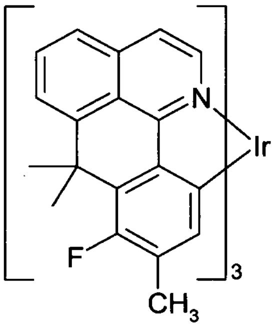 | 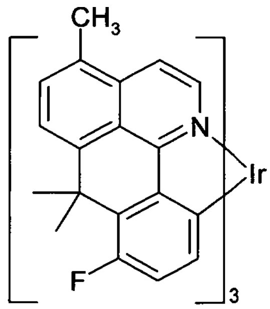 |
| (17) | (18) |
| 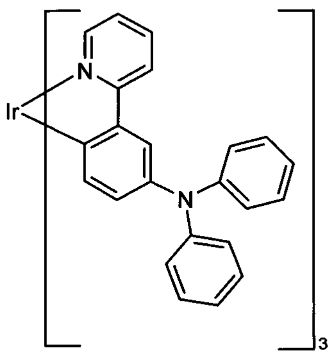 | 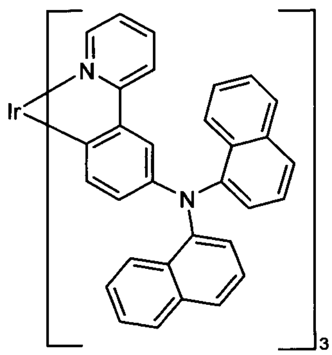 |
| (19) | (20) |

(continued)

| | |
|---|---|
| 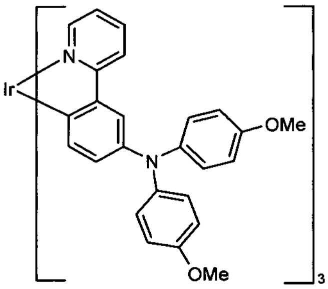 | 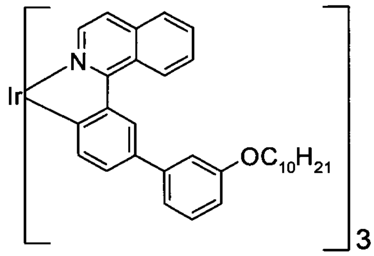 |
| (21) | (22) |
| 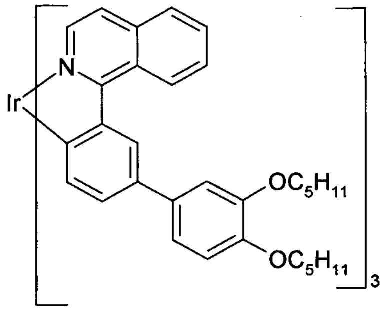 | 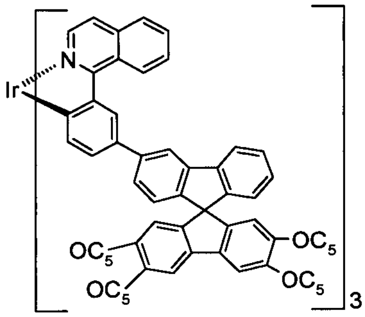 |
| (23) | (24) |
| 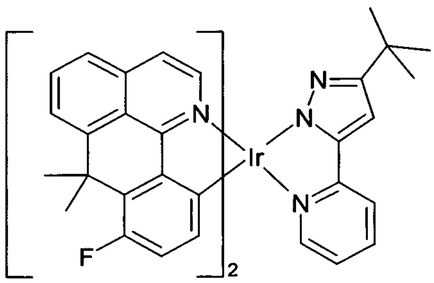 | 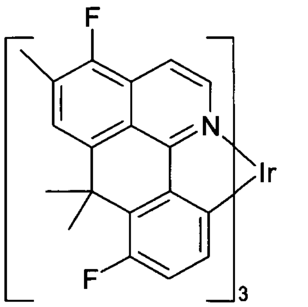 |
| (25) | (26) |
| 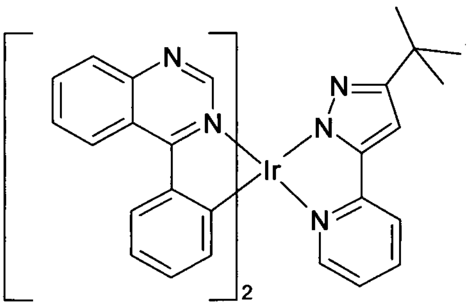 | 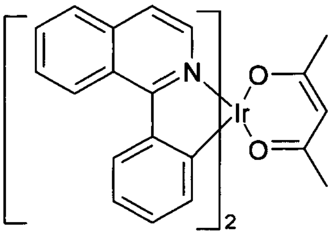 |
| (27) | (28) |
| 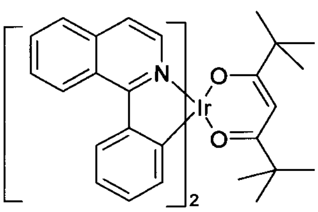 | 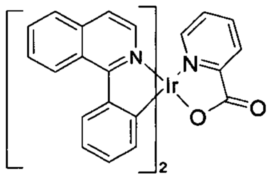 |

(continued)

| (29) | (30) |
|---|---|
| 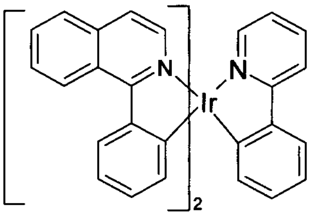 | 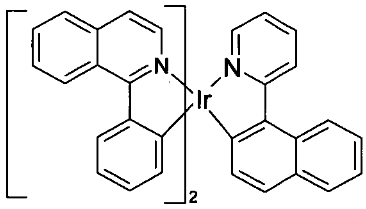 |
| (31) | (32) |
| 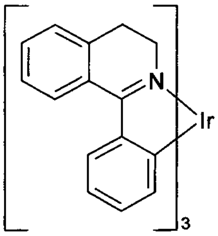 | 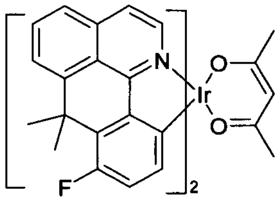 |
| (33) | (34) |
| 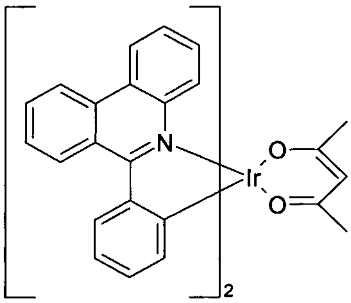 | 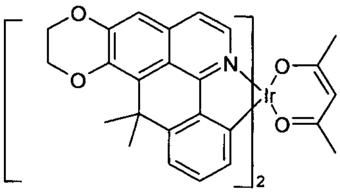 |
| (35) | (36) |
| 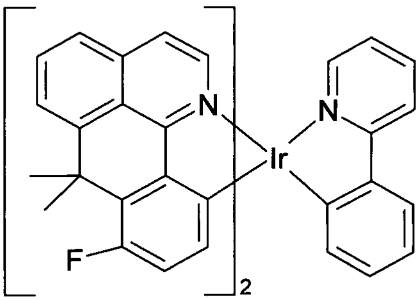 | 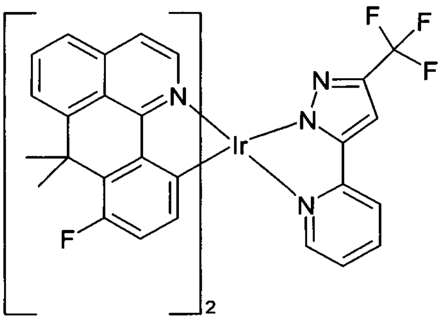 |
| (37) | (38) |
| 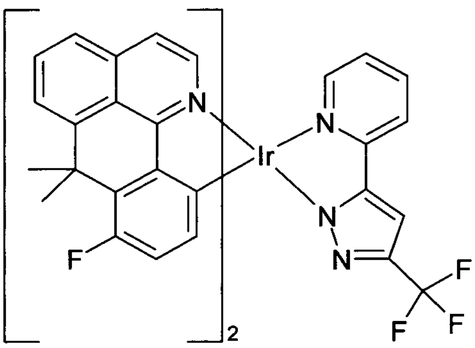 | 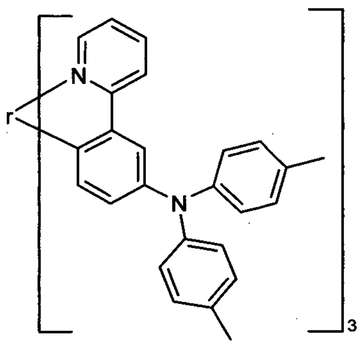 |

(continued)

| (39) | (40) |
|---|---|
| 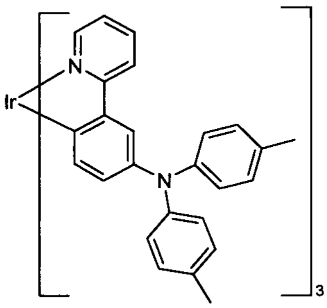 | 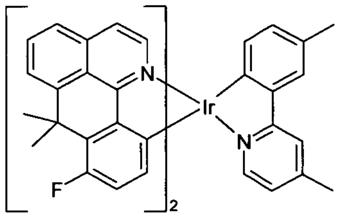 |
| (41) | (42) |
| 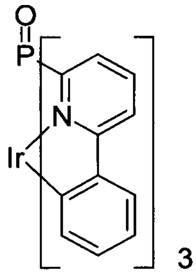 | 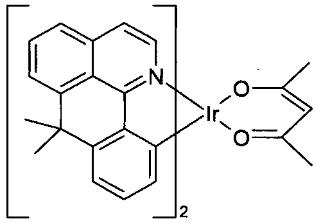 |
| (43) | (44) |
| 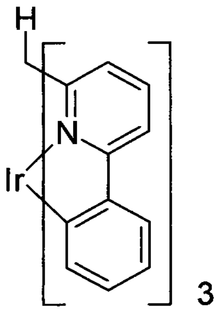 | 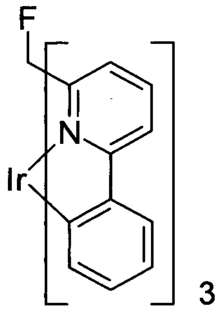 |
| (45) | (46) |
| 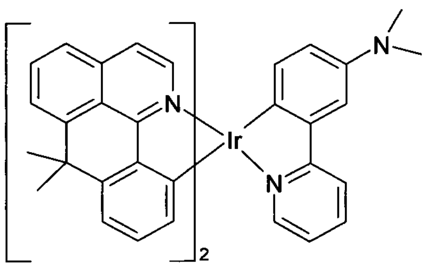 | 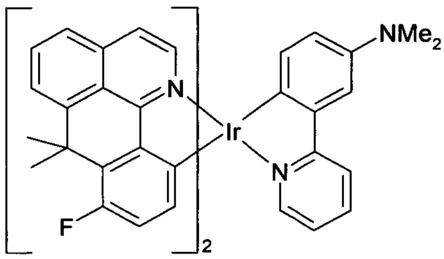 |
| (47) | (48) |
| 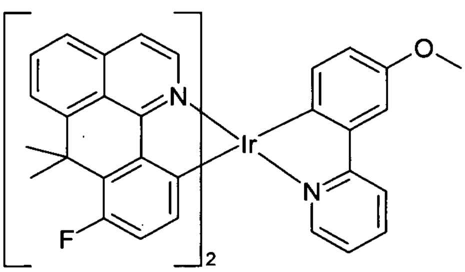 | 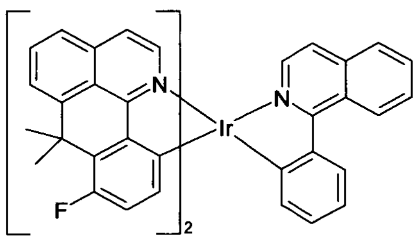 |

(continued)

| (49) | (50) |
|---|---|
| 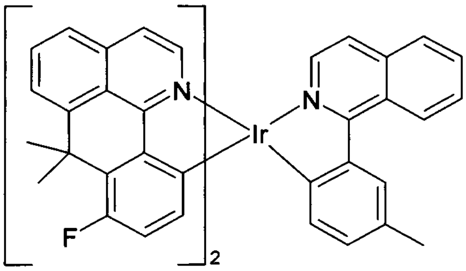 | 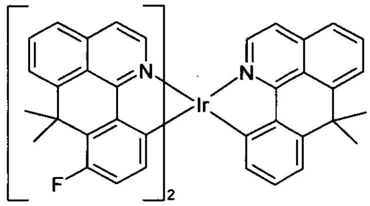 |
| (51) | (52) |
| 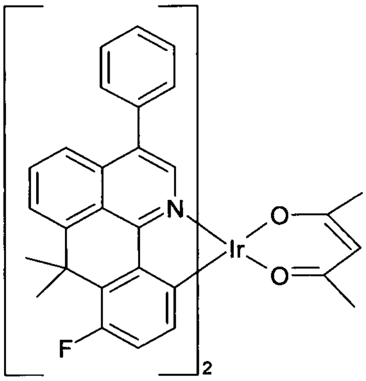 | 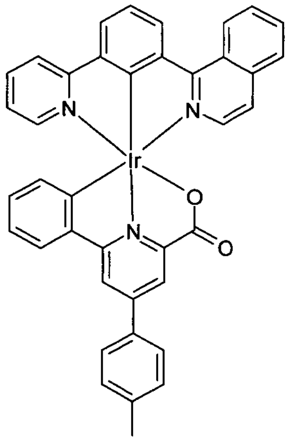 |
| (53) | (54) |
| 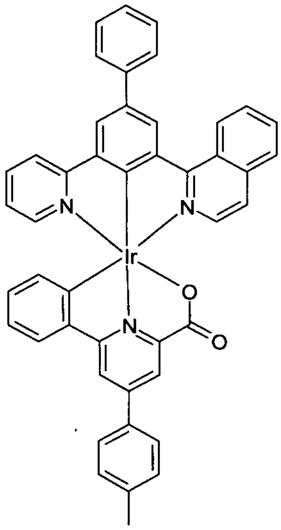 | 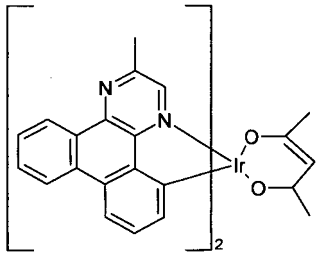 |
| (55) | (56) |

(continued)

| | |
|---|---|
| 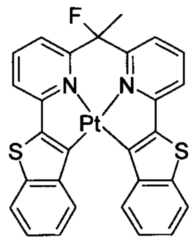 | 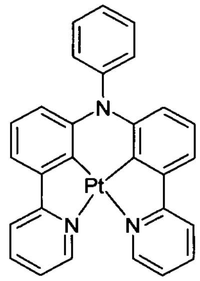 |
| (57) | (58) |
| 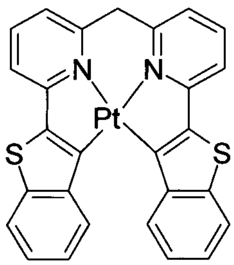 | 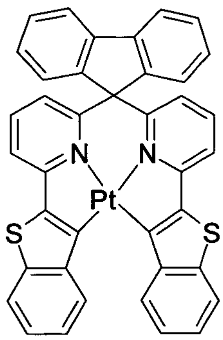 |
| (59) | (60) |
| 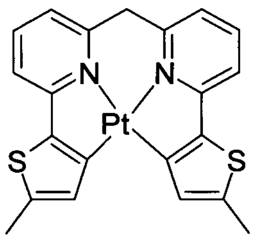 | 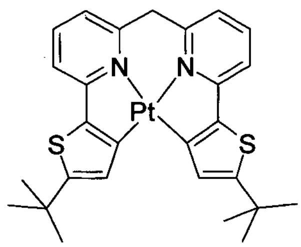 |
| (61) | (62) |
| 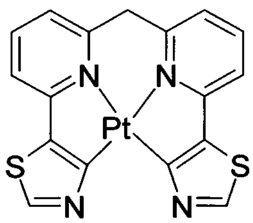 | 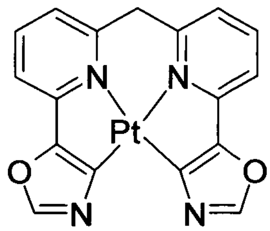 |
| (63) | (64) |
| 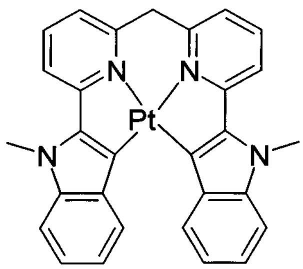 | 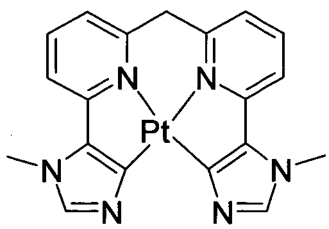 |
| (65) | (66) |

(continued)

| | |
|---|---|
| 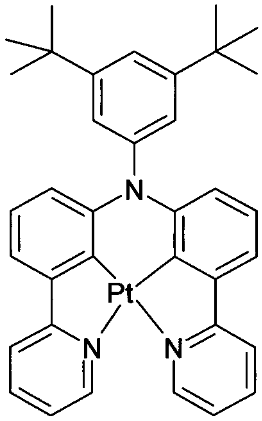 | 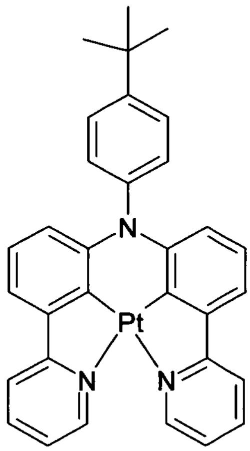 |
| (67) | (68) |
| 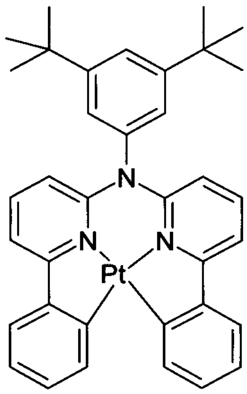 | 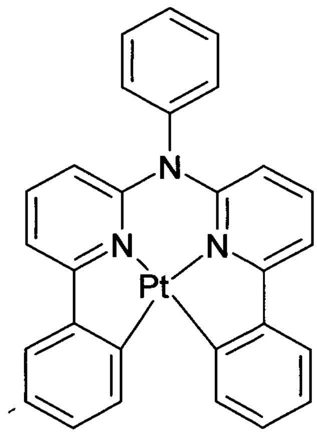 |
| (69) | (70) |
| 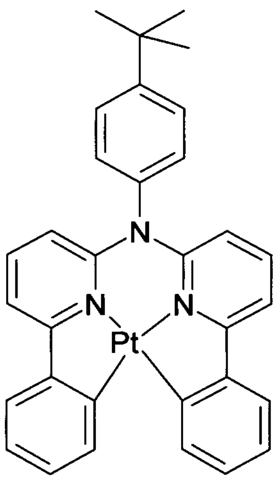 | 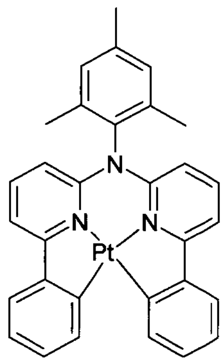 |
| (71) | (72) |

(continued)

| | |
|---|---|
| 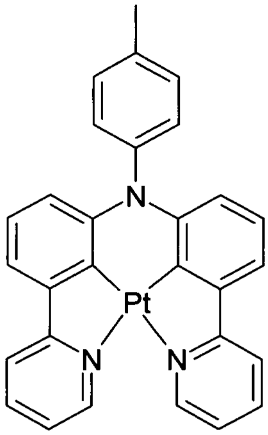 | 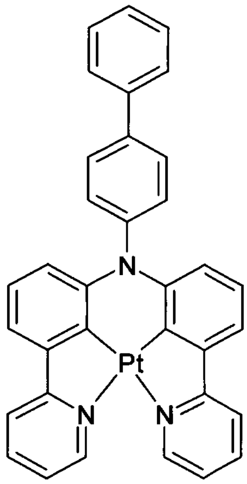 |
| (73) | (74) |
| 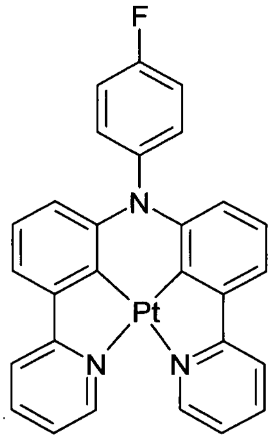 | 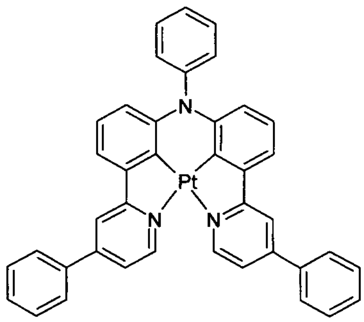 |
| (75) | (76) |
| 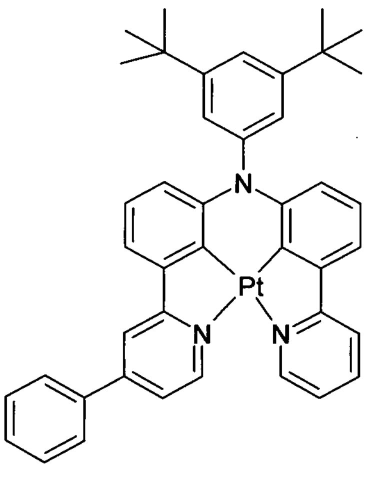 | 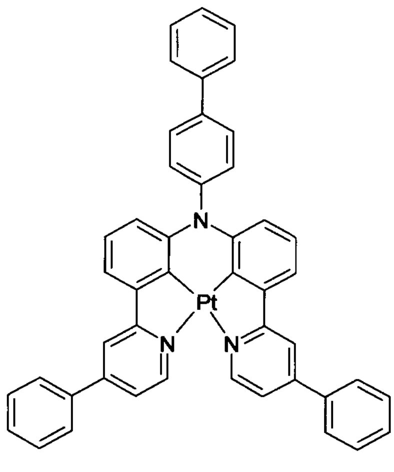 |
| (77) | (78) |

(continued)

| | |
|---|---|
| 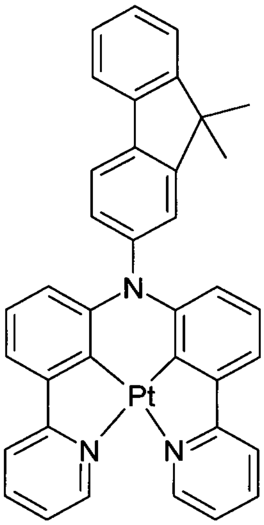 | 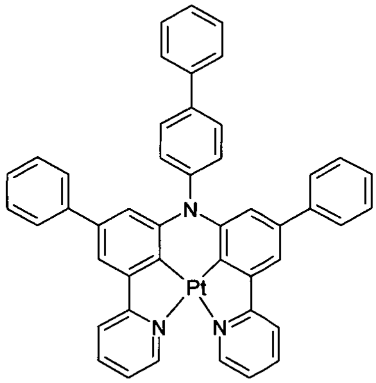 |
| (79) | (80) |
| 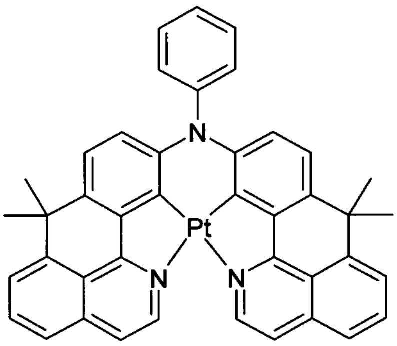 | 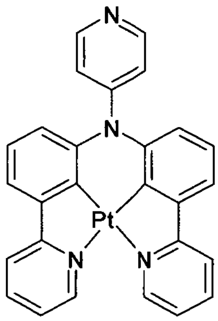 |
| (81) | (82) |
| 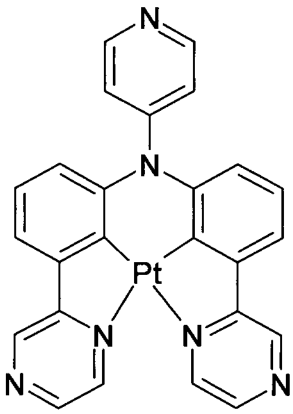 | 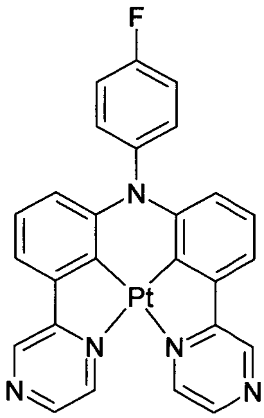 |
| (83) | (84) |

(continued)

| | |
|---|---|
| 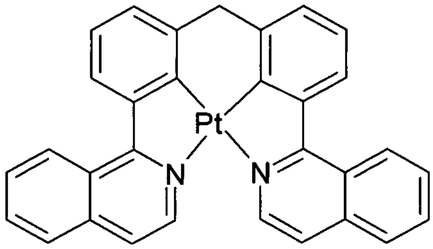 | 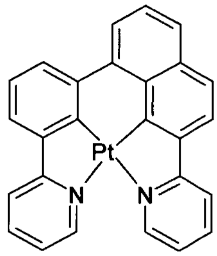 |
| (85) | (86) |
| 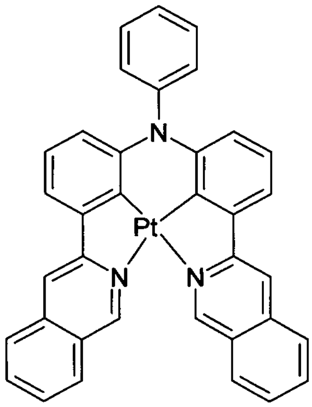 | 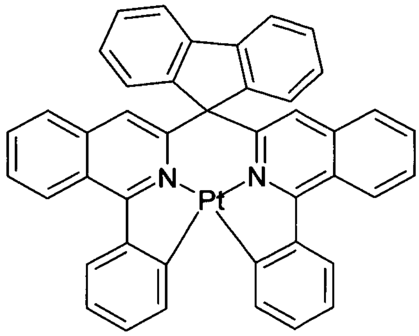 |
| (87) | (88) |
| 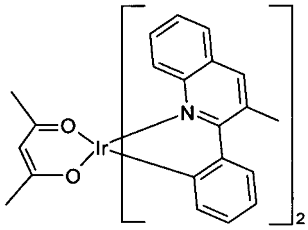 | 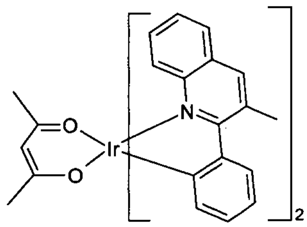 |
| (89) | (90) |
| 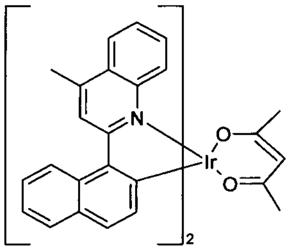 | 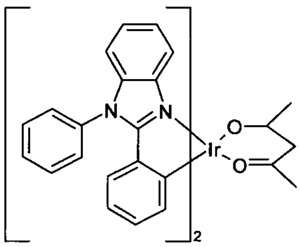 |
| (91) | (92) |
| 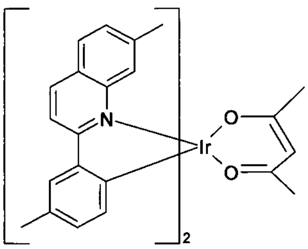 | 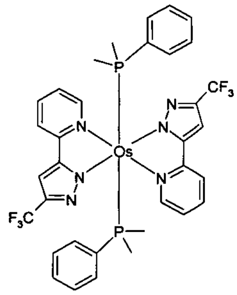 |

(continued)

| | |
|---|---|
| (93) | (94) |
| 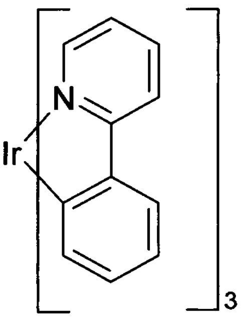 | 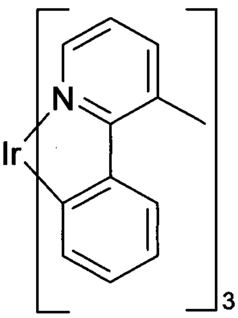 |
| (95) | (96) |
| 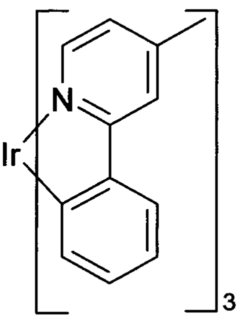 | 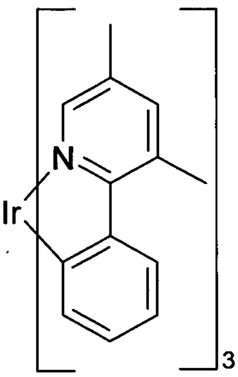 |
| (97) | (98) |
| 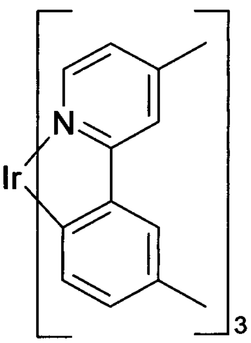 | 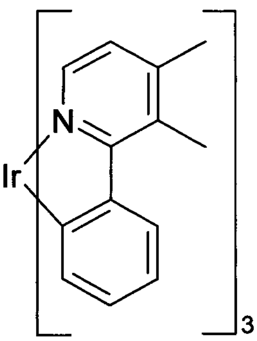 |
| (99) | (100) |
| 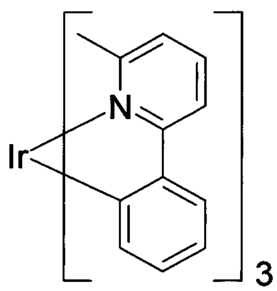 | 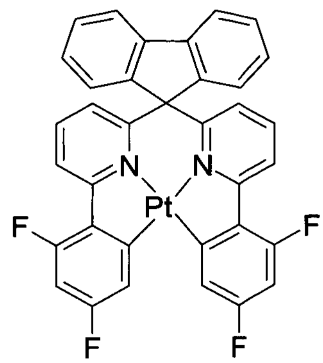 |
| (101) | (102) |

(continued)

| | |
|---|---|
| 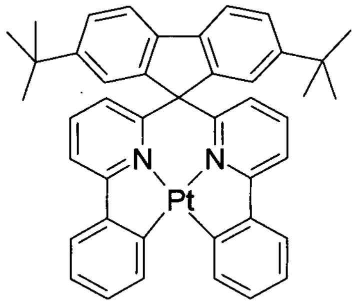 | 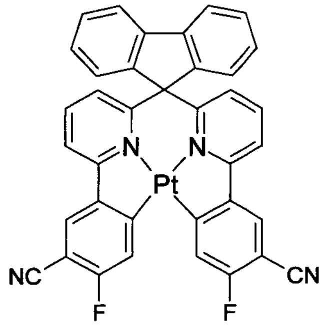 |
| (103) | (104) |
| 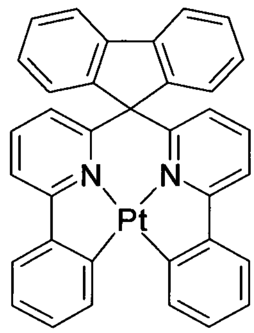 | 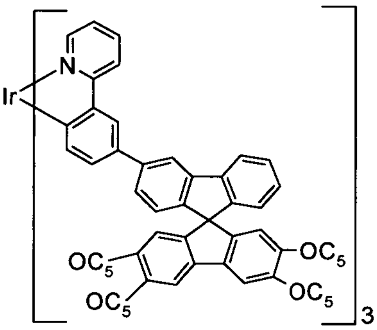 |
| (105) | (106) |
| 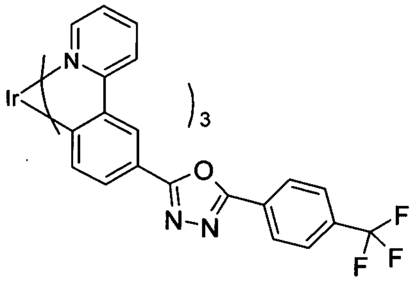 | 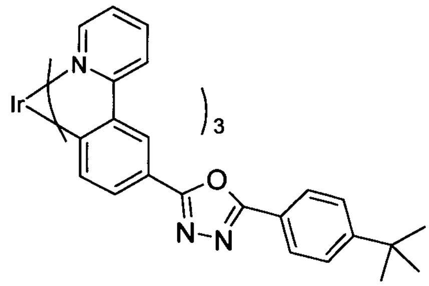 |
| (107) | (108) |
| 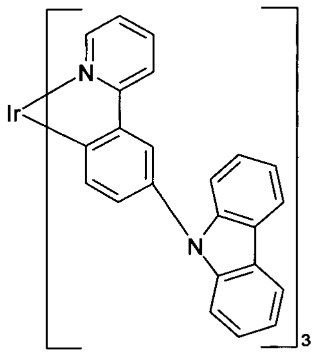 | 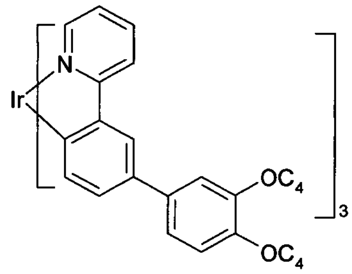 |
| (109) | (110) |

(continued)

| | |
|---|---|
| 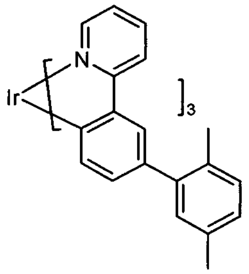 | 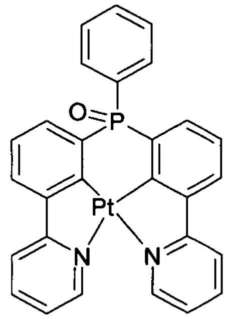 |
| (111) | (112) |
| 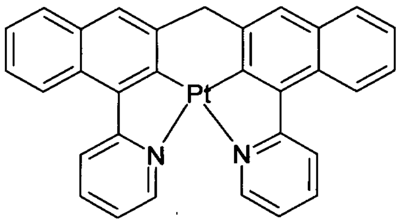 | 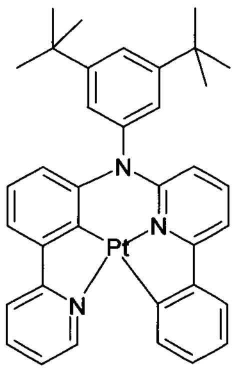 |
| (113) | (114) |
| 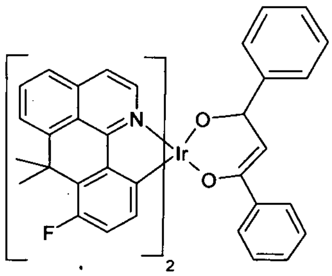 | 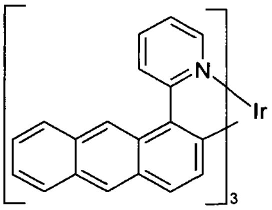 |
| (115) | (116) |
| 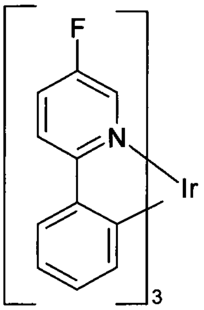 | 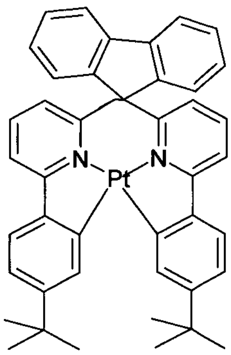 |
| (117) | (118) |

(continued)

| | |
|---|---|
| 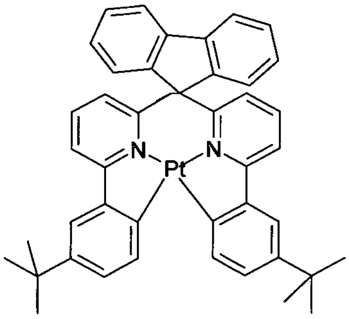 | 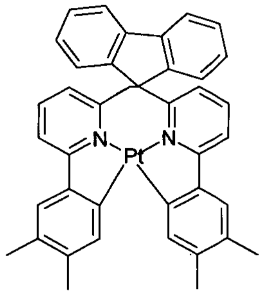 |
| (119) | (120) |
| 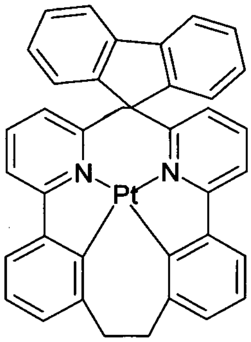 | 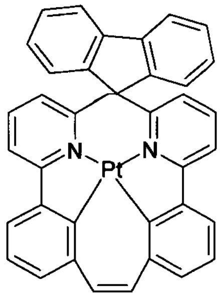 |
| (121) | (122) |
| 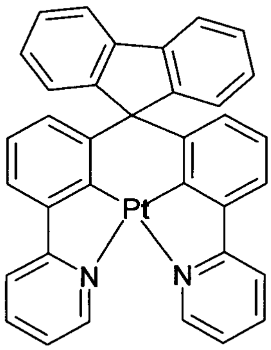 | 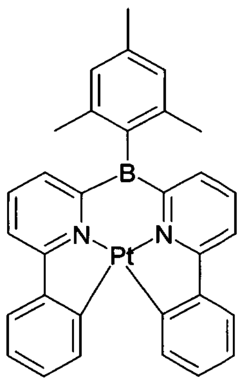 |
| (123) | (124) |
| 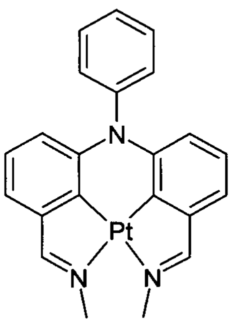 | 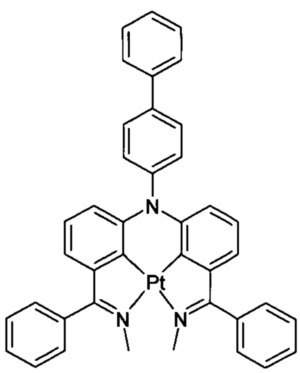 |
| (125) | (126) |

(continued)

| | |
|---|---|
| 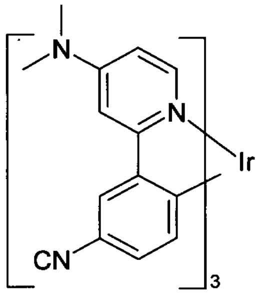 | 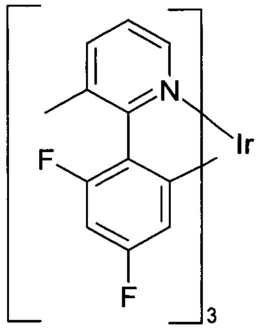 |
| (127) | (128) |
| 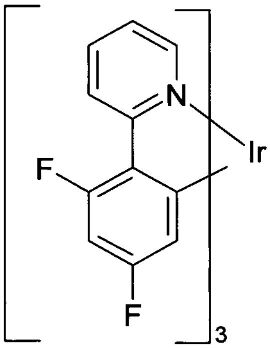 | 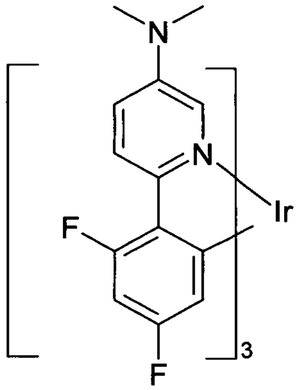 |
| (129) | (130) |
| 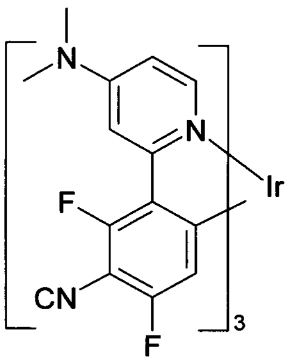 | 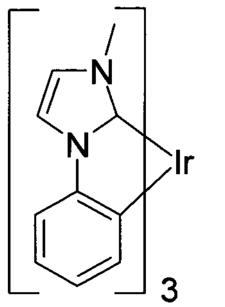 |
| (131) | (132) |
| 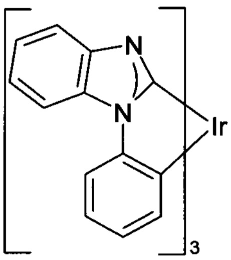 | 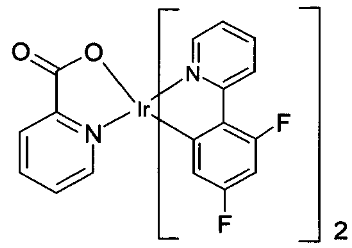 |
| (133) | (134) |

(continued)

| | |
|---|---|
| 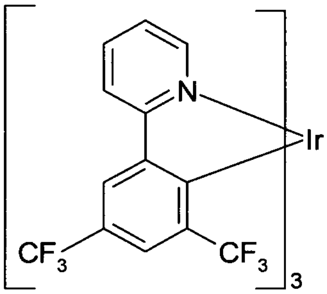 | 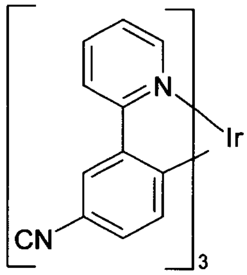 |
| (135) | (136) |
| 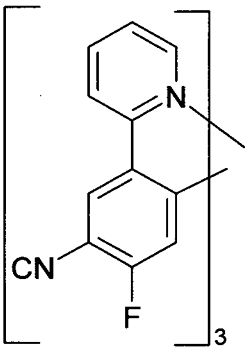 | 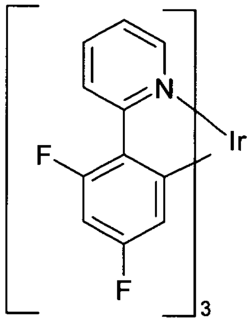 |
| (137) | (138) |
| 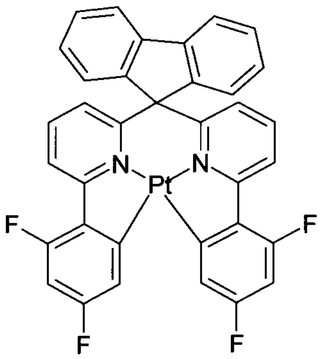 | 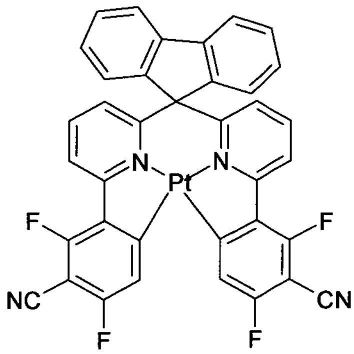 |
| (139) | (140) |
| 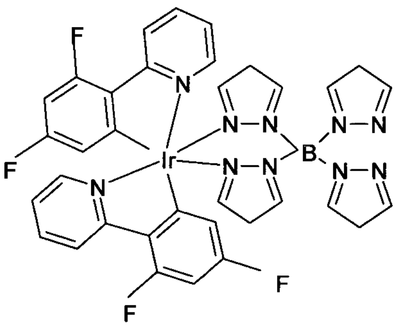 | 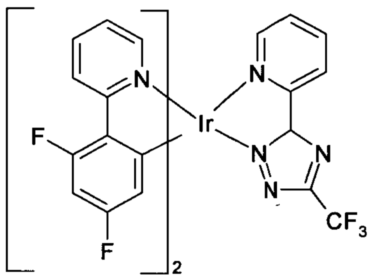 |
| (141) | (142) |

(continued)

| | |
|---|---|
| 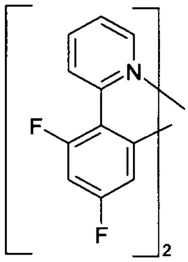 | 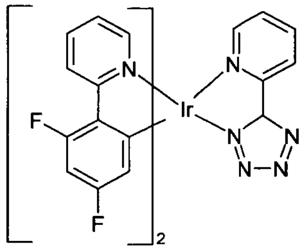 |
| (143) | (144) |
| 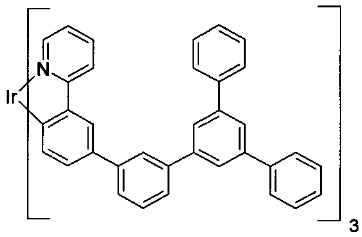 | 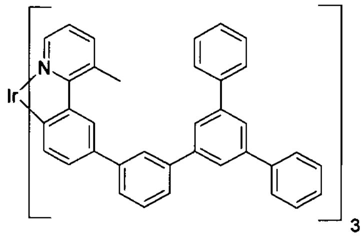 |
| (145) | (146) |
| 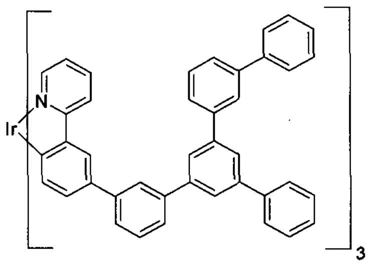 | 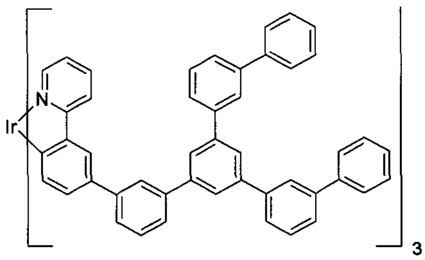 |
| (147) | (148) |
| 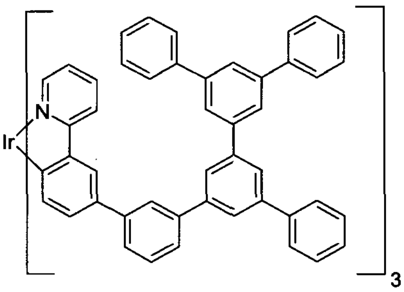 | 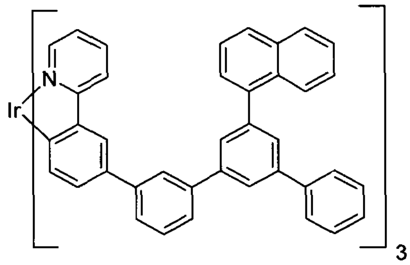 |
| (149) | (150) |
| 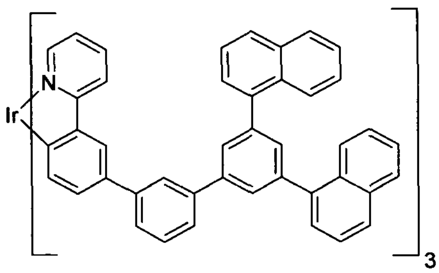 | 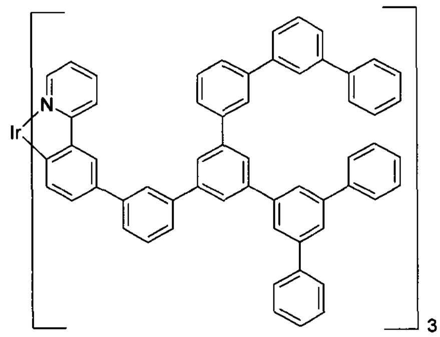 |
| (151) | (152) |

(continued)

| | |
|---|---|
| 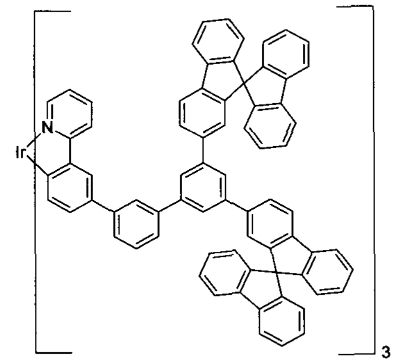 | 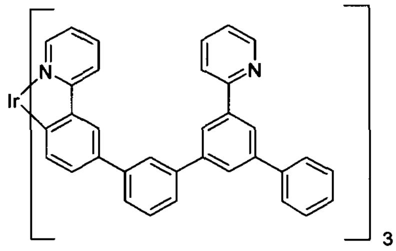 |
| (153) | (154) |
| 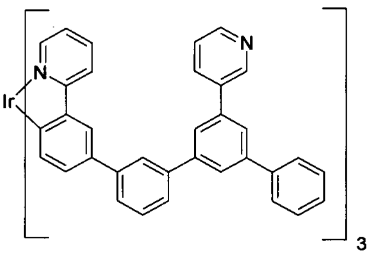 | 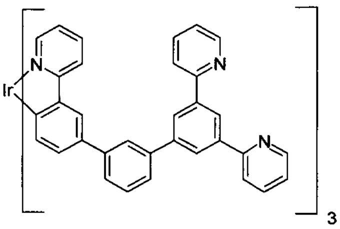 |
| (155) | (156) |
| 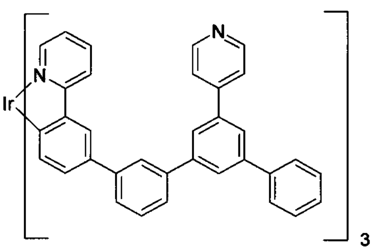 | 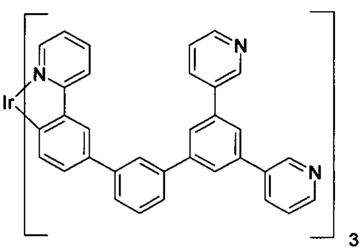 |
| (157) | (158) |
| 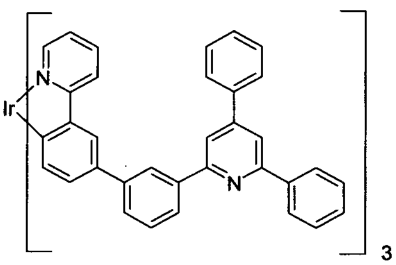 | 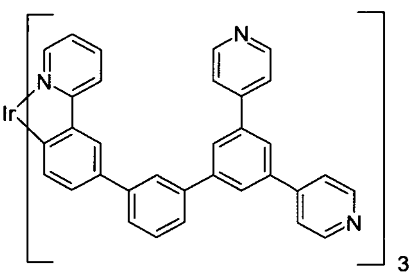 |
| (159) | (160) |
| 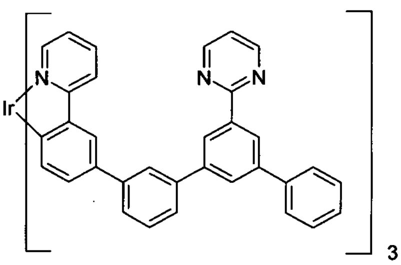 | 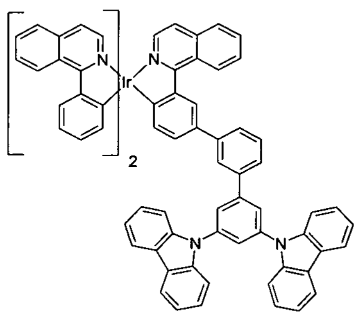 |

(continued)

| (161) | (162) |
|---|---|
| 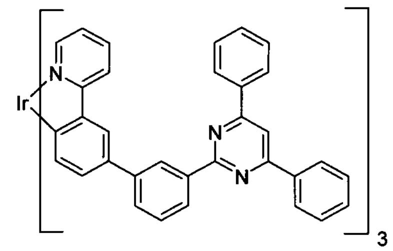 | 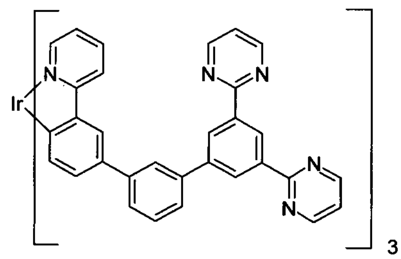 |
| (163) | (164) |
| 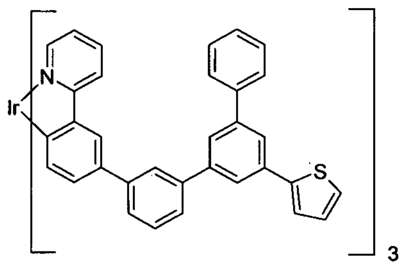 | 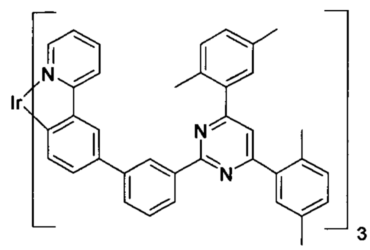 |
| (165) | (166) |
| 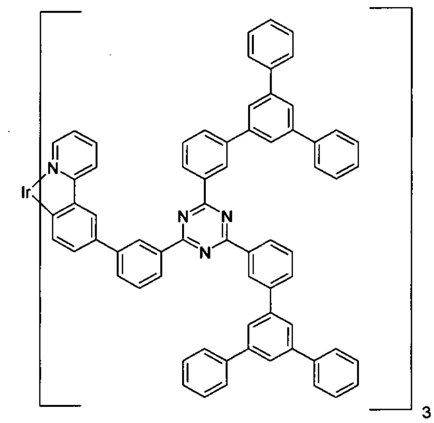 | 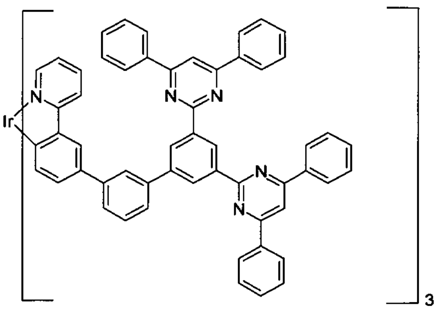 |
| (167) | (168) |
| 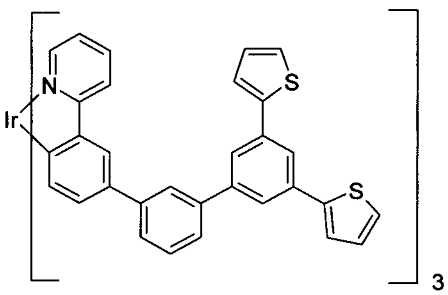 | 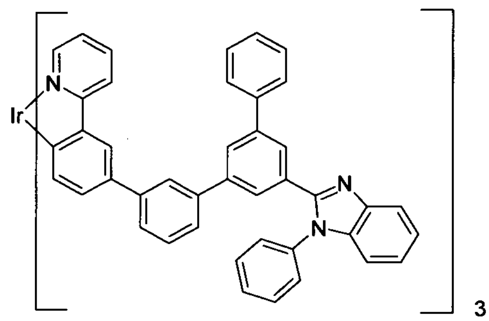 |
| (169) | (170) |

(continued)

| | |
|---|---|
| 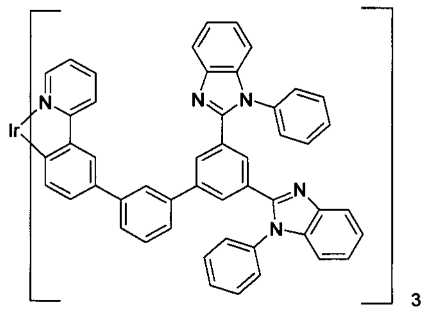 | 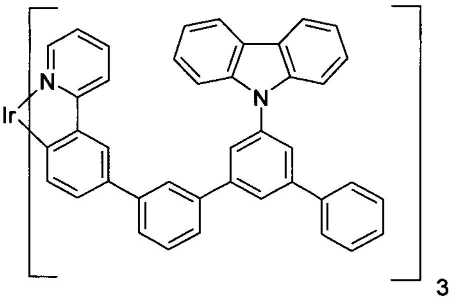 |
| (171) | (172) |
| 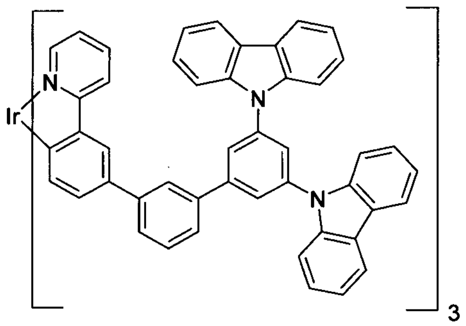 | 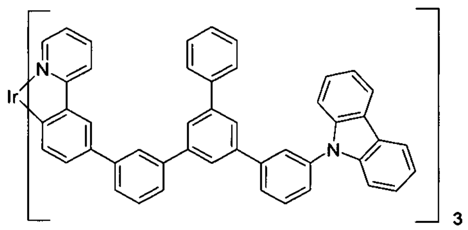 |
| (173) | (174) |
| 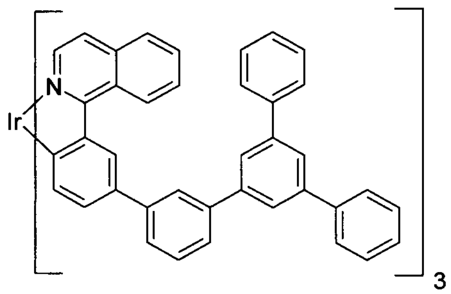 | 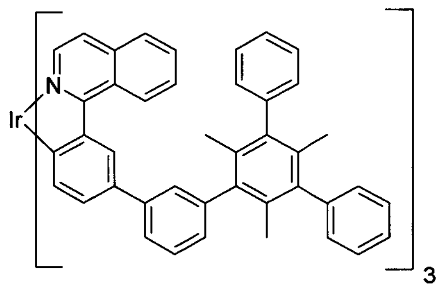 |
| (175) | (176) |
| 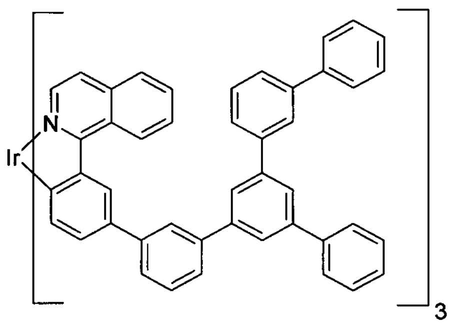 | 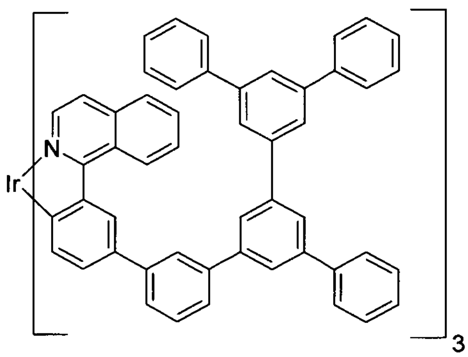 |
| (177) | (178) |

(continued)

| | |
|---|---|
| 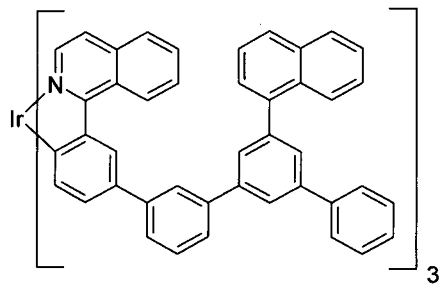 | 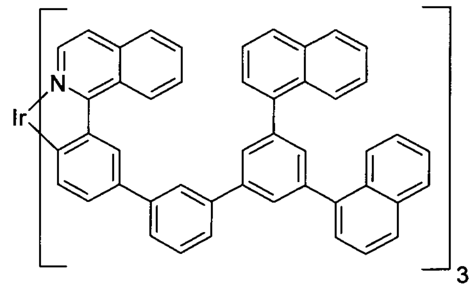 |
| (179) | (180) |
| 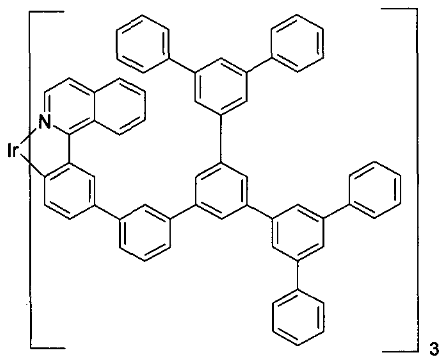 | 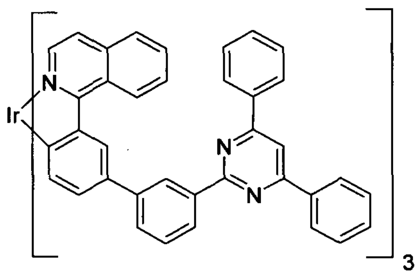 |
| (181) | (182) |
| 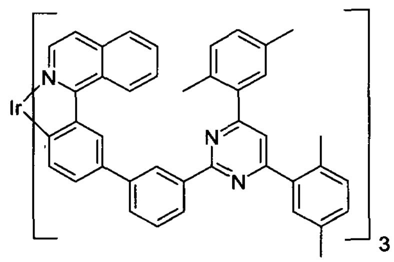 | 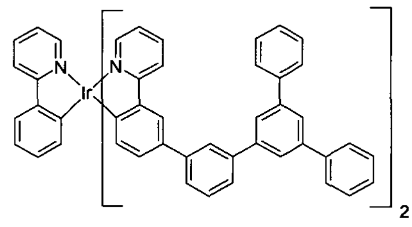 |
| (183) | (184) |
| 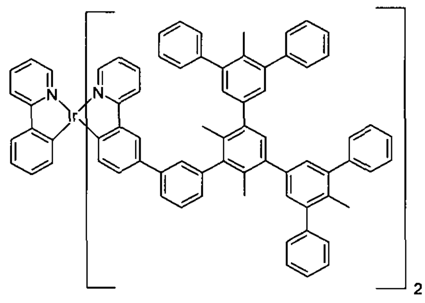 | 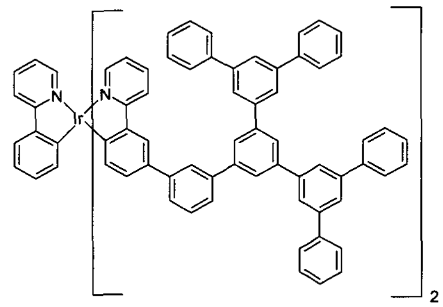 |
| (185) | (186) |
| 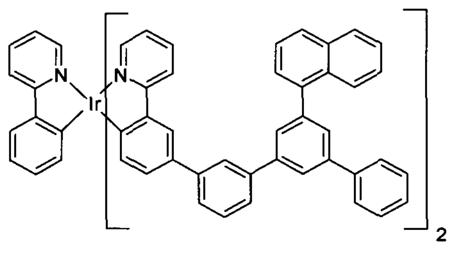 | 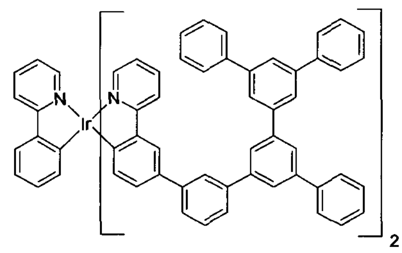 |

(continued)

| | |
|---|---|
| (187) | (188) |
| 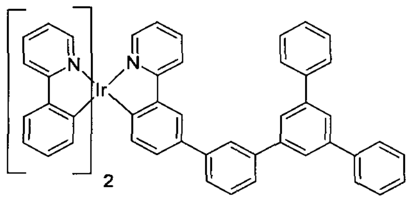 | 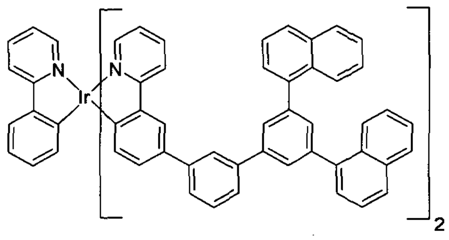 |
| (189) | (190) |
| 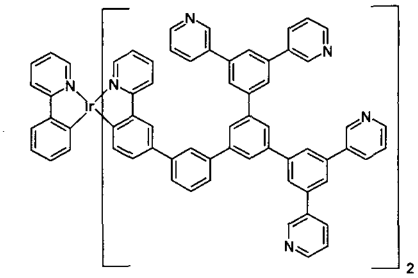 | 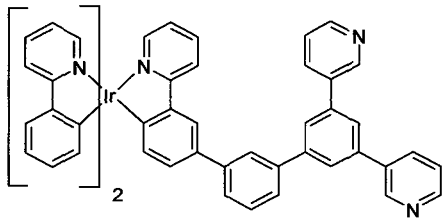 |
| (191) | (192) |
| 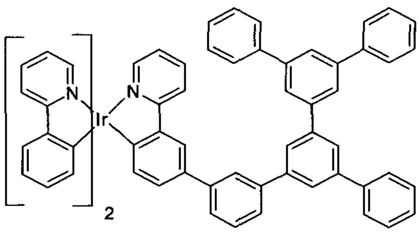 | 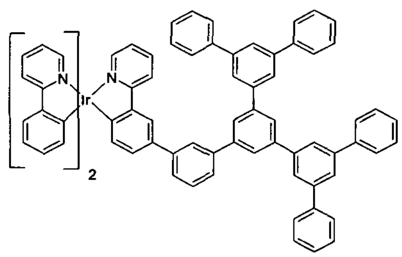 |
| (193) | (194) |
| 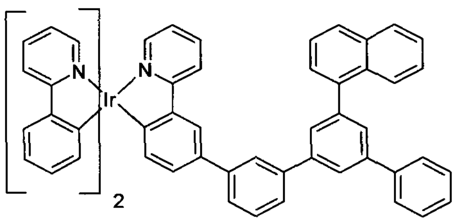 | 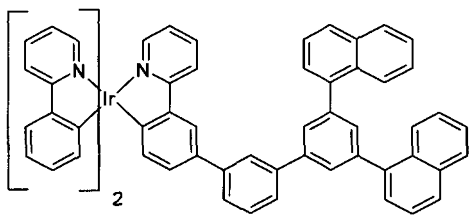 |
| (195) | (196) |
| 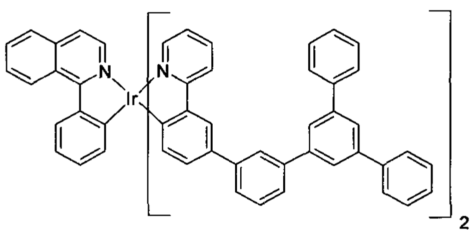 | 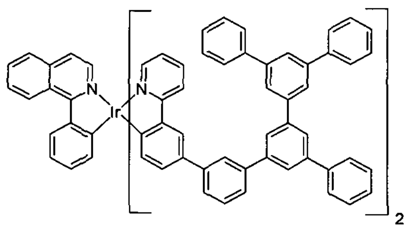 |
| (197) | (198) |

(continued)

| | |
|---|---|
| 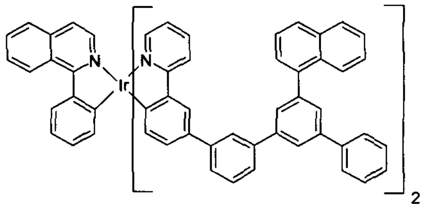 | 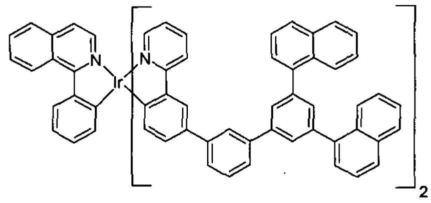 |
| (199) | (200) |
| 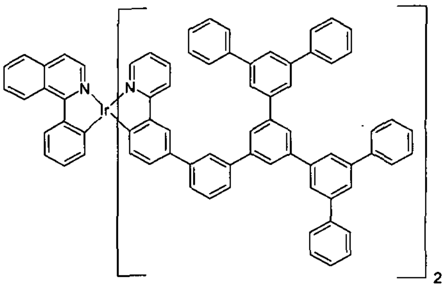 | 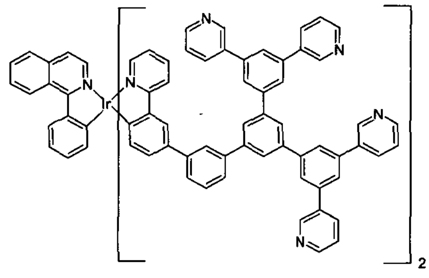 |
| (201) | (202) |
| 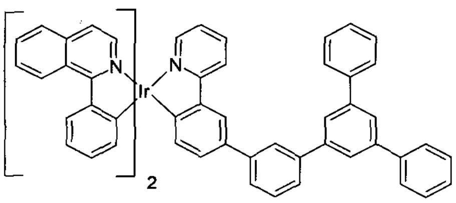 | 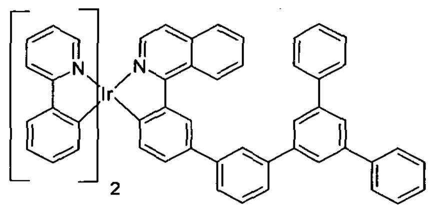 |
| (203) | (204) |
| 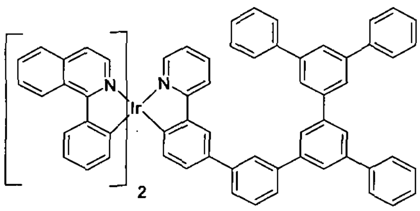 | 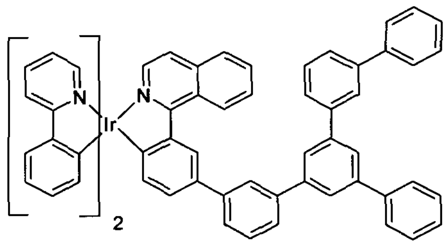 |
| (205) | (206) |
| 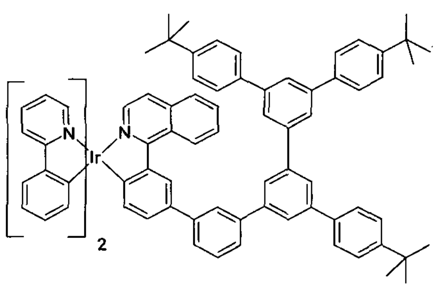 | 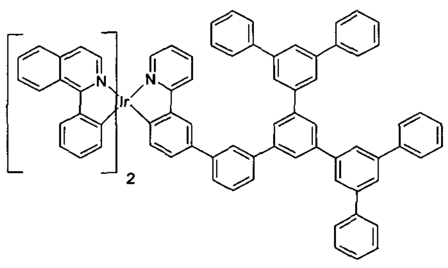 |
| (207) | (208) |

(continued)

| | |
|---|---|
| 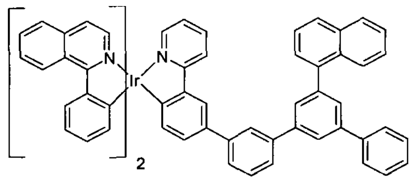 | 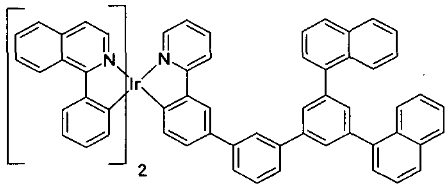 |
| (209) | (210) |
| 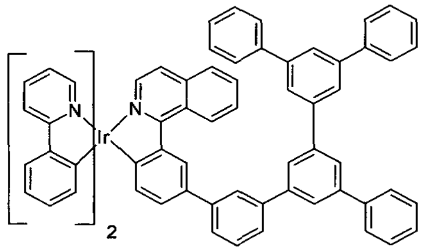 | 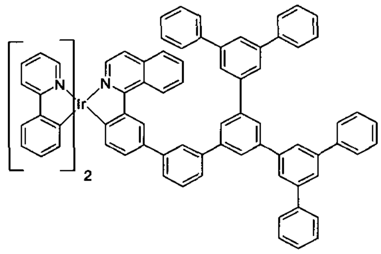 |
| (211) | (212) |
| 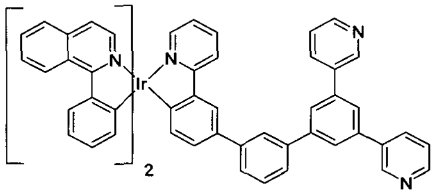 | 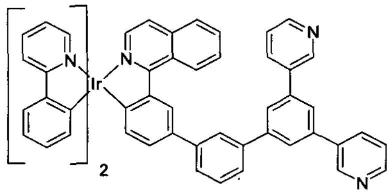 |
| (213) | (214) |
| 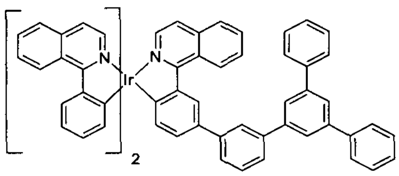 | 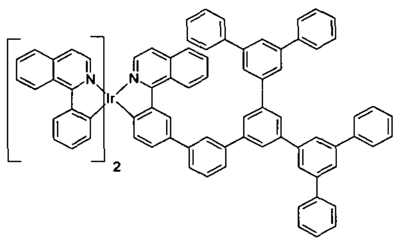 |
| (215) | (216) |
| 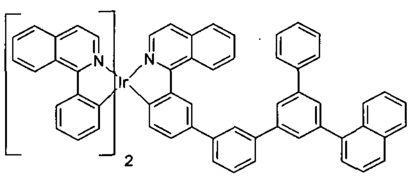 | 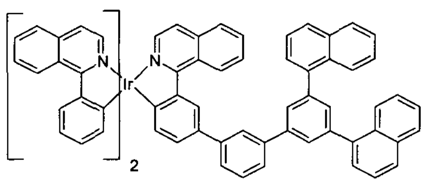 |
| (217) | (218) |
| 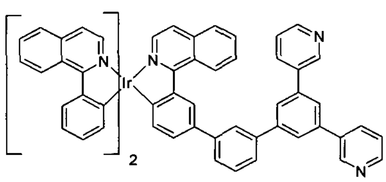 | 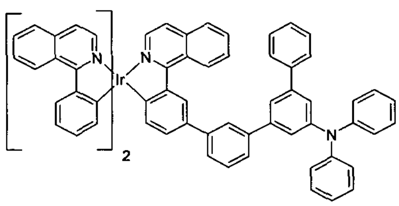 |
| (219) | (220) |

(continued)

| | |
|---|---|
| 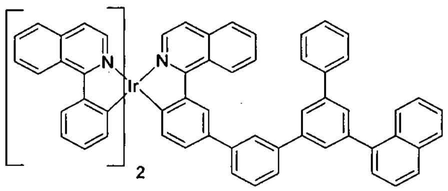 | 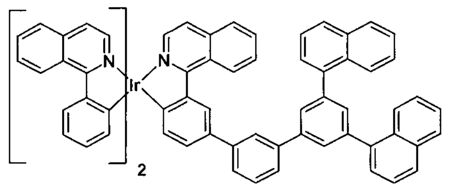 |
| (221) | (222) |
| 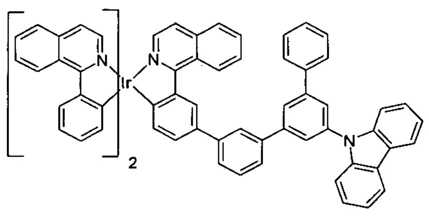 | 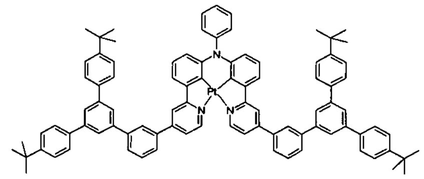 |
| (223) | (224) |
| 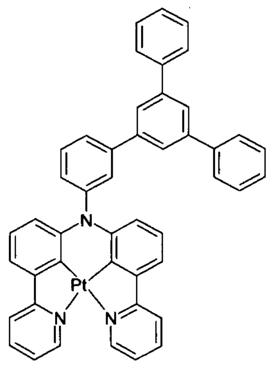 | 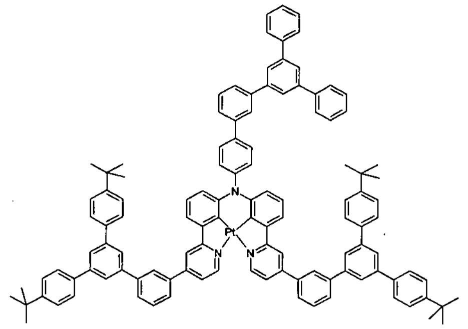 |
| (225) | (226) |

Preferred dopants are selected from the class of the monostyrylamines, the distyrylamines, the tristyrylamines, the tetrastyrylamines, the styryl-phosphines, the styryl ethers and the arylamines. A monostyrylamine is taken to mean a compound which contains one substituted or unsubstituted styryl group and at least one, preferably aromatic, amine. A distyrylamine is taken to mean a compound which contains two substituted or unsubstituted styryl groups and at least one, preferably aromatic, amine. A tristyrylamine is taken to mean a compound which contains three substituted or unsubstituted styryl groups and at least one, preferably aromatic, amine. A tetrastyrylamine is taken to mean a compound which contains four substituted or unsubstituted styryl groups and at least one, preferably aromatic, amine. The styryl groups are particularly preferably stilbenes, which may also be further substituted. Corresponding phosphines and ethers are defined analogously to the amines. For the purposes of the present invention, an arylamine or an aromatic amine is taken to mean a compound which contains three substituted or unsubstituted aromatic or heteroaromatic ring systems bonded directly to the nitrogen. At least one of these aromatic or heteroaromatic ring systems is preferably a condensed ring system, particularly preferably having at least 14 aromatic ring atoms. Preferred examples thereof are aromatic anthraceneamines, aromatic anthracenediamines, aromatic pyreneamines, aromatic pyrenediamines, aromatic chryseneamines or aromatic chrysenediamines. An aromatic anthraceneamine is taken to mean a compound in which one diarylamino group is bonded directly to an anthracene group, preferably in the 9-position. An aromatic anthracenediamine is taken to mean a compound in which two diarylamino groups are bonded directly to an anthracene group, preferably in the 9,10-position. Aromatic pyreneamines, pyrenediamines, chryseneamines and chrysenediamines are defined analogously thereto, where the diarylamino groups are preferably bonded to the pyrene in the 1-position or in the 1,6-position. Further preferred dopants are selected from indenofluoreneamines or indenofluorenediamines, for example in accordance with WO 06/122630, benzoindenofluoreneamines or benzoindenofluorenediamines, for example in accordance with WO 08/006449, and dibenzoindenofluoreneamines or dibenzoindenofluorenediamines, for example in accordance with WO 07/140847. Examples of dopants from the class of the styrylamines are substituted or unsubstituted tristilbeneamines or the dopants described in WO 06/000388, WO 06/058737,
WO 06/000389, WO 07/065549 and WO 07/115610. Preference is furthermore given to the condensed hydrocarbons

disclosed in DE 102008035413.

Suitable dopants are furthermore the structures depicted in the following table, and the derivatives of these structures disclosed in JP 06/001973, WO 04/047499, WO 06/098080, WO 07/065678, US 2005/0260442 and WO 04/092111.

| | | |
|---|---|---|
| 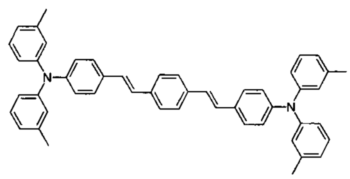 | 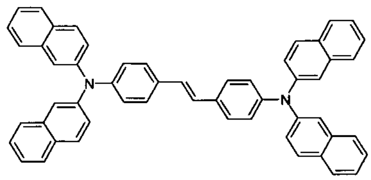 | 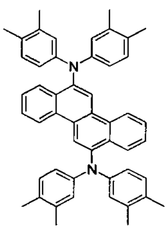 |
| (227) | (228) | (229) |
| 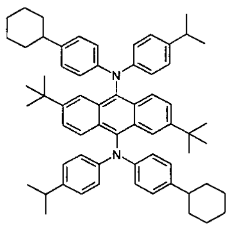 | 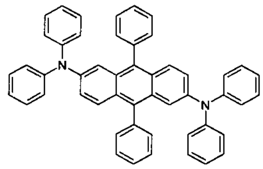 | 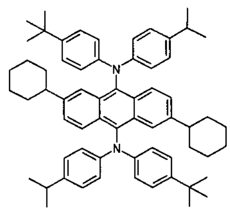 |
| (230) | (231) | (232) |

The proportion of the dopant in the mixture of the emitting layer is preferably between 0.1 and 50.0 % by weight, more preferably between 0.5 and 40.0 % by weight, and most preferably between 1.0 and 30.0 % by weight. Correspondingly, the proportion of the host material is between 40.0 and 99.9 % by weight, preferably between 50.0 and 99.5 % by weight, and more preferably between 60.0 and 99.0 % by weight.

Suitable host materials for this purpose are materials from various classes of substance. Preferred host materials are selected from the classes of the oligoarylenes (for example 2,2',7,7'-tetraphenylspirobifluorene in accordance with EP 676461 or dinaphthylanthracene), in particular the oligoarylenes containing condensed aromatic groups, the oligoarylenevinylenes (for example DPVBi or spiro-DPVBi in accordance with EP 676461), the polypodal metal complexes (for example in accordance with WO 04/081017), the hole-conducting compounds (for example in accordance with WO 04/058911), the electron-conducting compounds, in particular ketones, phosphine oxides, sulfoxides, etc. (for example in accordance with WO 05/084081 and WO 05/084082), the atropisomers (for example in accordance with WO 06/048268), the boronic acid derivatives (for example in accordance with WO 06/117052) or the benzanthracenes (for example in accordance with WO 08/145239). Suitable host materials are furthermore also the benzo[c]phenanthrene compounds according to the invention which are described above. Apart from the compounds according to the invention, particularly preferred host materials are selected from the classes of the oligoarylenes containing naphthalene, anthracene, benzanthracene and/or pyrene or atropisomers of these compounds, the oligoarylenevinylenes, the ketones, the phosphine oxides and the sulfoxides. Apart from the benzo[c]phenanthrene compounds according to the invention, very particularly preferred host materials are selected from the classes of the oligoarylenes containing anthracene, benzanthracene and/or pyrene or atropisomers of these compounds. For the purposes of this invention, an oligoarylene is intended to be taken to mean a compound in which at least three aryl or arylene groups are bonded to one another.

Suitable host materials are furthermore, for example, the materials depicted in the following table, and derivatives of these materials, as disclosed in WO 04/018587, WO 08/006449, US 5935721, US 2005/0181232, JP 2000/273056, EP 681019, US 2004/0247937 and US 2005/0211958.

| | | |
|---|---|---|
| 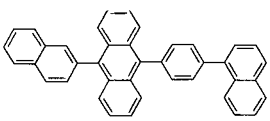 | 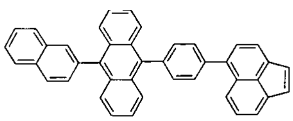 | 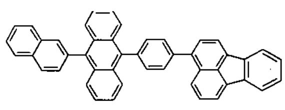 |
| (233) | (234) | (235) |

(continued)

| | | |
|---|---|---|
| 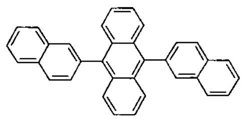 | 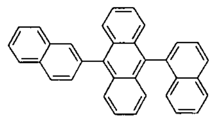 | 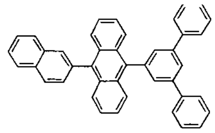 |
| (236) | (237) | (238) |
| 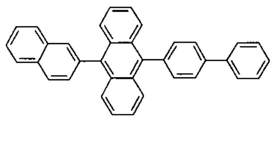 | 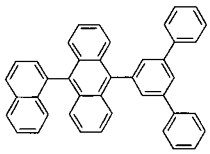 | 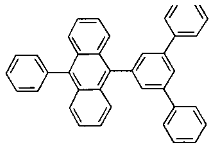 |
| (239) | (240) | (241) |
| 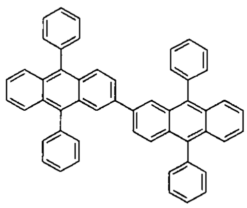 | 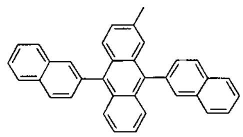 | 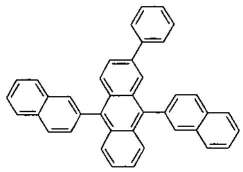 |
| (242) | (243) | (244) |

For the purposes of this invention, a hole-injection layer is a layer which is directly adjacent to the anode. For the purposes of this invention, a hole-transport layer is a layer which is located between a hole-injection layer and an emission layer. It may be preferred for them to be doped with electron-acceptor compounds, for example with $F_4$-TCNQ or with compounds as described in EP 1476881 or EP 1596445.

Suitable charge-transport materials, as can be used in the hole-injection or hole-transport layer or in the electron-injection or electron-transport layer of the organic electroluminescent device according to the invention, are, for example, the compounds disclosed in Y. Shirota et al., Chem. Rev. 2007, 107(4), 953-1010, or other materials as employed in these layers in accordance with the prior art.

Examples of preferred hole-transport materials which can be used in a hole-transport or hole-injection layer of the electroluminescent device according to the invention are indenofluoreneamines and derivatives (for example in accordance with WO 06/122630 or WO 06/100896), the amine derivatives as disclosed in EP 1661888, hexaazatriphenylene derivatives (for example in accordance with WO 01/049806), amine derivatives with condensed aromatics (for example in accordance with US 5,061,569), the amine derivatives as disclosed in WO 95/09147, monobenzoindenofluoreneamines (for example in accordance with WO 08/006449) or dibenzoindenofluoreneamines (for example in accordance with WO 07/140847). Suitable hole-transport and hole-injection materials are furthermore derivatives of the compounds depicted above, as disclosed in JP 2001/226331, EP 676461, EP 650955, WO 01/049806, US 4780536, WO 98/30071, EP 891121, EP 1661888, JP 2006/253445, EP 650955, WO 06/073054 and US 5061569.

Suitable hole-transport or hole-injection materials are furthermore, for example, the materials as disclosed in the following table.

| | | |
|---|---|---|
| 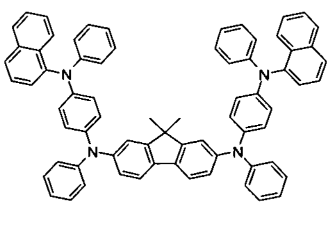 | 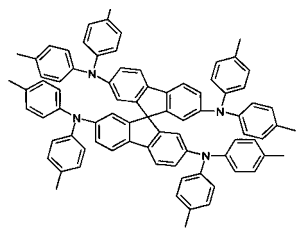 | 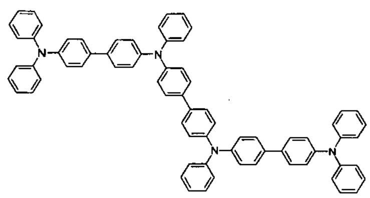 |
| (245) | (246) | (247) |

(continued)

| | | |
|---|---|---|
| 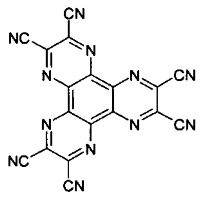 | 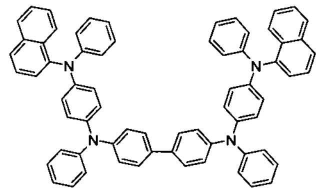 | 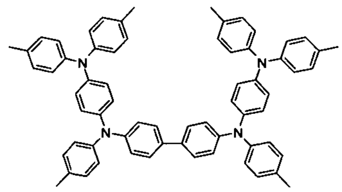 |
| (248) | (249) | (250) |
| 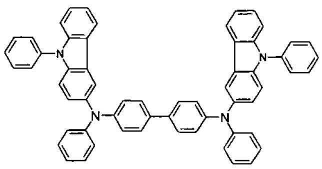 | 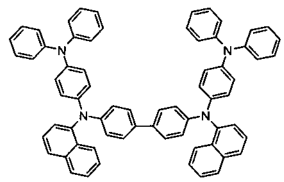 | 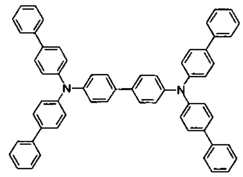 |
| (251) | (252) | (253) |
| 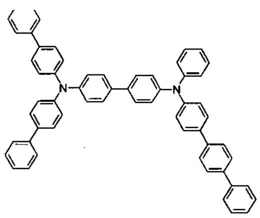 | 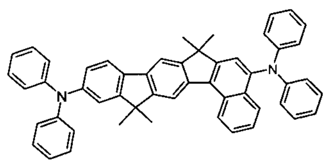 | 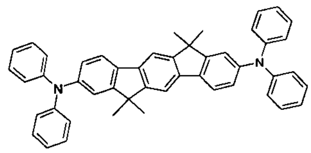 |
| (254) | (255) | (256) |
| 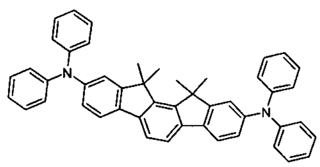 | 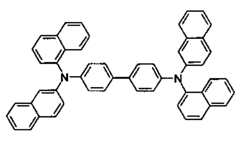 | 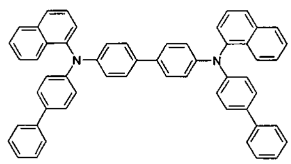 |
| (257) | (258) | (259) |
| 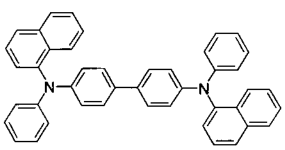 | 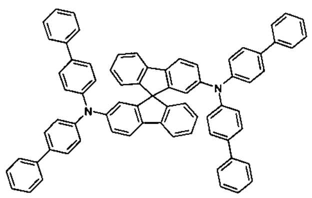 | 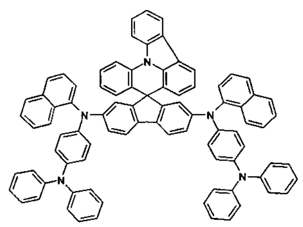 |
| (260) | (261) | (262) |

Suitable electron-transport or electron-injection materials which can be used in the electroluminescent device according to the present invention are, for example, the materials as disclosed in the following table. Suitable electron-transport and electron-injection materials are furthermore derivatives of the compounds depicted above, as disclosed in JP 2000/053957, WO 03/060956, WO 04/028217 and WO 04/080975.

| | |
|---|---|
| 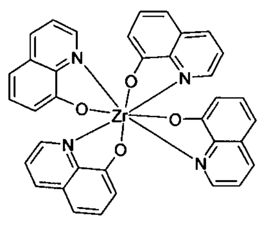 | 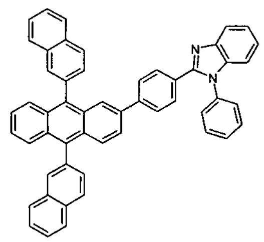 |
| (263) | (264) |
| 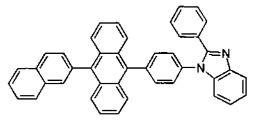 | 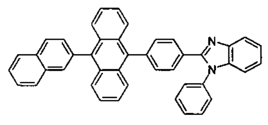 |
| (265) | (266) |

Suitable matrix materials for the compounds according to the invention are ketones, phosphine oxides, sulfoxides and sulfones, for example in accordance with WO 04/013080, WO 04/093207, WO 06/005627 or DE 102008033943, triarylamines, carbazole derivatives, for example CBP (N,N-biscarbazolyl-biphenyl) or the carbazole derivatives disclosed in WO 05/039246, US 2005/0069729, JP 2004/288381, EP 1205527 or WO 08/086851, indolocarbazole derivatives, for example in accordance with WO 07/063754 or WO 08/056746, azacarbazoles, for example in accordance with EP 1617710, EP 1617711, EP 1731584, JP 2005/347160, bipolar matrix materials, for example in accordance with WO 07/137725, silanes, for example in accordance with WO 05/111172, azaboroles or boronic esters, for example in accordance with WO 06/117052, triazine derivatives, for example in accordance with DE 102008036982,
WO 07/063754 or WO 08/056746, or zinc complexes, for example in accordance with DE 102007053771.

Astonishing improvements can be achieved with one or more functional compounds having a high solubility. Preferred organic functional compounds can comprise Hansen Solubility parameters of $H_d$ in the range of 17.0 to 20.0 $MPa^{0.5}$, Hp in the range of 2 to 10.0 $MPa^{0.5}$ and $H_h$ in the range of 0.0 to 15.0 $MPa^{0.5}$. More preferred functional compounds comprise Hansen Solubility parameters of $H_d$ in the range of 17.5 to 19.0 $MPa^{0.5}$, Hp in the range of 3.5 to 8.0 $MPa^{0.5}$ and $H_h$ in the range of 3.0 to 10.0 $MPa^{0.5}$.

Surprising effects can be achieved with functional compounds having a radius of at least 3.0 $MPa^{0.5}$, preferably at least 4.5 $MPa^{0.5}$ and more preferably at least 5.0 $MPa^{0.5}$determined according to Hansen Solubility parameters.

Especially preferred host materials, hole-transport materials, electron- or exciton-blocking materials, matrix materials for fluorescent or phosphorescent compounds, hole-blocking materials or electron-transport materials comprise one or more compounds according to formula (H1)

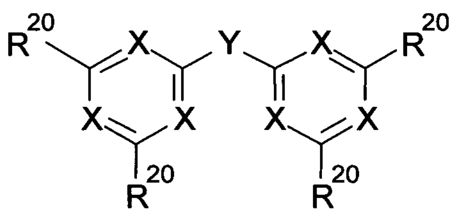

(H1)

where the following applies to the symbols used:

Y is C=O or $C(R^{21})_2$;

X is on each occurrence, identically or differently, $CR^{22}$ or N;

$R^{20}$ is on each occurrence, identically or differently, an aromatic or hetero-aromatic ring system having 5 to 60 aromatic ring atoms, which may be substituted by one or more radicals $R^{23}$, or an $N(Ar)_2$, $Si(Ar)_3$, C(=O)Ar, OAr, ArSO, $ArSO_2$ $P(Ar)_2$, $P(O)(Ar)_2$ or $B(Ar)_2$ group;

Ar is on each occurrence, identically or differently, an aromatic or hetero-aromatic ring system having 5 to 30 aromatic

ring atoms, which may be substituted by one or more non-aromatic radicals $R^{23}$; two radicals Ar here which are bonded to the same nitrogen, phosphorus or boron atom may also be linked to one another by a single bond or a bridge selected from $B(R^{24})$, $C(R^{24})_2$, $Si(R^{24})_2$, C=O, C=N $R^{24}$, $C=C(R^{24})_2$, O, S, S=O, $SO_2$, $N(R^{24})$, $P(R^{24})$ and P(=O) $R^{24}$;

$R^{21}$ is on each occurrence, identically or differently, H, D, F or a linear alkyl group having 1 to 20 C atoms or a branched or cyclic alkyl group having 3 to 20 C atoms; a plurality of radicals $R^{21}$ here may form a ring system with one another;

$R^{22}$ is on each occurrence, identically or differently, H, D, F, CN, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^{24}$, where one or more non-adjacent $CH_2$ groups may be replaced by $R^{24}C=CR^{24}$, C≡C, O or S and where one or more H atoms may be replaced by F;

$R^{23}$ is on each occurrence, identically or differently, H, D, F, Cl, Br, I, CHO, $N(Ar)_2$, C(=O)Ar, $P(=O)(Ar)_2$, S(=O)Ar, $S(=O)_2Ar$, $CR^{22}=CR^{22}Ar$, CN, $NO_2$, $Si(R^{24})_3$, $B(OR^{24})_2$, $B(R^{24})_2$, $B(N(R^{24})_2)_2$, $OSO_2$ $R^{24}$, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^{24}$, where one or more non-adjacent $CH_2$ groups may be replaced by $R^{24}C=CR^{24}$, C≡C, $Si(R^{24})_2$, $Ge(R^{24})_2$, $Sn(R^{24})_2$, C=O, C=S, C=Se, $C=NR^{24}$, $P(=O)(R^{24})$, SO, $SO_2$, $R^{24}$, O, S or $CONR^{24}$ and where one or more H atoms may be replaced by F, Cl, Br, I, CN or $NO_2$ or an aromatic or heteroaromatic ring system having 5 to 60 aromatic ring atoms, which may in each case be substituted by one or more radicals $R^{24}$, or an aryloxy or heteroaryloxy group having 5 to 60 aromatic ring atoms, which may be substituted by one or more radicals $R^{24}$, or a combination of these systems; two or more adjacent substituents $R^{23}$ here may also form a mono- or polycyclic, aliphatic or aromatic ring system with one another;

$R^{24}$ is on each occurrence, identically or differently, H, D or an aliphatic, aromatic and/or heteroaromatic hydrocarbon radical having 1 to 20 C atoms, in which, in addition, H atoms may be replaced by F; two or more adjacent substituents $R^{24}$ here may also form a mono- or polycyclic, aliphatic or aromatic ring system with one another.

More preferably, compounds according to according to formula (H1a) can be used,

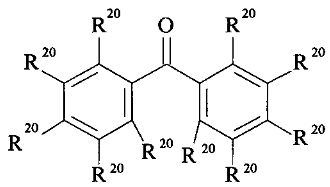

(H1a),

wherein the residue $R^{20}$ has the same meaning as in formula (H1).

More preferably, compounds according to according to formula (H1b) can be used,

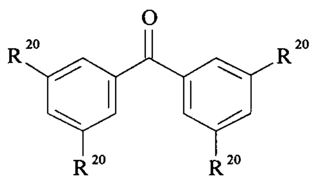

(H1b),

wherein the residue $R^{20}$ has the same meaning as in formula (H1).

Preferably, the compounds according to formulae (H1), (H1a) and/or (H1b), meet the requirements of formula (I), formula (II) and/or formula (III) and comprise at least one solubilizing structure element of formulae (L-I), (L-II) and (L-III), respectively.

Especially preferred host materials, hole-transport materials, electron- or exciton-blocking materials, matrix materials for fluorescent or phosphorescent compounds, hole-blocking materials or electron-transport materials comprise one or more compounds according to formula (H2a) and/or (H2b),

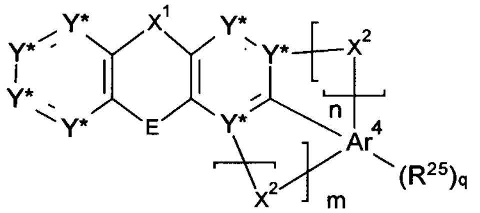

(H2a)

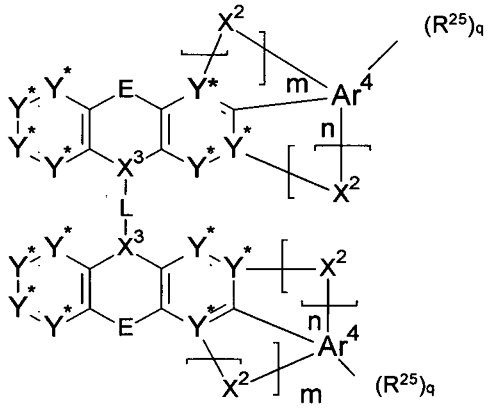

(H2b)

where the following applies to the symbols used:

Y* is C if a group $X^2$ is bonded to the group Y, or is on each occurrence, identically or differently, $CR^{25}$ or N if no group $X^2$ is bonded to the group Y;

E is on each occurrence, identically or differently, a covalent single bond or a divalent bridge selected from $N(R^{26})$, $B(R^{26})$, $C(R^{26})_2$, O, $Si(R^{26})_2$, $C=NR^{26}$, $C=C(R^{26})_2$, S, S=O, $SO_2$, $P(R^{26})$ and $P(=O)R^{26}$;

$X^1$ is on each occurrence, identically or differently, a divalent bridge selected from $N(R^{26})$, $B(R^{26})$, O, $C(R^{26})_2$, $Si(R^{26})_2$, $C=NR^{26}$, $C=C(R^{26})_2$, S, S=O, $SO_2$, $P(R^{26})$ and $P(=O)R^{26}$;

$X^2$ is on each occurrence, identically or differently, a divalent bridge selected from $N(R^{26})$, $B(R^{26})$, $C(R^{26})_2$, $Si(R^{26})_2$, C=O, $C=NR^{26}$, $C=C(R^{26})_2$, S, S=O, $SO_2$, $CR^{26}$-$CR^{26}$, $P(R^{26})$ and $P(=O)R^{26}$;

$X^3$ is on each occurrence, identically or differently, a divalent bridge selected from N, B, $C(R^{26})$, $Si(R^{26})$, P and P(=O);

L is a divalent aromatic or heteroaromatic ring system having 5 to 40 aromatic ring atoms, which may be substituted by one or more radicals $R^{26}$;

n, m are, identically or differently on each occurrence, 0 or 1, with the proviso that n + m = 1 or 2;

q is 1, 2, 3, 4, 5 or 6;

$R^{25}$ is on each occurrence, identically or differently, H, D, F, Cl, Br, I, N(Ar)2, C(=O) $Ar^4$, P(=O) $Ar^42$, S(=O)$Ar^4$, $S(=O)_2Ar^4$, $CR^{27}=CR^{27}Ar^4$, CN, $NO_2$ $Si(R^{27})_3$, $B(OR^{27})_2$, $OSO_2R^{27}$, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^{27}$, where one or more non-adjacent $CH_2$ groups may be replaced by $R^{27}C=CR^{27}$, C=C, $Si(R^{27})_2$, $Ge(R^{27})_2$, $Sn(R^{27})_2$, C=O, C=S, C=Se, $C=NR^{27}$, $P(=O)(R^{27})$, SO, $SO_2$, $NR^{27}$, O, S or $CONR^{27}$ and where one or more H atoms may be replaced by D, F, Cl, Br, I, CN or $NO_2$ or an aryl or heteroaryl group having 5 to 40 ring atoms, which may in each case be substituted by one or more radicals $R^{27}$, or an aromatic or heteroaromatic ring system having 5 to 60 aromatic ring atoms, which may in each case be substituted by one or more radicals $R^{27}$, or an aryloxy or heteroaryloxy group having 5 to 40 aromatic ring atoms, which may be substituted by one or more radicals $R^{27}$, or an aralkyl or heteroaralkyl group having 5 to 40 aromatic ring atoms, which may be substituted by one or more radicals $R^{27}$, or a combination of these systems; two or more substituents R here, together with the atoms to which they are bonded, may also

form a mono- or polycyclic aliphatic or aromatic ring system with one another or, if they are bonded to $Ar^4$, with $Ar^4$;

$R^{26}$ is on each occurrence, identically or differently, H, D, F, Cl, Br, I, CN, $NO_2$, $CF_3$, $B(OR^{27})_2$, $Si(R^{27})_3$, a straight-chain alkyl, alkoxy or thioalkoxy group having 1 to 40 C atoms or a branched or cyclic alkyl, alkoxy or thioalkoxy group having 3 to 40 C atoms, or an alkenyl or alkynyl group having 2 to 40 C atoms, each of which may be substituted by one or more radicals $R^{27}$, where one or more non-adjacent $CH_2$ groups may be replaced by $-R^{27}C=CR^{27}-$, -C≡C-, $Si(R^{27})_2$, $Ge(R^{27})_2$, $Sn(R^{27})_2$, C=O, C=S, C=Se, $C=NR^{27}$, -O-, -S-, -COO- or $-CONR^{27}-$ and where one or more H atoms may be replaced by F, Cl, Br, I, CN or $NO_2$ or arylamines, or substituted or unsubstituted carbazoles, which may in each case be substituted by one or more radicals $R^{27}$, or an aryl or heteroaryl group having 5 to 40 ring atoms, which may be substituted by one or more aromatic, heteroaromatic or non-aromatic radicals $R^{27}$, or an aromatic or heteroaromatic ring system having 5 to 60 aromatic ring atoms, which may be substituted by one or more non-aromatic radicals $R^{27}$, or an aryloxy or heteroaryloxy group having 5 to 40 aromatic ring atoms, which may be substituted by one or more radicals $R^{27}$, or an aralkyl or heteroaralkyl group having 5 to 40 aromatic ring atoms, which may be substituted by one or more radicals $R^{27}$, or a combination of these systems; two or more substituents $R^{26}$ here may also form a mono- or polycyclic aliphatic or aromatic ring system with one another, together with the atoms to which they are bonded;

$R^{27}$ is on each occurrence, identically or differently, H, D or an aliphatic hydrocarbon radical having 1 to 20 C atoms or an aryl or heteroaryl group having 5 to 40 ring atoms, or a combination of these groups;

$Ar^4$ is on each occurrence, identically or differently, an aromatic or hetero-aromatic ring system, preferably an aryl or heteroaryl group having 5 to 40 ring atoms, which may be substituted by one or more radicals $R^{26}$.

Preferably, the compounds according to formulae (H2a) and/or (H2b), meet the requirements of formula (I), formula (II) and/or formula (III) and comprise at least one solubilizing structure element of formulae (L-I), (L-II) and (L-III), respectively.

Especially preferred host materials, hole-transport materials, electron- or exciton-blocking materials, matrix materials for fluorescent or phosphorescent compounds, hole-blocking materials or electron-transport materials comprise one or more compounds according to formula (H3a) and/or formula (H3b),

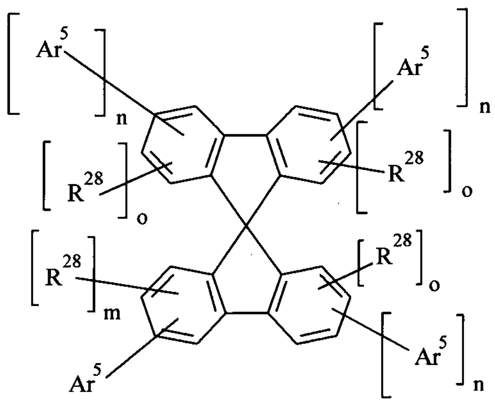

**(H3a)**

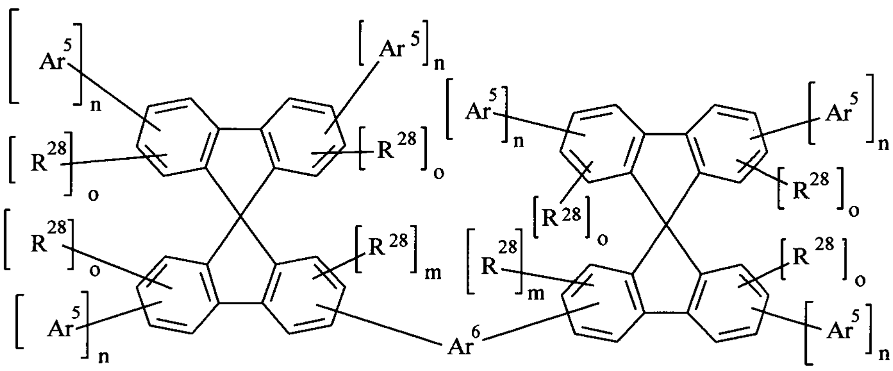

(H3b)

where the following applies to the symbols and indices used:

$Ar^5$ is a group of the following formula (H3c):

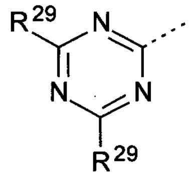

(H3c)

where the dashed bond indicates the bond to the spirobifluorene;
$Ar^6$ is a group of the following formula (H3d):

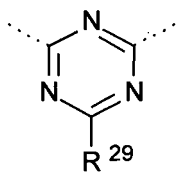

(H3d)

where the dashed bonds indicate the bonds to the spirobifluorene;

$R^{28}$, $R^{29}$ are on each occurrence, identically or differently, H, D, F, Cl, Br, I, CHO, $N(R^{30})_2$, $N(Ar^7)_2$, $B(Ar^7)_2$, $C(=O)Ar^7$, $P(=O)(Ar^7)_2$, $S(=O)Ar^7$, $S(=O)_2Ar^7$, $CR^{30}=CR^{30}Ar^7$, CN, $NO_2$ $Si(R^{30})_3$, $B(OR^{30})_2$, $B(R^{30})_2$, $B(N(R^{30})_2)_2$, $OSO_2R^{30}$, a straight-chain alkyl, alkenyl, alkynyl, alkoxy or thioalkoxy group having 1 to 40 C atoms or a branched or cyclic alkyl, alkenyl, alkynyl, alkoxy or thioalkoxy group having 3 to 40 C atoms, each of which may be substituted by one or more radicals $R^{30}$, where one or more non-adjacent $CH_2$ groups may be replaced by $R^{30}C=CR^{30}$, C≡C, $Si(R^{30})_2$, $Ge(R^{30})_2$, $Sn(R^{30})_2$, C=O, C=S, C=Se, $C=NR^{30}$, $P(=O)(R^{30})$, SO, $SO_2$, $NR^{30}$, O, S or $CONR^{30}$ and where one or more H atoms may be replaced by D, F, Cl, Br, I, CN or $NO_2$ or an aromatic or heteroaromatic ring system having 5 to 60 aromatic ring atoms, which may in each case be substituted by one or more radicals $R^{30}$, or an aryloxy or heteroaryloxy group having 5 to 60 aromatic ring atoms, which may be substituted by one or more radicals $R^{30}$, or a combination of these systems; two or more adjacent substituents $R^{28}$ here may also form a mono- or polycyclic, aliphatic or aromatic ring system with one another;

$Ar^7$ is on each occurrence, identically or differently, an aromatic or heteroaromatic ring system having 5 to 30 aromatic ring atoms, which may be substituted by one or more radicals $R^{30}$; two radicals $Ar^7$ here which are bonded to the same nitrogen, phosphorus or boron atom may also be linked to one another by a single bond or a bridge selected from $B(R^{30})$, $C(R^{30})_2$, $Si(R^{30})_2$, C=O, $C=NR^{30}$, $C=C(R^{30})_2$, O, S, S=O, $SO_2$, $N(R^{30})$, $P(R^{30})$ and $P(=O)R^{30}$;

$R^{30}$ is on each occurrence, identically or differently, H, D or an aliphatic, aromatic and/or heteroaromatic hydrocarbon radical having 1 to 20 C atoms, in which, in addition, H atoms may be replaced by D or F; two or more adjacent substituents $R^{30}$ here may also form a mono- or polycyclic, aliphatic or aromatic ring system with one another;

n is 0 or 1;

m is 0, 1, 2 or 3; and

o is 0, 1, 2, 3 or 4 if n = 0 in the same ring and is 0, 1, 2 or 3 if n = 1 in the same ring.

Preferably, the compounds according to formulae (H3a) and/or (H3b), meet the requirements of formula (I), formula (II) and/or formula (III) and comprise at least one solubilizing structure element of formulae (L-I), (L-II) and (L-III), respectively.

Preferred compounds having solubilising groups include

| | |
|---|---|
| 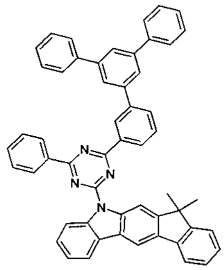 | 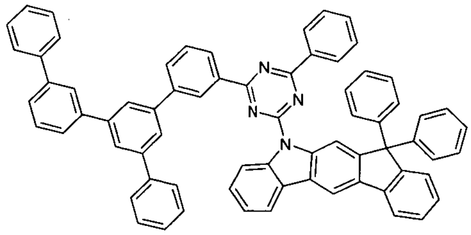 |
| (267) | (268) |
| 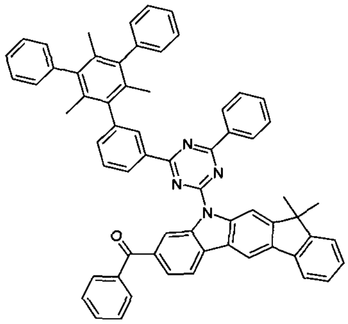 | 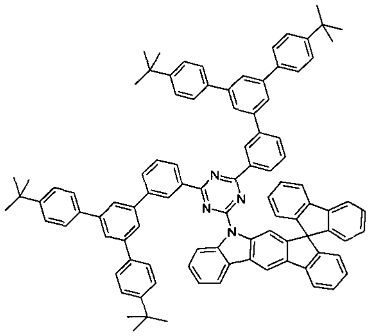 |
| (269) | (270) |
| 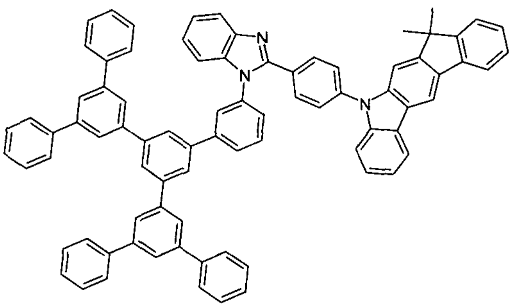 | 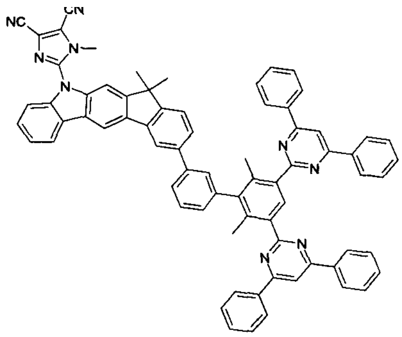 |
| (271) | (272) |

(continued)

| | |
|---|---|
| 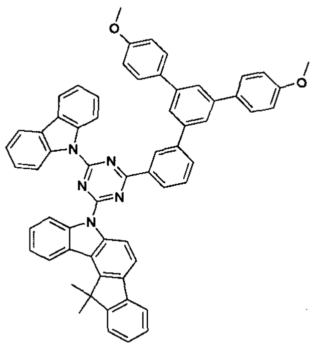 | 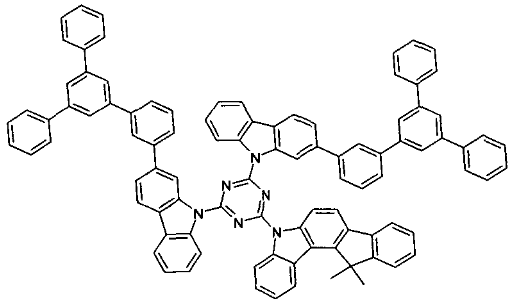 |
| (273) | (274) |
| 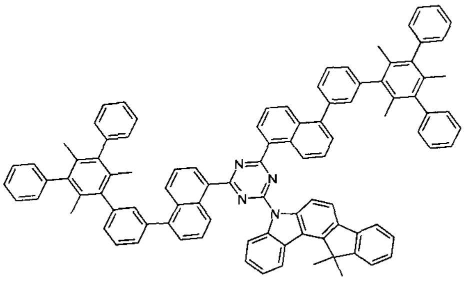 | 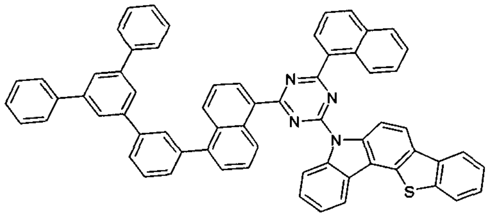 |
| (275) | (276) |
| 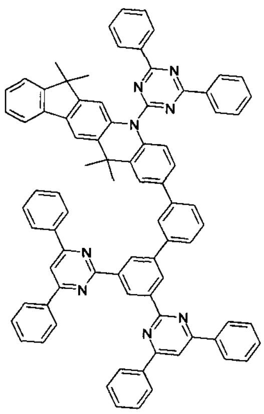 | 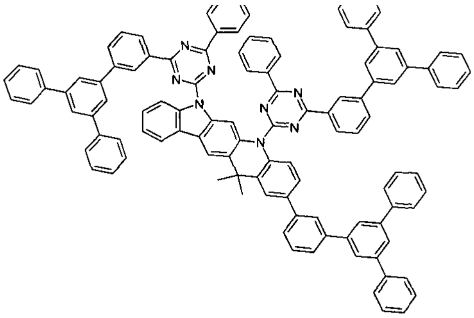 |
| (277) | (278) |
| 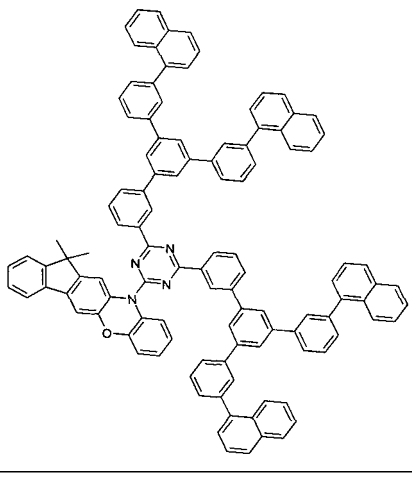 | 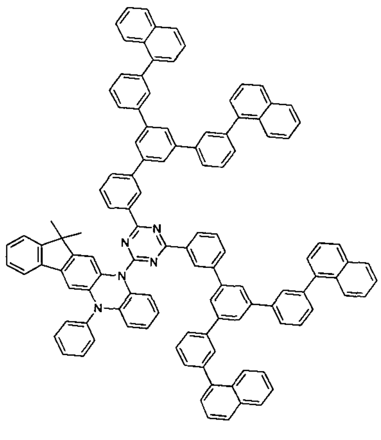 |
| (279) | (280) |

(continued)

| | |
|---|---|
| 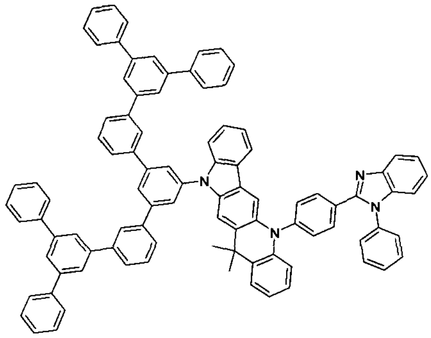 | 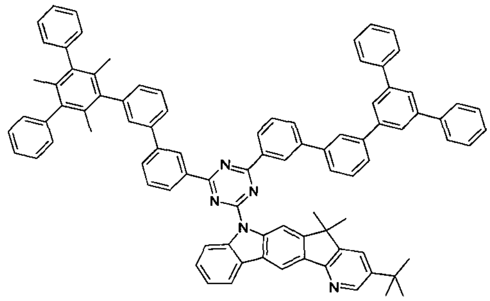 |
| (281) | (282) |
| 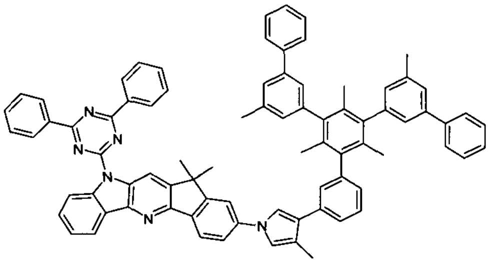 | 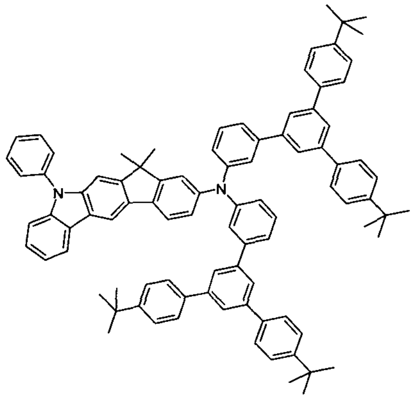 |
| (283) | (284) |
| 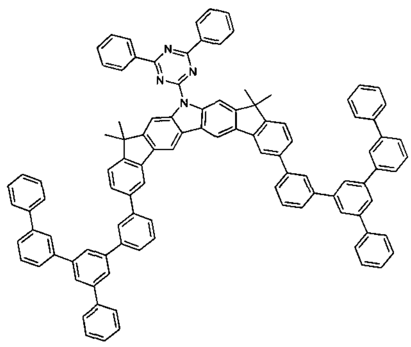 | 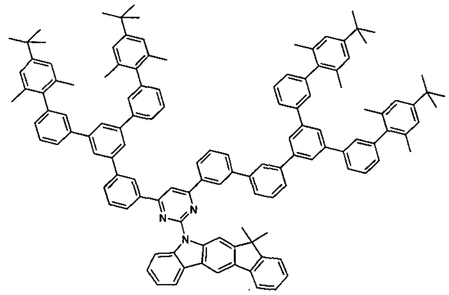 |
| (285) | (286) |
| 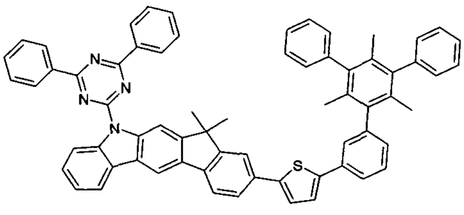 | 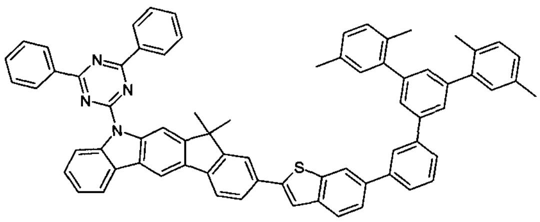 |
| (287) | (288) |

(continued)

| | |
|---|---|
| 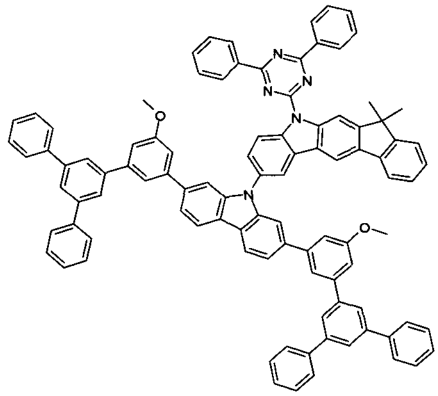 | 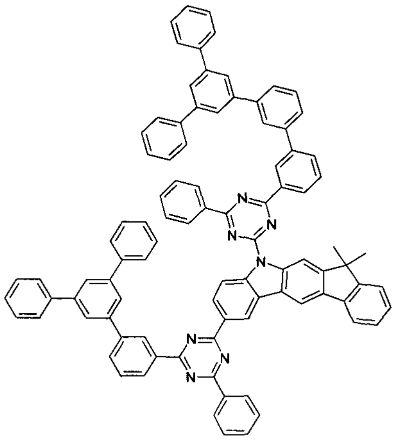 |
| (289) | (290) |
| 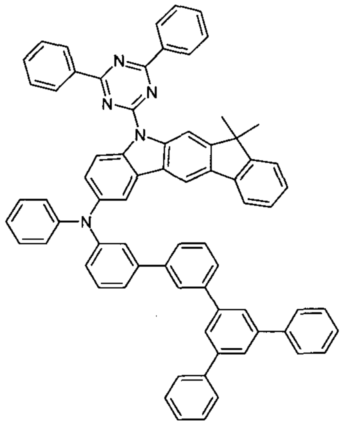 | 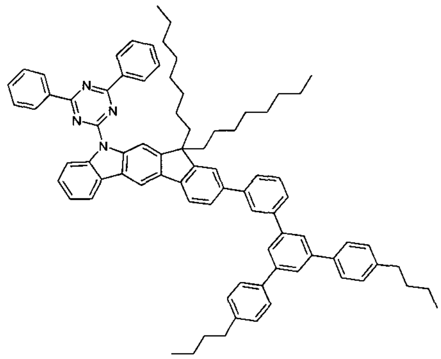 |
| (291) | (292) |
| 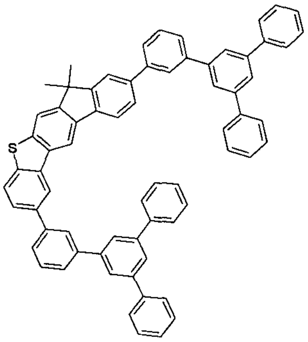 | 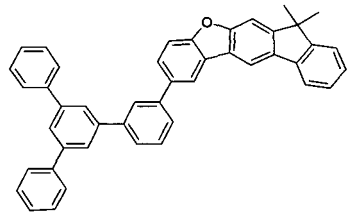 |
| (293) | (294) |

(continued)

| | |
|---|---|
| 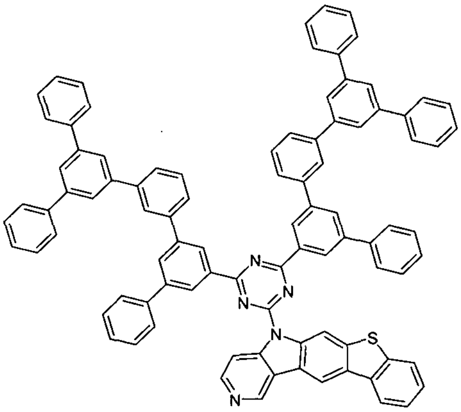 | 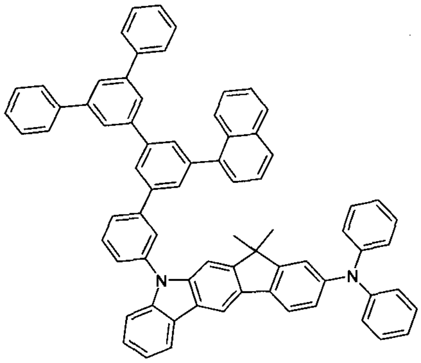 |
| (295) | (296) |
| 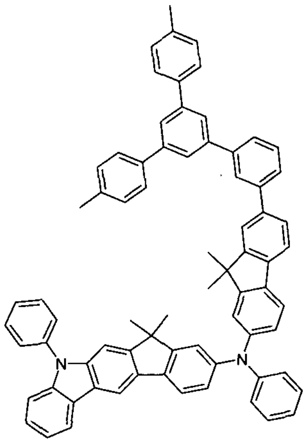 | 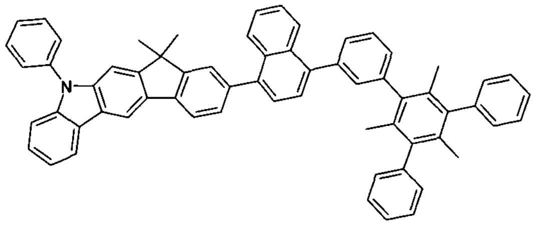 |
| (297) | (298) |
| 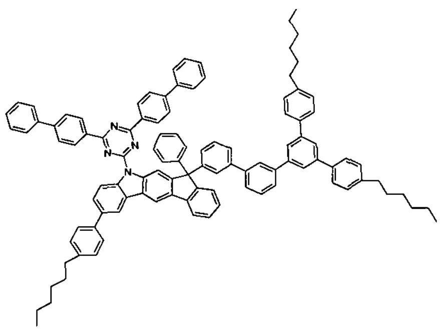 | 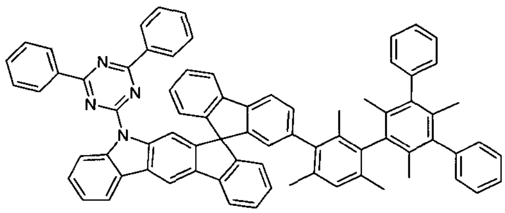 |
| (299) | (300) |

(continued)

| | |
|---|---|
| 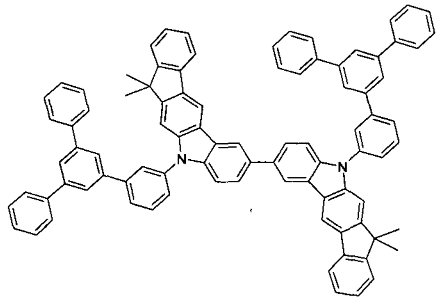 | 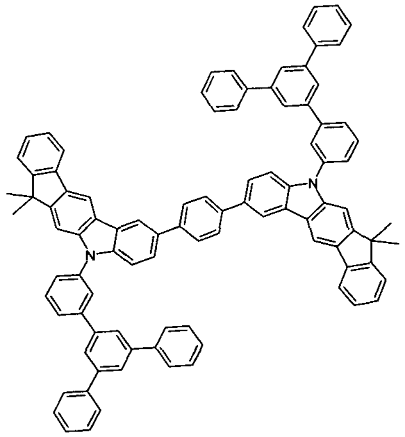 |
| (301) | (302) |
| 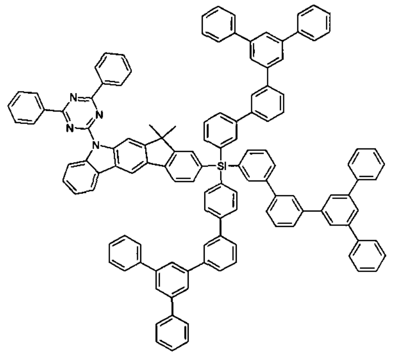 | 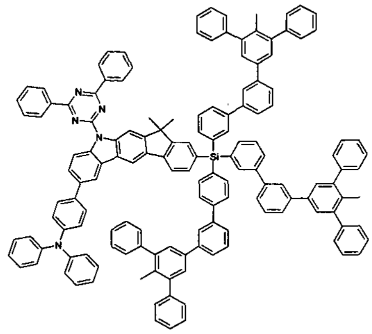 |
| (303) | (304) |
| 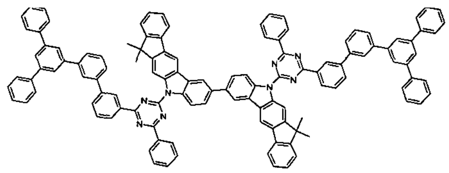 | 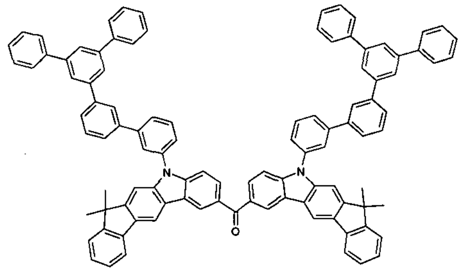 |
| (305) | (306) |

(continued)

| | |
|---|---|
| 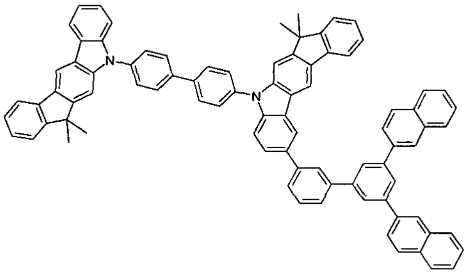 | 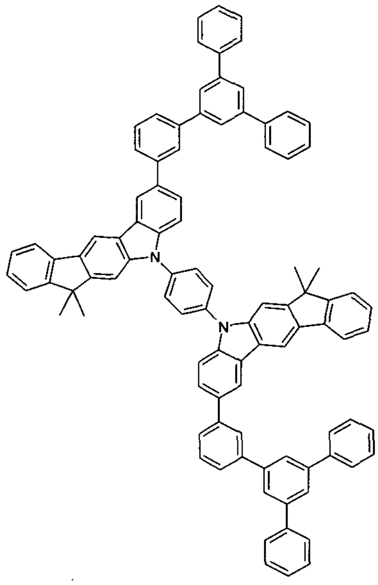 |
| (307) | (308) |
| 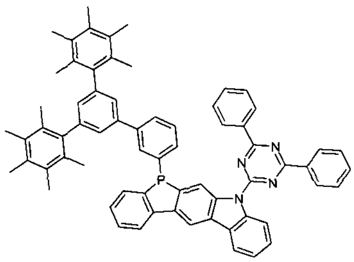 | 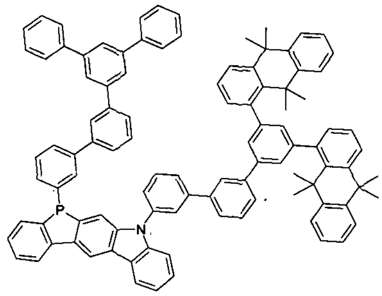 |
| (309) | (310) |
| 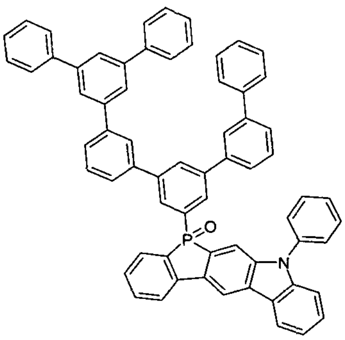 | 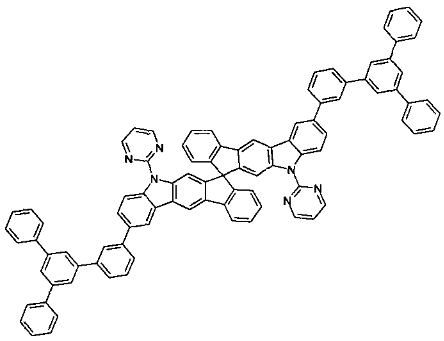 |
| (311) | (312) |

(continued)

| | |
|---|---|
| 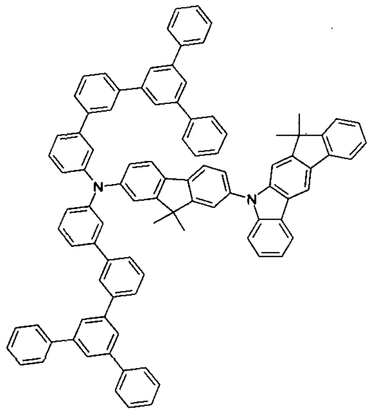 | 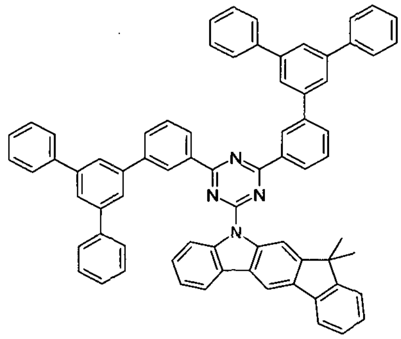 |
| (313) | (314) |
| 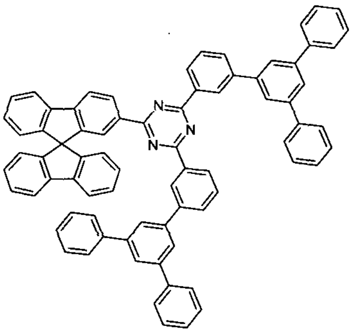 | 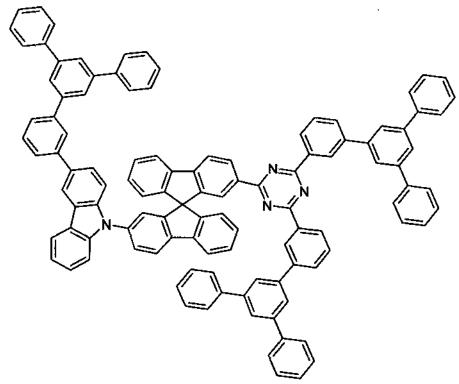 |
| (315) | (316) |
| 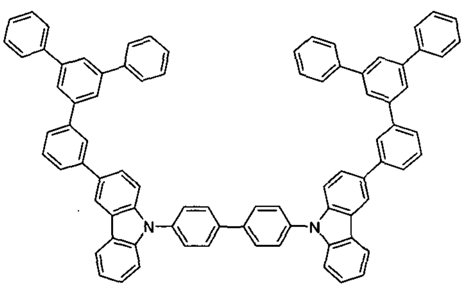 | 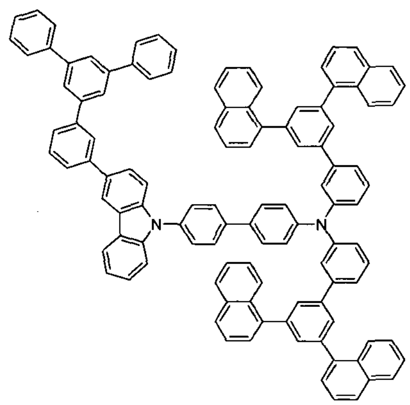 |
| (317) | (318) |

(continued)

| | |
|---|---|
| 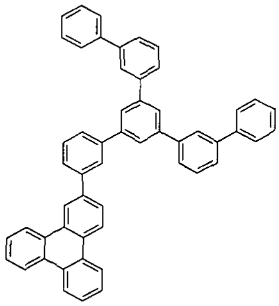 | 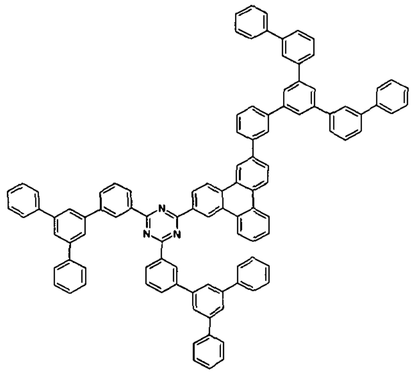 |
| (319) | (320) |
| 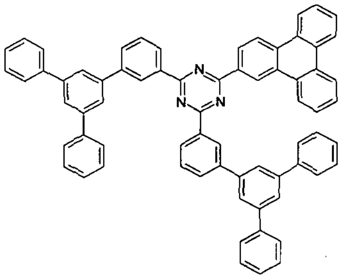 | 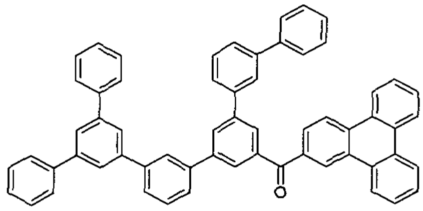 |
| (321) | (322) |
| 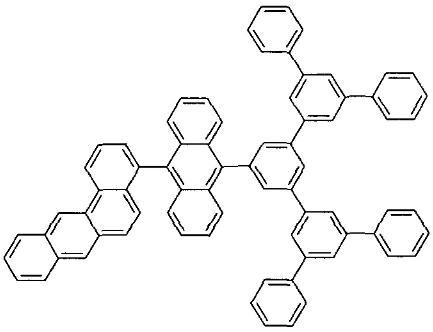 | 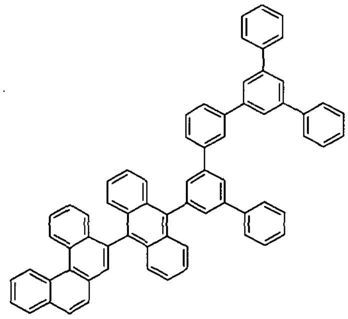 |
| (323) | (324) |
| 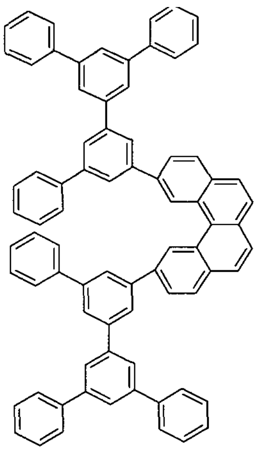 | 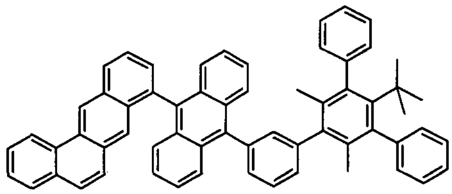 |
| (325) | (326) |

(continued)

| | |
|---|---|
| 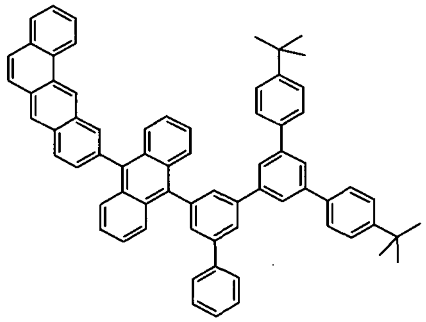 | 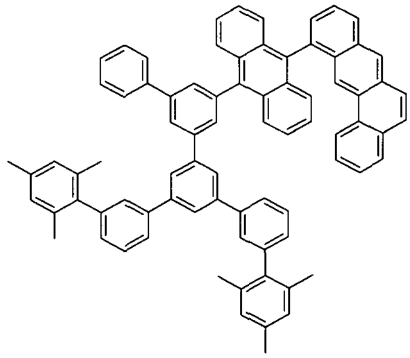 |
| (327) | (328) |
| 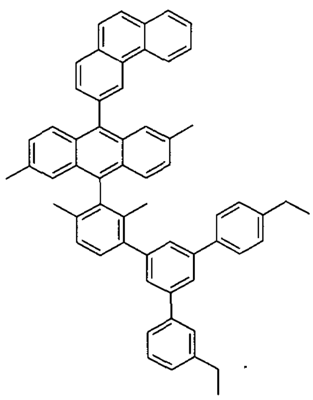 | 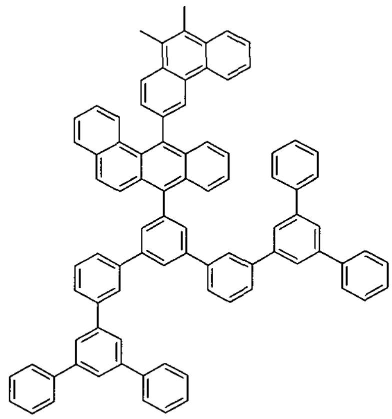 |
| (329) | (330) |
| 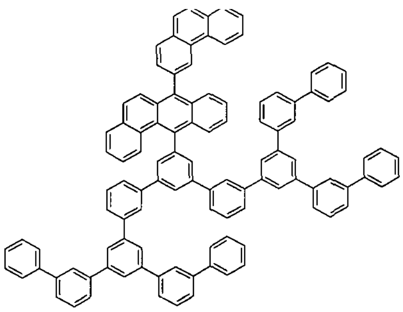 | 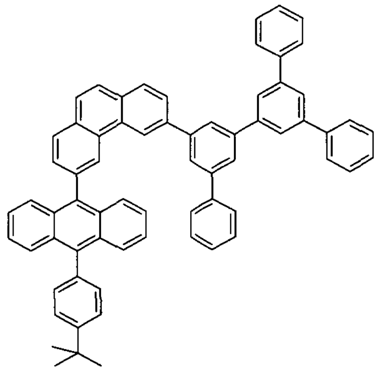 |
| (331) | (332) |
| 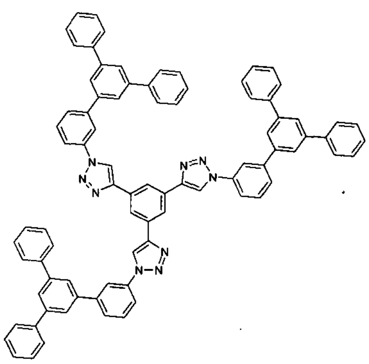 | 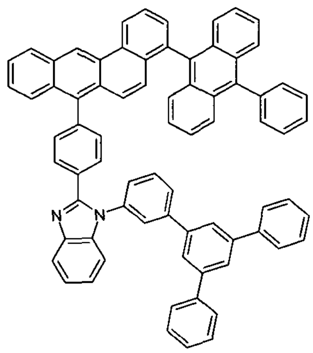 |

(continued)

| (333) | (334) |
|---|---|
| 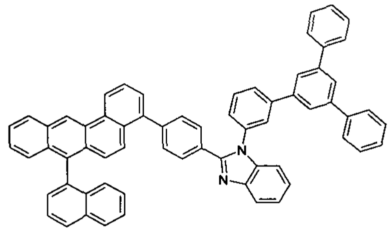 | 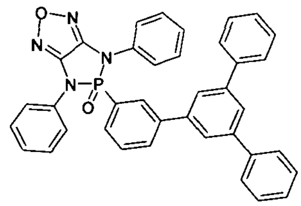 |
| (335) | (336) |
| 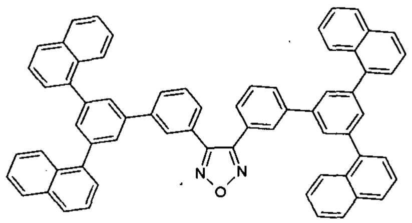 | 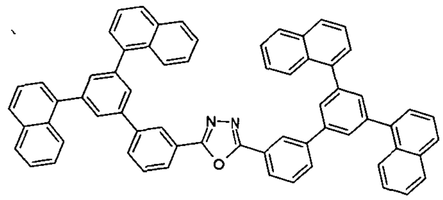 |
| (337) | (338) |
| 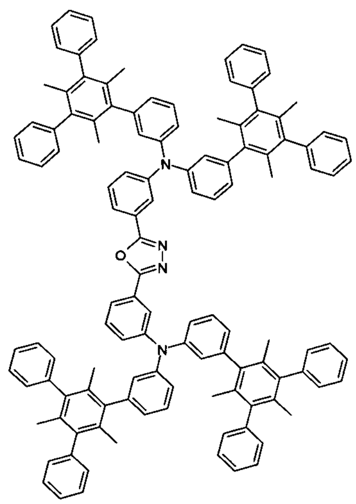 | 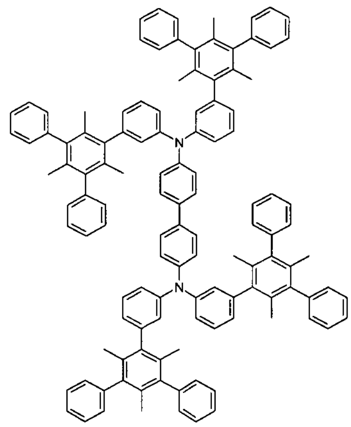 |
| (339) | (340) |

Further suitable compounds, their Hansen Solubility Parameters including their radiuses are mentioned in the following table 2:

Table 2: Hansen Solubility Parameters of suitable compounds

| Material | $H_d$[MPa$^{0.5}$] | $H_h$[MPa$^{0.5}$] | $H_p$[MPa$^{0.5}$] | Radius[MPa$^{0.5}$] |
|---|---|---|---|---|
| 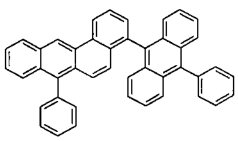 | 19.5 | 3.6 | 3.9 | 3.2 |
| 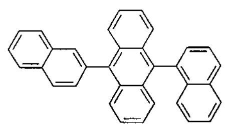 | 18.1 | 6.5 | 4.6 | 6.6 |

(continued)

| Material | $H_d$[$MPa^{0.5}$] | $H_h$[$MPa^{0.5}$] | $H_p$[$MPa^{0.5}$] | Radius[$MPa^{0.5}$] |
|---|---|---|---|---|
| 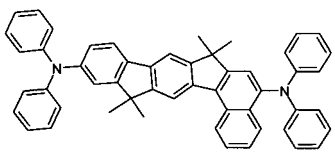 | 18.1 | 6.5 | 4.6 | 6.6 |
| 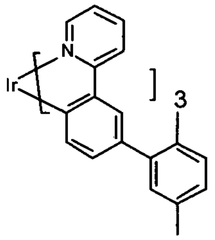 | 19.1 | 3.0 | 5.2 | 2.7 |
| 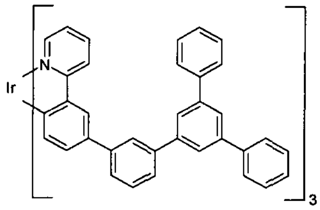 | 17.7 | 4.0 | 7.4 | 8.4 |
| 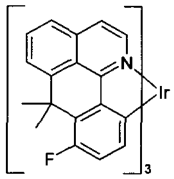 | 17.9 | 7.0 | 6.4 | 3.0 |
| 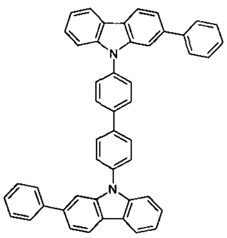 | 18.8 | 4.1 | 2.9 | 4.5 |
| 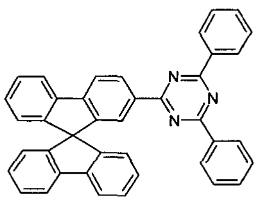 | 18.6 | 3.6 | 5.6 | 5.0 |
| 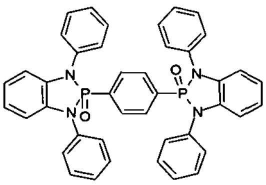 | 18.8 | 4.7 | 5.3 | 5.0 |

(continued)

| Material | $H_d$[$MPa^{0.5}$] | $H_h$[$MPa^{0.5}$] | $H_p$[$MPa^{0.5}$] | Radius[$MPa^{0.5}$] |
|---|---|---|---|---|
| 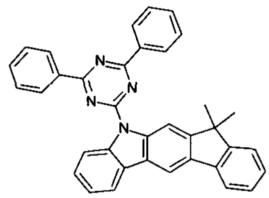 | 17.6 | 3.7 | 4.3 | 5.3 |
| 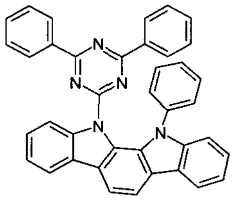 | 17.6 | 3.7 | 4.3 | 5.3 |
| 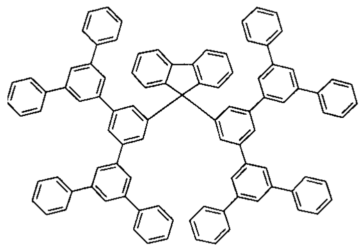 | 18.5 | 3.1 | 5.0 | 5.5 |

According to a preferred embodiment of the present invention, the formulation comprises 0.1 to 10 % by weight, more preferably 0.25 to 5 % and most preferably 0.5 to 4 % by weight of at least one organic light emitting material as an organic semiconducting compound.

Furthermore, the formulation of the present invention comprises at least one polymer. The polymer is useful as an inert binder. Therefore, the polymer does not have semiconducting properties and does not oxidise the at least one organic light emitting material or otherwise chemically react with these materials as mentioned above and below. The inert binder does not provide semiconducting or conducting properties. The low conducting properties of the inert polymeric binder can be determined as low permittivity. Preferred binders according to the present invention are materials of low permittivity, that is, those having a permittivity, at 1,000 Hz of 3.3 or less. The organic binder preferably has a permittivity at 1,000 Hz of less than 3.0, more preferably 2.9 or less. Preferably the organic binder has a permittivity at 1,000 Hz of greater than 1.7. It is preferred that the permittivity of the binder is in the range from 2.0 to 2.9. The terms "oxidise" and "chemically react" as used above and below refer to a possible oxidation or other chemical reaction of the conductive additive with the organic light emitting materials and/or charge transporting materials under the conditions used for manufacture, storage, transport and/or use of the formulation and the OLED device.

Preferably, the inert binder increases the solvent viscosity of at least 0.4 mPas when dissolving 1 % w/w of the inert binder in said organic solvent.

The polymeric binder has a weight average molecular weight of at least 8.000.000 g/mol and preferably at least 10.000.000 g/mol.

The polymers being useful as inert binders preferably have a weight average molecular weight of at most 50.000.000 g/mol and preferably at most 30.000.000 g/mol.

Preferably, the polymeric binder comprises a weight average molecular weight in the range of 8.000.000 to 50.000.000 g/mol and preferably 10.000.000 to 30.000.000 g/mol.

Preferably, the polymer can have a polydispersity index $M_w/M_n$ in the range of 1.0 to 10.0, more preferably in the range of 1.0 to 5.0 and most preferably in the range of 1.0 to 3. Astonishing improvements can be achieved with preferable polymers having a polydispersity index $M_w/M_n$ in the range of 1.0 to 2.0, more preferabyl in the range of 1.0 to 1.5 and moste preferably in the range of 1.0 to 1.2.

According to a preferred aspect of the present invention, the polymeric binder may have a multi modal molecular weight distribution. Preferably, the polymer may have 2, 3, 4 or more maxima in the molecular weight distribution as determinable using GPC.

The binder is selected for example from polystyrene, poly(α-methylstyrene), polyvinylcinnamate, poly(4-vinylbiphenyl) or poly(4-methylstyrene). Polymeric binders preferably comprise repeating units derived from styrene and/or olefins. Preferred polymeric binders can comprise at least 80 %, preferably at least 90 % and more preferably at least 99 % by weight of repeating units derived from styrene monomers and/or olefins.

Useful and preferred polymeric binders comprise Hansen Solubility parameters of $H_d$ in the range of 15.7 to 23.0 $MPa^{0.5}$, Hp in the range of 0.0 to 20.0 $MPa^{0.5}$ and $H_h$ in the range of 0.0 to 12.5 $MPa^{0.5}$. More preferred polymeric binders comprise Hansen Solubility parameters of $H_d$ in the range of 17.0 to 21.0 $MPa^{0.5}$, Hp in the range of 1.0 to 5.0 $MPa^{0.5}$ and $H_h$ in the range of 2.0 to 10.0 $MPa^{0.5}$. Most preferred polymeric binders comprise Hansen Solubility parameters of $H_d$ in the range of 19.0 to 21.0 $MPa^{0.5}$, Hp in the range of 1.0 to 3.0 $MPa^{0.5}$ and $H_h$ in the range of 2.5 to 5.0 $MPa^{0.5}$.

The Hansen Solubility Parameters can be determined according to the Hansen Solubility Parameters in Practice HSPiP 3rd edition, (Software version 3.0.38) with reference to the Hansen Solubility Parameters: A User's Handbook, Second Edition, C. M. Hansen (2007), Taylor and Francis Group, LLC) as supplied by Hanson and Abbot et al.

Examples of useful polymeric binders are disclosed in Table 3.

Table 3: Hansen Solubility Parameters of useful polymeric binders

| **Polymer** | $H_d$[$MPa^{0.5}$] | $H_h$[$MPa^{0.5}$] | Hp [$MPa^{0.5}$] | **Tg** |
|---|---|---|---|---|
| 1,4-Polyisoprene | 16.8 | 2.9 | 5.2 | |
| Polynorbornene | 19.7 | 0 | 0.0* | |
| Poly(styrene-block-butadiene); 31% wt styrene | 17.7 | 2.3 | 5.4 | |
| Poly(styrene-block-butadiene-block-styrene); 30% wt styrene | 17.7 | 2.3 | 5.5 | |
| Poly(styrene-co-maleic anhydride) (and ethylene/butylene) 1-1.7% maleic anhydride | 17.3 | 5.1 | 5.4 | |
| Poly(styrene- block-ethylene/butylene-block-styrene) triblock polymer 13% styrene | 16.4 | 5.2 | 3.5 | |
| Poly(styrene-block-ethylene-propylene-block-styrene) triblock polymer; 37% wt styrene | 17.5 | 4.6 | 5.2 | |
| Poly(styrene-block-ethylene/butylene-block-styrene) | 17 | 4.5 | 3.5 | |
| triblock polymer; 29% wt styrene | | | | |
| Poly(1-vinylnaphthalene) | 22.8 | 19.7 | 8.3 | 162 |
| Poly(1-vinylpyrrolidone-co-styrene) 64% styrene | 19.7 | 4.4 | 5.6 | |
| Poly(1-vinylpyrrolidone-co-vinyl acetate) 1.3:1 | 18.8 | 9.2 | 10.4 | 64 |
| Poly(2-chlorostyrene) | 19.8 | 15.8 | 2.1 | 103 |
| Poly(2-vinylnaphthalene) | 22.8 | 19.7 | 8.3 | 135 |
| Poly(2-vinylpyridine-co-styrene) 1:1 | 19.5 | 0.9 | 5.9 | 96 |
| Poly(4,5-Difluoro-2,2-bis(CF3)-1,3-dioxole-co-tetrafluoroethylene) Teflon | 16.2 | 5.8 | 3.7 | 160 |
| Poly(4-chlorostyrene) | 19.8 | 7.1 | 3 | 106 |
| Poly(4-methyl-1-pentene) | 16.3 | 7.7 | 4.9 | |
| Poly(4-methylstyrene) | 19.3 | 3.1 | 3.6 | 106 |
| Poly(4-vinylpyridine-co-styrene) 1:1 | 19.5 | 0.9 | 5.9 | |
| Poly(alpha-methylstyrene) | 18.5 | 7.2 | 3.8 | |
| Poly(butadiene-graft-poly(methyl acrylate-co-acrylonitrile)) 1:1: 1 | 17.2 | 5.4 | 8 | |
| Poly(butyl methacrylate-co-isobutyl methacrylate) 1:1 | 16.8 | 3.6 | 9.7 | 35 |
| Poly(butyl methacrylate-co-methyl methacrylate) 1:1 | 16.5 | 7 | 10.3 | 52 |
| Poly(cyclohexyl methacrylate) | 17.1 | 4.5 | 7.9 | |
| Poly(ethylene-co-1-butene-co-1-hexene) 1:1:1 | 16.2 | 6 | 3.6 | 95 |

(continued)

| Polymer | $H_d$[MPa$^{0.5}$] | $H_h$[MPa$^{0.5}$] | Hp [MPa$^{0.5}$] | Tg |
|---|---|---|---|---|
| Poly(ethylene-co-ethylacrylate-co-maleic anhydride) 2% anhydride, 32% ethyl acrylate | 16.4 | 8.7 | 6.7 | 65 |
| Poly(ethylene-co-glycidyl methacrylate); 8% glycidyl methacrylate | 16.2 | 7.3 | 6.1 | 87 |
| Poly(ethylene-co-methyl acrylate-co-glycidylmethacrylate) 8% glycidyl methacrylate; 25% methyl acrylate | 16.5 | 7.7 | 7.2 | |
| Poly(ethylene-co-octene) 1:1 | 16.4 | 5.8 | 3.9 | |
| Poly(ethylene-co-propylene-co-5-methylene-2-norbornene) 50% ethylene | 18.1 | 4.4 | 6.7 | |
| Poly(ethylene-co-tetrafluoroethylene) 1:1 | 16.9 | 3.9 | 3.3 | |
| Poly(isobutyl methacrylate) | 16.9 | 2.8 | 11.2 | |
| Poly(isobutylene) | 15.8 | 3.7 | 1.3 | |
| Poly(methyl methacrylate)-co-(fluorescein O-methacrylate); 80% methyl methacrylate | 17.2 | 10.5 | 11.3 | 148 |
| Poly(methyl methacrylate-co-butyl methacrylate); 85% methyl methacrylate | 16.3 | 8.9 | 11.8 | 105 |
| Poly(methyl methacrylate-co-ethyl acrylate); 5% ethyl acrylate | 16.2 | 9.7 | 12.2 | |
| Poly(propylene-co-butene) 12% 1-butene | 16.4 | 4.5 | 6 | 138 |
| Poly(styrene-co-allyl alcohol) 40% allyl alcohol | 18.9 | 1.2 | 12.1 | 63 |
| Poly(styrene-co-maleic anhydride) 7% maleic anhydride | 19.8 | 3 | 3.8 | 120 |
| Poly(styrene-co-maleic anhydride) cumene terminated (1.3:1) | 20 | 9.5 | 5.6 | 154 |
| Poly(styrene-co-methyl methacrylate) 40% styrene | 17.6 | 6.5 | 8.8 | 101 |
| Poly(vinyltoluene-co-alpha-methylstyrene) 1:1 | 18.9 | 5.2 | 3.7 | 52 |
| Poly-2-vinylpyridine | 19.3 | 0 | 8.2 | |
| Poly-4-vinylpyridine | 19.3 | 0 | 8.2 | 137 |
| Poly-alpha-pinene | 17 | 1.5 | 4.5 | 25 |
| Polybenzylmethacrylate | 18.2 | 5.7 | 8.4 | 54 |
| Polyethyl methacrylate | 16 | 7.7 | 10.3 | |
| Polyethylene | 16.1 | 7.7 | 5.7 | |
| Polyethylene terephthalate | 19.3 | 1.2 | 0.0 | 115 |
| Polyethylene-co-ethylacrylate 18% ethyl acrylate | 16.2 | 8.1 | 6.2 | 116 |
| Polyethylene-co-vinylacetate 12% vinyl acetate | 16.3 | 7.9 | 6.4 | 61 |
| Polyethylene-graft-maleic anhydride 0.5% maleic anhydride | 16.1 | 7.8 | 5.7 | |
| Polymethyl methacrylate | 16.2 | 4.6 | 9.3 | |
| Polypropylene | 16.4 | 4.8 | 6.6 | 105 |
| Polypropylene-graft-maleic anhydride 8-10% maleic anhydride | 16.8 | 6.2 | 6.8 | 157 |
| Polystyrene | 19.7 | 1.7 | 3.5 | |
| Poly(styrene-block-ethylene/butylene-block- styrene) graft maleic anhydride 2% maleic anhydride; 1:1:1 others | 17.6 | 4.3 | 5.2 | |
| Poly(styrene-block-butadiene) branched; 1:1 | 18.3 | 2.1 | 4.9 | |

(continued)

| Polymer | $H_d$[MPa$^{0.5}$] | $H_h$[MPa$^{0.5}$] | Hp [MPa$^{0.5}$] | Tg |
|---|---|---|---|---|
| Poly(styrene-block-butadiene-block-styrene) 30% styrene | 17.7 | 2.3 | 5.5 | |
| Poly(styrene-block-isoprene) 10% wt styrene | 17.1 | 2.8 | 5 | |
| Poly(styrene-block-isoprene-block-styrene) 17% wt styrene | 17.3 | 2.7 | 4.9 | |
| Poly(styrene-co-4-chloromethylstyrene-co-4-methoxymethylstyrene 2:1:1 | 19.6 | 5.5 | 4.5 | |
| Polystyrene-co-acrylonitrile 25% acrylonitrile | 19.2 | 2.5 | 4.5 | |
| Polystyrene-co-alpha-methylstyrene 1:1 | 19.1 | 4.5 | 3.7 | 67 |
| Polystyrene-co-butadiene 4% butadiene | 19.6 | 1.7 | 3.6 | 103 |
| Polystyrene-co-butadiene 45% styrene | 18.1 | 2.1 | | |
| Polystyrene-co-chloromethylstyrene 1:1 | 19.9 | 8.6 | 3.2 | |
| Polyvinylchloride | 18.2 | 15.1 | 4.7 | 82 |
| Polyvinylcinnamate | 19.9 | 3.3 | 7.8 | |
| Polyvinylcyclohexane | 17.6 | 3.1 | 1.9 | 123 |
| Polyvinylidenefluoride | 17.3 | 1.9 | 2.8 | |
| Polyvinylidenefluoride-co-hexafluoropropylene assume 1:1 | 16.4 | 2 | 1.7 | |
| Poly(styrene-block-ethylene/propylene-block-styrene) 30% styrene | 17.4 | 2.8 | 4.2 | |
| Poly(styrene- block-ethylene/propylene-block-styrene) 18% styrene | 17 | 3 | 4.3 | |
| Poly(styrene- block-ethylene/propylene-block-styrene) 13% styrene | 16.8 | 3.1 | 4.4 | |
| Poly(styrene- block ethylene block-ethylene/propylene-block styrene); 32% styrene | 17.5 | 3 | 3.5 | |
| Poly(styrene- block ethylene block-ethylene/propylene-block styrene); 30% styrene | 17.4 | 3 | 3.5 | |
| Poly(styrene-block-ethylene/butylene-block-styrene); 31% styrene | 17.5 | 3.1 | 2.9 | |
| Poly(styrene-block-ethylene/butylene-block-styrene); 34% styrene | 17.6 | 3.1 | 2.9 | |
| Poly(styrene-block-ethylene/butylene-block-styrene); 30% styrene | 17.5 | 3.2 | 2.9 | |
| Poly(styrene- block-ethylene/butylene-block-styrene); 60% styrene | 18.4 | 2.5 | 3.1 | |
| $H_d$ refers to Dispersion contribution<br>Hp refers to Polar contribution<br>$H_h$ refers to Hydrogen bonding contribution | | | | |

According to a preferred embodiment of the present invention, the inert binder is a polymer having a glass transition temperature in the range of -70 to 160°C, preferably 0 to 150°C, more preferably 50 to 140°C and most preferably 70 to 130°C. The glass transition temperature can be determined by measuring the DSC of the polymer (DIN EN ISO 11357, heating rate 10°C per minute).

Usually, the polymeric binder is dispersible or soluble in the solvent of the present formulation as described above and below. Preferably, the polymeric binder is soluble in the organic solvent and the solubility of the polymeric binder in the solvent is at least 1 g/l, more preferably at least 5 g/l and most preferably at least 10 g/l.

According to a preferred embodiment of the present invention, the formulation of the present invention comprises 0.05 to 10 % by weight, preferably 0.1 to 5 % and more preferably 0.15 to 3 % by weight polymeric binder. Astonishing improvements can be achieved by using formulations preferably comprising 0.2 to 1 %, more preferably 0.25 to 0.6 % and most preferably 0.3 to 0.5 % by weight polymeric binder.

Astonishing improvements can be achieved by using a high molecular weight binder at a low content in the formulation. Using such approach surprisingly efficient devices having an excellent printing quality are obtainable.

The weight ratio of the semiconducting compound to the inert binder is preferably in the range of 30:1 to 1:30, more preferably in the range of 15:1 to 1:2 and more preferably in the range of 8:1 to 3:1.

Styrene monomers are well known in the art. These monomers include styrene, substituted styrenes with an alkyl substituent in the side chain, such as α-methylstyrene and α-ethylstyrene, substituted styrenes with an alkyl substituent on the ring such as vinyltoluene and p-methylstyrene, halogenated styrenes such as monochlorostyrenes, dichlorostyrenes, tribromostyrenes and tetrabromostyrenes.

Olefins are monomers consisting of hydrogen and carbon atoms. These monomers include ethylene, propylene, butylenes, isoprene and 1,3-butadiene.

According to a preferred aspect of the present invention, the polymeric binder is polystyrene having a weight average molecular weight of at least 8.000.000, and preferably at least 10.000.000 g/mol.

The polystyrene being useful as inert binders preferably have a weight average molecular weight of at most 50.000.000 g/mol and preferably at most 30.000.000 g/mol.

The formulation according to the present invention may additionally comprise one or more further components like for example surface-active compounds, lubricating agents, conductive additives, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors. However, these further components should not be oxidising or otherwise capable of chemically reacting with the OSC or have an electrically doping effect on the OSC.

Surprising improvements can be achieved with volatile wetting agents. The term "volatile" as used above and below means that the agent can be removed from the organic semiconducting materials by evaporation, after these materials have been deposited onto a substrate of an OE device, under conditions (like temperature and/or reduced pressure) that do not significantly damage these materials or the OE device. Preferably this means that the wetting agent has a boiling point or sublimation temperature of < 350°C, more preferably ≤ 300°C, most preferably ≤ 250°C, at the pressure employed, very preferably at atmospheric pressure (1013 hPa). Evaporation can also be accelerated e.g. by applying heat and/or reduced pressure. Preferably, the wetting agents are not capable of chemically reacting with the OSC compounds. In particular they are selected from compounds that do not have a permanent doping effect on the OSC material (e.g. by oxidising or otherwise chemically reacting with the OSC material). Therefore, the formulation preferably should not contain additives, like e.g. oxidants or protonic or lewis acids, which react with the OSC materials by forming ionic products.

Surprising effects can be accomplished by formulations comprising volatile components having similar boiling points. Preferably, the difference of the boiling point of the wetting agent and the organic solvent is in the range of -50°C to 50°C, more preferably in the range of -30°C to 30°C and most preferably in the range of -20°C to 20°C.

Preferred wetting agents are non-aromatic compounds. With further preference the wetting agents are non-ionic compounds. Particular useful wetting agents comprise a surface tension of at most 35 mN/m, more preferably of at most 30 mN/m and most preferably of at most 25 mN/m. The surface tension can be measured using a FTA (First Ten Angstrom) 1000 contact angle goniometer at 25°C. Details of the method are available from First Ten Angstrom as published by Roger P. Woodward, Ph.D. "Surface Tension Measurements Using the Drop Shape Method". Preferably, the pendant drop method can be used to determine the surface tension.

According to a preferred aspect of the present invention, the difference of the surface tension of the organic solvent and the wetting agent is preferably at least 1 mN/m, more preferably at least 5 mN/m and most preferably at least 10 mN/m.

Unexpected improvements can be achieved by wetting agents comprising a molecular weight of at least 100 g/mol, preferably at least 150 g/mol, more preferably at least 180 g/mol and most preferably at least 200 g/mol.

Suitable and preferred wetting agents that do not oxidise or otherwise chemically react with the OSC materials are selected from the group consisting of siloxanes, alkanes, amines, alkenes, alkynes, alcohols and/or halogenated derivates of these compounds. Furthermore, fluoro ethers, fluoro esters and/or fluoro ketones can be used. More preferably, these compounds are selected from methyl siloxanes having 6 to 20 carbon atoms, preferably 8 to 16 carbon atoms; $C_7$-$C_{14}$ alkanes, $C_7$-$C_{14}$ alkenes, $C_7$-$C_{14}$ alkynes, alcohols having 7 to 14 carbon atoms, fluoro ethers having 7 to 14 carbon atoms, fluoro esters having 7 to 14 carbon atoms and fluoro ketones having 7 to 14 carbon atoms. Most preferred wetting agents are methyl siloxanes having 8 to 14 carbon atoms.

Useful and preferred alkanes having 7 to 14 carbon atoms include heptane, octane, nonane, decane, undecane, dodecane, tridecane, tetradecane, 3-methyl heptane, 4-ethyl heptane, 5-propyl decane, trimethyl cyclohexane, and

decalin.

Halogenated alkanes having 7 to 14 carbon atoms include 1-chloro heptane, 1,2-dichloro octane, tetrafluoro octane, decafluoro dodecane, perfluoro nonane, 1,1,1-trifluoromethyl decane, and perfluoro methyl decalin.

Useful and preferred alkenes having 7 to 14 carbon atoms include heptene, octene, nonene, 1-decene, 4-decene, undecene, dodecene, tridecene, tetradecene, 3-methyl heptene, 4-ethyl heptene, 5-propyl decene, and trimethyl cyclohexene.

Halogenated alkenes having 7 to 14 carbon atoms include 1,2-dichloro octene, tetrafluoro octene, decafluoro dodecene, perfluoro nonene, and 1,1,1-trifluoromethyl decene.

Useful and preferred alkynes having 7 to 14 carbon atoms include octyne, nonyne, 1-decyne, 4-decyne, dodecyne, tetradecyne, 3-methyl heptyne, 4-ethyl heptyne, 5-propyl decyne, and trimethyl cyclohexyne.

Halogenated alkynes having 7 to 14 carbon atoms include 1,2-dichloro octyne, tetrafluoro octyne, decafluoro dodecyne, perfluoro nonyne, and 1,1,1-trifluoromethyl decyne.

Useful and preferred alcanols having 7 to 14 carbon atoms include, heptanol, octanol, nonanol, decanol, undecanol, dodecanol, tridecanol, tetradecanol, 3-methyl heptanol, 3,5-dimethyl-1-hexyn-3-ol, 4-ethyl heptanol, 5-propyl decanol, trimethyl cyclohexanol, and hydroxyl decalin.

Halogenated alkanols having 7 to 14 carbon atoms include 1-chloro heptanol, 1,2-dichloro octanol, tetrafluoro octanol, decafluoro dodecanol, perfluoro nonanol, 1,1,1-trifluoromethyl decanol, and 2-trifluoro methyl-1-hydroxy decalin.

Useful and preferred fluoro ethers having 7 to 14 carbon atoms include 3-ethoxy-1,1,1,2,3,4,4,5,5,6,6,6 dodecafluoro-2-trifluoromethyl-hexane, 3-propoxy-1,1,1,2,3,4,4,5,5,6,6,6 dodecafluoro-2-trifluoromethyl-hexane, and 3-propoxy-1,1,1,2,3,4,4,5,5,5 decafluoro-2-trifluoromethyl-pentane.

Useful and preferred fluoro esters having 7 to 14 carbon atoms include 3-(1,1,1,2,3,4,4,5,5,6,6,6 dodecafluoro-2-trifluoromethyl-hexyl) ethanoate, and 3-(1,1,1,2,3,4,4,5,5,5 decafluoro-2-trifluoromethyl-pentyl) propanoate.

Useful and preferred fluoro ketones having 7 to 14 carbon atoms include 3-(1,1,1,2,3,4,4,5,5,6,6,6 dodecafluoro-2-trifluoromethyl-hexyl) ethyl ketone, and 3-(1,1,1,2,3,4,4,5,5,5 decafluoro-2-trifluoromethyl-pentyl) propyl ketone.

Useful and preferred siloxanes include hexamethyl disiloxane, octamethyl trisiloxane, decamethyl tetrasiloxane, dodecamethyl pentasiloxane, and tetradecamethyl hexasiloxane.

Preferably, the formulation comprises at most 5 % by weight, more preferably at most 3 % by weight, and most preferably at most 1 % by weight of wetting additives. Preferably, the formulation comprises 0.01 to 5 % by weight, more preferably 0.1 to 3 % by weight, and most preferably 0.1 to 1 % by weight of wetting agent.

The formulation according to the present invention can be designed as an emulsion, dispersion or solution. Preferably, the present formulation is a solution (homogeneous mixture) comprising no considerable amounts of a second phase.

The formulation according to the present invention can be used for the preparation of organic electronic (OE) devices, for example organic light emitting diodes (OLED).

During the process of preparing an OE device, the OSC layer is deposited onto a substrate, followed by removal of the solvent together with any volatile additive(s) present, to form a film or layer.

Various substrates may be used for the fabrication of OE devices, for example glass, ITO coated glass, ITO glass with pre coated layers including PEDOT, PANI etc, or plastics, plastics materials being preferred, examples including alkyd resins, allyl esters, benzocyclobutenes, butadiene-styrene, cellulose, cellulose acetate, epoxide, epoxy polymers, ethylene-chlorotrifluoro ethylene, ethylene-tetra-fluoroethylene, fibre glass enhanced plastic, fluorocarbon polymers, hexafluoropropylenevinylidene-fluoride copolymer, high density polyethylene, parylene, polyamide, polyimide, polyaramid, polydimethylsiloxane, polyethersulphone, polyethylene, polyethylenenaphthalate, polyethyleneterephthalate, polyketone, polymethylmethacrylate, polypropylene, polystyrene, polysulphone, polytetrafluoroethylene, polyurethanes, polyvinylchloride, silicone rubbers, silicones, and flexible films with ITO, or other conducting layers and barrier layers e.g. Vitex film.

Preferred substrate materials are polyethyleneterephthalate, polyimide, and polyethylenenaphthalate. The substrate may be any plastic material, metal or glass coated with the above materials. The substrate should preferably be homogeneous to ensure good pattern definition. The substrate may also be uniformly pre-aligned by extruding, stretching, rubbing or by photochemical techniques to induce the orientation of the organic semiconductor in order to enhance carrier mobility.

The electrodes can be deposited by liquid coating, such as spray-, dip-, web- or spin-coating, or by vacuum deposition or vapor deposition methods. Suitable electrode materials and deposition methods are known to the person skilled in the art. Suitable electrode materials include, without limitation, inorganic or organic materials, or composites of the two. Examples for suitable conductor or electrode materials include polyaniline, polypyrrole, PEDOT or doped conjugated polymers, further dispersions or pastes of graphite or particles of metal such as Au, Ag, Cu, Al, Ni or their mixtures as well as sputter coated or evaporated metals such as Cu, Cr, Pt/Pd or metal oxides such as indium tin oxide (ITO). Organometallic precursors may also be used deposited from a liquid phase.

Preferably, the substrate on surface on which the formulation according to the present invention is applied

comprises a surface energy in the range of 130 to 25 mN $m^{-1}$, more preferably in the range of 115 to 30 mN $m^{-1}$, determined by measuring the contact angle of at least 2 solvents, e.g. water and methylene iodide, but other solvents can be used. These are typically measured using a contact angle goniometer such as a FTA 1000, at a temperature of 20 to 25°C (room temperature and at normal atmospheric pressure) the contact angle of the 2 solvents are then combined using a variety of mathematical models, typically Owens-Wendt geometric mean or Wu's harmonic mean. Preferably, the Owens-Wendt method is used.

Owens-Wendt formula

$$(1 + \cos\theta)\,\gamma LV = 2\sqrt{(\gamma^D SV\, \gamma^D LV)} + 2\sqrt{(\gamma^P SV\, \gamma^P LV)}$$

Wu's Harmonic mean formula

$$(1 + \cos\theta)\,\gamma LV = 4\{\gamma D\, SV\gamma D\, LV / (\gamma^D SV+\gamma^D LV) + \gamma^P SV\gamma^P LV / (\gamma^P SV+ \gamma^P LV)\}$$

Deposition of the OSC layer can be achieved by standard methods that are known to the skilled person and are described in the literature. Suitable and preferred deposition methods include liquid coating and printing techniques. Preferred deposition methods include, without limitation, dip coating, spin coating, spray coating, aerosol jetting, ink jet printing, nozzle printing, gravure printing, doctor blade coating, roller printing, reverse-roller printing, flexographic printing, web printing, screen printing, stencil printing, spray coating, dip coating, curtain coating, kiss coating, meyer bar coating, 2 roll nip fed coating, anilox coaters, knife coating or slot dye coating. Preferably, the OSC layer is applied with gravure printing, doctor blade coating, roller printing, reverse-roller printing, flexographic printing, web printing, anilox coaters. Gravure and flexographic printing and variants of these printing methods are preferred. These include but or not limited to, micro gravure, reverse gravure, offset gravure, reverse roll etc. Both web fed (roll to roll) and sheetfed in both flatbed and the more conventional 'on the round' configurations can be used.

For flexo printing the anilox can be either chromed steel or ceramic, preferably ceramic. The cell etch can vary between 2 $cm^3/m^2$ to 120 $cm^3/m^2$, preferably between 3 $cm^3/m^2$ to 20 $cm^3/m^2$ and more preferably between 4 $cm^3/m^2$ to 18 $cm^3/m^2$, however the dried film thickness will vary on the concentration of the active material and the transfer characteristics of said formulation.

The cell configuration, i.e. shape, depth, cell wall linking can be adapted by a person skilled in the art to achieve an optimal printing result.

For gravure printing the chromed steel is preferably used but this does not exclude other materials. The engraving requirements are approximately 50% of those for the flexographic printing because there is one less transfer process involved.

The speed can vary significantly depending on the press type and configuration, for flatbed printing the print speed is typically very slow, typically 100 mm/minute or less. On roll to roll presses the speed can exceed 500 m/minute.

According to a preferred aspect, an insulator layer can be deposited on a substrate in order to achieve a special type of an OE according to the present invention. Preferably, the insulator layer is deposited by solution processing, very preferably using a solution of a dielectric material, which is optionally cross-linkable, in one or more organic solvents. Preferably the solvent used for depositing the dielectric material is orthogonal to the solvent used for depositing the OSC material, and vice versa.

When spin coating is used as deposition method, the OSC or dielectric material is spun for example between 1000 and 2000 rpm for a period of for example 30 seconds to give a layer with a typical layer thickness between 0.5 and 1.5 $\mu$m. After spin coating the film can be heated at an elevated temperature to remove all residual volatile solvents.

If a cross-linkable dielectric is used, it is preferably cross-linked after deposition by exposure to electron beam or electromagnetic (actinic) radiation, like for example X-ray, UV or visible radiation. For example, actinic radiation can be used having a wavelength of from 50 nm to 700 nm, preferably from 200 to 450 nm, and more preferably from 300 to 400 nm. Suitable radiation dosages are typically in the range from 25 to 3,000 mJ/$cm^2$. Suitable radiation sources include mercury, mercury/xenon, mercury/halogen and xenon lamps, argon or xenon laser sources, x-ray, or e-beam. The exposure to actinic radiation will induce a cross-linking reaction in the cross-linkable groups of the dielectric material in the exposed regions. It is also possible for example to use a light source having a wavelength outside the absorption band of the cross-linkable groups, and to add a radiation sensitive photosensitizer to the cross-linkable material.

Optionally the dielectric material layer is annealed after exposure to radiation, for example at a temperature from 70°C to 130°C, for example for a period of from 1 to 30 minutes, preferably from 1 to 10 minutes. The annealing step at elevated temperature can be used to complete the cross-linking reaction that was induced by the exposure of the cross-linkable groups of the dielectric material to photoradiation.

Removal of the solvent and any volatile additive(s) is preferably achieved by evaporation, for example by exposing the deposited layer to high temperature and/or reduced pressure, preferably at -50°C to 300°C, more preferably 20°C to 250°C. According to a preferred aspect of the present invention, the solvent(s) and any volatile additive can be evaporated under reduced pressure. Preferably either atmospheric pressure or reduced pressure, the pressure for solvent evaporation ranges from $10^{-3}$ mbar to 1 bar, preferably from $10^{-2}$ mbar to 100 mbar and more preferably from 0.1 mbar to 10 mbar. Moreover, the evaporation of the solvent can be preferably achieved below the boiling point of the solvent.

The thickness of the dried OSC layer is preferably from 1 nm to 50 μm, more preferably from 2 to 1000 nm and most preferably 3 to 500 nm. Preferred layers comprising organic light emitting materials and/or charge transporting materials can have a thickness in the range of 2 to 150 nm.

Further to the materials and methods as described above and below, the OE device and its components can be prepared from standard materials and standard methods, which are known to the person skilled in the art and described in the literature.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

The term "polymer" includes homopolymers and copolymers, e.g. statistical, alternating or block copolymers. In addition, the term "polymer" as used hereinafter does also include oligomers and dendrimers.

Dendrimers are typically branched macromolecular compounds consisting of a multifunctional core group onto which further branched monomers are added in a regular way giving a tree-like structure, as described e.g. in M. Fischer and F. Vögtle, Angew. Chem., Int. Ed. 1999, 38, 885.

The term "conjugated polymer" means a polymer containing in its backbone (or main chain) mainly C atoms with $sp^2$-hybridisation, or optionally sp-hybridisation, which may also be replaced by hetero atoms, enabling interaction of one π-orbital with another across an intervening σ-bond. In the simplest case this is for example a backbone with alternating carbon-carbon (or carbon-hetero atom) single and multiple (e.g. double or triple) bonds, but does also include polymers with units like 1,3-phenylene. "Mainly" means in this connection that a polymer with naturally (spontaneously) occurring defects, which may lead to interruption of the conjugation, is still regarded as a conjugated polymer. Also included in this meaning are polymers wherein the backbone comprises for example units like aryl amines, aryl phosphines and/or certain heterocycles (i.e. conjugation via N-, O-, P- or S-atoms) and/or metal organic complexes (i.e. conjugation via a metal atom). The term "conjugated linking group" means a group connecting two rings (usually aromatic rings) consisting of C atoms or hetero atoms with $sp^2$-hybridisation or sp-hybridisation. See also "IUPAC Compendium of Chemical terminology, Electronic version".

Unless stated otherwise, the molecular weight is given as the number average molecular weight $M_n$ or as weight average molecular weight $M_w$, which unless stated otherwise are determined by gel permeation chromatography (GPC) against polystyrene standards.

The degree of polymerization (n) means the number average degree of polymerization, unless stated otherwise given as $n = M_n/M_U$, wherein Mu is the molecular weight of the single repeating unit.

The term "small molecule" means a monomeric, i.e. a non-polymeric compound.

Unless stated otherwise, percentages of solids are per cent by weight ("wt. %"), percentages or ratios of liquids (like e.g. in solvent mixtures) are per cent by volume ("vol. %"), and all temperatures are given in degrees Celsius (°C).

Unless stated otherwise, concentrations or proportions of mixture components, given in percentages or ppm are related to the entire formulation including the solvents.

All process steps described above and below can be carried out using known techniques and standard equipment which are described in prior art and are well-known to the skilled person.

The invention will now be described in more detail by reference to the following examples, which are illustrative

only and do not limit the scope of the present invention.

Examples

**Example 1**

Teonex Q65FA film (available from DuPont Teijin Films) was washed in an ultrasonic methanol bath for 2 minutes and then rinsed with methanol.

The OLED formulation was prepared by dissolving of a phosphorescent compound according to formula C-1 at a level of 0.5 % by weight,

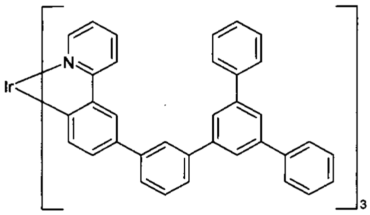

(C-1)

a host material according to formula C-2 at a level of 1.0 % by weight,

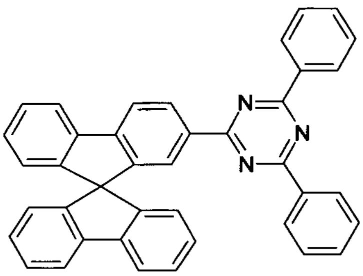

(C-2)

a host material according to formula C-3 at a level of 1.0% by weight,

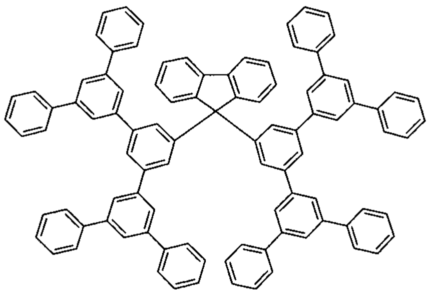

(C-3)

and 0.25 % by weight of a polystyrene having a molecular weight Mw of 15 000 000 g/mol in a 3:1 blend of anisole : mesitylene.

Viscosity measured as 29 cp (Viscosity measured using a TA, AR-G2 rheometer, using 40 mm parallel plate geometry).

The OSC formulation was then printed as an array of lines:

50 μ with gaps of 100 μ, 200 μ and 400 μ,
100 μ lines with gaps of 200 μ and
200 μ lines with gaps of 200 μ and 400 μ.

The formulation was printed using a Nissha angstromer flexographic printer and then dried at 100°C for 20 minutes. The printed result was imaged using a Nikon EV400 microscope using a UV light source to view under photoluminescence. The printing quality was high. No significant problems were seen.

## Claims

1. Formulation comprising at least one organic semiconducting compound (OSC), at least one organic solvent, and at least one polymeric binder, wherein said at least one organic semiconducting compound is an organic light emitting material, wherein said at least one organic solvent comprises at least one aromatic and/or heteroaromatic compound and wherein said at least one polymeric binder is an inert binder, **characterized in that** said organic semiconducting compound has a molecular weight of at most 5000 g/mol, said polymeric binder has a weight average molecular weight of at least 8.000.000 g/mol, determined by gel permeation chromatography against polystyrene standard, and said composition comprises a viscosity at 25°C of at least 15 mPas.

2. Formulation according to claim 1, **characterized in that** said polymeric binder is a polymer comprising repeating units derived from styrene monomers and/or olefins, preferably comprising at least 80 % by weight of repeating units derived from styrene monomers and/or olefins and more preferably comprising at least 85 % by weight of repeating units derived from styrene monomers.

3. Formulation according to claim 1 or 2, **characterized in that** said formulation comprises in the range of 0.1 to 10 % by weight of said at least polymeric binder.

4. Formulation according to one or more of claims 1 to 3, **characterized in that** said organic solvent comprises at least one aromatic hydrocarbon compounds.

5. Formulation according to one or more of claims 1 to 4, **characterized in that** said organic solvent comprises at least 80 % by weight of compounds having a viscosity at 25°C of less than 15 mPas.

6. Formulation according to one or more of claims 1 to 5, **characterized in that** said formulation comprises at least 80 % by weight of said at least one organic solvent.

7. Formulation according to one or more of claims 1 to 6, **characterized in that** said at least one organic light emitting material having a molecular weight of at most 5000 g/mol is an organic phosphorescent compound which emits light and in addition contains at least one atom having an atomic number greater than 38.

8. Formulation according to claim 7, **characterized in that** said at least one phosphorescent compound is a compound selected of formulae (1) to (4):

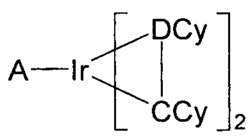

formula (1)

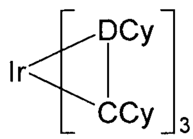

formula (2)

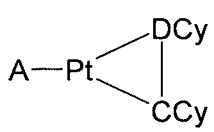

formula (3)

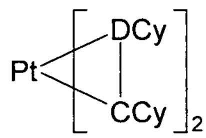

formula (4)

wherein

DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents $R^{18}$; the groups DCy and CCy are connected to one another via a covalent bond;
CCy is, identically or differently on each occurrence, a cyclic group which contains a carbon atom via which the cyclic group is bonded to the metal and which may in turn carry one or more substituents $R^{18}$;

A is, identically or differently on each occurrence, a monoanionic, bidentate chelating ligand, preferably a diketonate ligand;
$R^{18}$ are identically or differently at each instance, and are F, Cl, Br, I, $NO_2$, CN, a straight-chain, branched or cyclic alkyl or alkoxy group having from 1 to 20 carbon atoms, in which one or more nonadjacent $CH_2$ groups may be replaced by -O-, -S-, -$NR^{19}$-, -$CONR^{19}$-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals, and a plurality of substituents $R^{18}$, either on the same ring or on two different rings, may together in turn form a mono- or polycyclic, aliphatic or aromatic ring system; and
$R^{19}$ are identically or differently at each instance, and are a straight-chain, branched or cyclic alkyl or alkoxy group having from 1 to 20 carbon atoms, in which one or more nonadjacent $CH_2$ groups may be replaced by -O-, -S-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals.

**9.** Formulation according to one or more of claims 1 to 8, **characterized in that** said formulation comprises 0.1 to 10 % by weight of at least one organic semiconducting compound having a molecular weight of at most 5000 g/mol.

**10.** Formulation according to one or more of claims 1 to 9, **characterized in that** said formulation comprises at least one wetting agent.

**11.** Use of a formulation according to one or more of claims 1 to 10 as coating or printing ink for the preparation of OE devices.

**12.** Process of preparing an organic electronic (OE) device, comprising the steps of

a) depositing the formulation according to one or more of claims 1 to 10 onto a substrate to form a film or layer, and
b) removing the at least one solvent.

**13.** Organic electronic device prepared from a formulation according to one or more of claims 1 to 10 or by a process according to claim 12.

**Patentansprüche**

**1.** Formulierung enthaltend mindestens eine organische Halbleiterverbindung (organic semiconducting compound - OSC), mindestens ein organisches Lösungsmittel und mindestens ein polymeres Bindemittel, wobei es sich bei der mindestens einen organischen Halbleiterverbindung um ein organisches lichtemittierendes Material handelt, wobei das mindestens eine organische Lösungsmittel mindestens eine aromatische und/oder heteroaromatische Verbindung enthält und wobei es sich bei dem mindestens einen polymeren Bindemittel um ein inertes Bindemittel handelt, **dadurch gekennzeichnet, dass** die organische Halbleiterverbindung ein Molekulargewicht von höchstens 5000 g/mol aufweist, das polymere Bindemittel ein gewichtsmittleres Molekulargewicht von mindestens 8.000.000 g/mol, bestimmt durch Gelpermeationschromatographie gegen Polystyrolstandards, aufweist, und die Zusammensetzung eine Viskosität bei 25°C von mindestens 15 mPas umfasst.

**2.** Formulierung nach Anspruch 1, **dadurch gekennzeichnet, dass** es sich bei dem polymeren Bindemittel um ein Polymer handelt, das Wiederholungseinheiten enthält, die sich von Styrolmonomeren und/oder Olefinen ableiten, vorzugsweise mindestens 80 Gew.-% an Wiederholungseinheiten enthält, die sich von Styrolmonomeren und/oder Olefinen ableiten, und besonders bevorzugt mindestens 85 Gew.-% an Wiederholungseinheiten enthält, die sich von Styrolmonomeren ableiten.

**3.** Formulierung nach Anspruch 1 oder 2, **dadurch gekennzeichnet, dass** die Formulierung im Bereich von 0,1 bis 10 Gew.-% des mindestens polymeren Bindemittels enthält.

**4.** Formulierung nach einem oder mehreren der Ansprüche 1 bis 3, **dadurch gekennzeichnet, dass** das organische Lösungsmittel mindestens eine aromatische Kohlenwasserstoffverbindungen enthält.

**5.** Formulierung nach einem oder mehreren der Ansprüche 1 bis 4, **dadurch gekennzeichnet, dass** das organische

Lösungsmittel mindestens 80 Gew.-% an Verbindungen mit einer Viskosität bei 25°C von weniger als 15 mPas enthält.

**6.** Formulierung nach einem oder mehreren der Ansprüche 1 bis 5, **dadurch gekennzeichnet, dass** die Formulierung mindestens 80 Gew.-% des mindestens einen organischen Lösungsmittels enthält.

**7.** Formulierung nach einem oder mehreren der Ansprüche 1 bis 6, **dadurch gekennzeichnet, dass** es sich bei dem mindestens einen organischen lichtemittierenden Material mit einem Molekulargewicht von höchstens 5000 g/mol um eine organische phosphoreszierende Verbindung handelt, die Licht emittiert und zusätzlich mindestens ein Atom mit einer Ordnungszahl größer als 38 enthält.

**8.** Formulierung nach Anspruch 7, **dadurch gekennzeichnet, dass** es sich bei der mindestens einen phosphoreszierenden Verbindung um eine Verbindung handelt, die aus den Formeln (1) bis (4) ausgewählt ist:

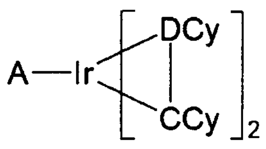

Formel (1)

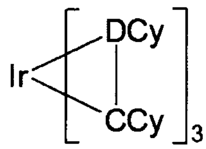

Formel (2)

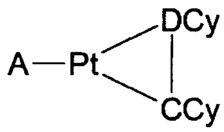

Formel (3)

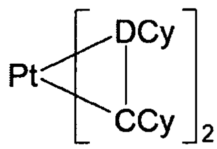

Formel (4)

wobei

DCy gleich oder verschieden bei jedem Auftreten eine cyclische Gruppe ist, die mindestens ein Donoratom, vorzugsweise Stickstoff, Kohlenstoff in Form eines Carbens oder Phosphor, enthält, über das die cyclische Gruppe an das Metall gebunden ist, und die wiederum einen oder mehrere Substituenten $R^{18}$ tragen kann; die Gruppen DCy und CCy sind über eine kovalente Bindung miteinander verbunden;
CCy gleich oder verschieden bei jedem Auftreten eine cyclische Gruppe ist, die ein Kohlenstoffatom enthält, über das die cyclische Gruppe an das Metall gebunden ist, und die wiederum einen oder mehrere Substituenten $R^{18}$ tragen kann;
A gleich oder verschieden bei jedem Auftreten ein monoanionischer, zweizähniger chelatbildender Ligand, vorzugsweise ein Diketonat-Ligand ist;
$R^{18}$ bei jedem Auftreten gleich oder verschieden sind und F, Cl, Br, I, $NO_2$, CN, eine geradkettige, verzweigte oder cyclische Alkyl- oder Alkoxygruppe mit 1 bis 20 Kohlenstoffatomen, in der eine oder mehrere nicht benachbarte $CH_2$-Gruppen durch -O-, -S-, -$NR^{19}$-, -$CONR^{19}$-, -CO-O-, -C=O-, -CH=CH- oder -C≡C- ersetzt sein können und in der ein oder mehrere Wasserstoffatome durch F ersetzt sein können, oder eine Aryl- oder Heteroarylgruppe, die 4 bis 14 Kohlenstoffatome aufweist und durch einen oder mehrere nichtaromatische Reste $R^{18}$ substituiert sein kann, sind und eine Mehrzahl von Substituenten $R^{18}$, entweder am gleichen Ring oder an zwei verschiedenen Ringen, zusammen wiederum ein mono- oder polycyclisches, aliphatisches oder aromatisches Ringsystem bilden können; und
$R^{19}$ bei jedem Auftreten gleich oder verschieden sind und eine geradkettige, verzweigte oder cyclische Alkyl- oder Alkoxygruppe mit 1 bis 20 Kohlenstoffatomen, in der eine oder mehrere nicht benachbarte $CH_2$-Gruppen durch -O-, -S-, -CO-O-, -C=O-, - CH=CH- oder -C≡C- ersetzt sein können und in der ein oder mehrere Wasserstoffatome durch F ersetzt sein können, oder eine Aryl- oder Heteroarylgruppe, die 4 bis 14 Kohlenstoffatome aufweist und durch einen oder mehrere nichtaromatische Reste $R^{18}$ substituiert sein kann, sind.

**9.** Formulierung nach einem oder mehreren der Ansprüche 1 bis 8, **dadurch gekennzeichnet, dass** die Formulierung 0,1 bis 10 Gew.-% mindestens einer organischen Halbleiterverbindung mit einem Molekulargewicht von höchstens 5000 g/mol enthält.

**10.** Formulierung nach einem oder mehreren der Ansprüche 1 bis 9, **dadurch gekennzeichnet, dass** die Formulierung mindestens ein Netzmittel enthält.

**11.** Verwendung einer Formulierung nach einem oder mehreren der Ansprüche 1 bis 10 als Beschichtung oder Druckfarbe zur Herstellung von OE-Vorrichtungen.

**12.** Verfahren zur Herstellung einer organischen elektronischen (OE) Vorrichtung, umfassend die Schritte

a) Abscheiden der Formulierung nach einem oder mehreren der Ansprüche 1 bis 10 auf ein Substrat zur Bildung eines Films oder einer Schicht und
b) Entfernen des mindestens einen Lösungsmittels.

**13.** Organische elektronische Vorrichtung hergestellt aus einer Formulierung nach einem oder mehreren der Ansprüche 1 bis 10 oder durch ein Verfahren nach Anspruch 12.

## Revendications

**1.** Formulation comprenant au moins un composé de semiconduction organique (OSC), au moins un solvant organique, et au moins un liant polymérique, dans laquelle ledit au moins un composé de semiconduction organique est un matériau émetteur de lumière organique, dans laquelle ledit au moins un solvant organique comprend au moins un composé aromatique et/ou hétéroaromatique et dans laquelle ledit au moins un liant polymérique est un liant inerte, **caractérisée en ce que** ledit composé de semiconduction organique présente un poids moléculaire d'au plus 5 000 g/mol, ledit liant polymérique présente un poids moléculaire moyen en poids d'au moins 8 000 000 g/mol, déterminé par chromatographie par perméation de gel à l'encontre d'un standard polystyrène, et ladite composition présente une viscosité à 25°C d'au moins 15 mPas.

**2.** Formulation selon la revendication 1, **caractérisée en ce que** ledit liant polymérique est un polymère qui comprend des unités de répétition qui sont dérivées à partir de monomères de styrène et/ou d'oléfines, de préférence qui comprend au moins 80 % en poids d'unités de répétition qui sont dérivées à partir de monomères de styrène et/ou d'oléfines et de façon davantage préférable, qui comprend au moins 85 % en poids d'unités de répétition qui sont dérivées à partir de monomères de styrène.

**3.** Formulation selon la revendication 1 ou 2, **caractérisée en ce que** ladite formulation comprend dans la plage de 0,1 à 10 % en poids dudit au moins un liant polymérique.

**4.** Formulation selon une ou plusieurs des revendications 1 à 3, **caractérisée en ce que** ledit solvant organique comprend au moins un composé hydrocarbone aromatique.

**5.** Formulation selon une ou plusieurs des revendications 1 à 4, **caractérisée en ce que** ledit solvant organique comprend au moins 80 % en poids de composés présentant une viscosité à 25°C inférieure à 15 mPas.

**6.** Formulation selon une ou plusieurs des revendications 1 à 5, **caractérisée en ce que** ladite formulation comprend au moins 80 % en poids dudit au moins un solvant organique.

**7.** Formulation selon une ou plusieurs des revendications 1 à 6, **caractérisée en ce que** ledit au moins un matériau émetteur de lumière organique qui présente un poids moléculaire d'au plus 5 000 g/mol est un composé phosphorescent organique qui émet de la lumière et qui, en outre, contient au moins un atome qui présente un numéro atomique supérieur à 38.

**8.** Formulation selon la revendication 7, **caractérisée en ce que** ledit au moins un composé phosphorescent est un composé qui est sélectionné parmi les formules (1) à (4) :

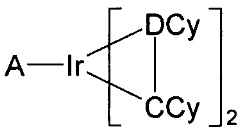

formule (1)

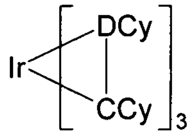

formule (2)

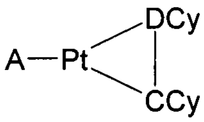

formule (3)

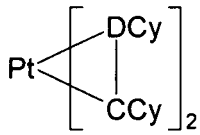

formule (4)

formules dans lesquelles :

DCy est, de manière identique ou différente pour chaque occurrence, un groupe cyclique qui contient au moins un atome donneur, de préférence azote, carbone sous la forme d'un carbène ou d'un phosphore, atome donneur via lequel le groupe cyclique est lié au métal, et lequel atome donneur peut à son tour être porteur d'un ou de plusieurs substituant(s) $R^{18}$ ; les groupes DCy et CCy sont connectés l'un à l'autre via une liaison covalente ;
CCy est, de manière identique ou différente pour chaque occurrence, un groupe cyclique qui contient un atome de carbone via lequel le groupe cyclique est lié au métal et lequel atome de carbone peut à son tour être porteur d'un ou de plusieurs substituant(s) $R^{18}$;
A est, de manière identique ou différente pour chaque occurrence, un ligand chélatant bidenté monoanionique, de préférence un ligand dicétonate ;
$R^{18}$ sont identiques ou différents à chaque fois, et sont F, Cl, Br, I, $NO_2$, CN, un groupe alkyle ou alcoxy en chaîne droite, ramifié ou cyclique qui comporte de 1 à 20 atome(s) de carbone, où un ou plusieurs groupe(s) $CH_2$ non adjacents peut/peuvent être remplacé(s) par -O-, -S-, $-NR^{19}-$, $-CONR^{19}-$, -CO-O-, -C=O-, -CH=CH- ou -C≡C-, et où un ou plusieurs atome(s) d'hydrogène peut/peuvent être remplacé(s) par F, ou un groupe aryle ou hétéroaryle qui comporte de 4 à 14 atomes de carbone et qui peut être substitué par un radical ou par plusieurs radicaux $R^{18}$ non aromatique(s), et les substituants d'une pluralité de substituants $R^{18}$, soit sur le même cycle, soit sur deux cycles différents, peuvent à leur tour former en association un système de cycle aliphatique ou aromatique monocyclique ou polycyclique ; et
$R^{19}$ sont identiques ou différents à chaque fois, et sont un groupe alkyle ou alcoxy en chaîne droite, ramifié ou cyclique qui comporte de 1 à 20 atome(s) de carbone, où un ou plusieurs groupe(s) $CH_2$ non adjacents peut/peuvent être remplacé(s) par -O-, -S-, -CO-O-, -C=O-, -CH=CH- ou -C≡C-, et où un ou plusieurs atome(s) d'hydrogène peut/peuvent être remplacé(s) par F, ou un groupe aryle ou hétéroaryle qui comporte de 4 à 14 atomes de carbone et qui peut être substitué par un radical ou par plusieurs radicaux $R^{18}$ non aromatique(s).

**9.** Formulation selon une ou plusieurs des revendications 1 à 8, **caractérisée en ce que** ladite formulation comprend 0,1 à 10 % en poids d'au moins un composé de semiconduction organique qui présente un poids moléculaire d'au plus 5 000 g/mol.

**10.** Formulation selon une ou plusieurs des revendications 1 à 9, **caractérisée en ce que** ladite formulation comprend au moins un agent d'humidification.

**11.** Utilisation d'une formulation selon une ou plusieurs des revendications 1 à 10 en tant qu'encre de revêtement ou d'impression pour la préparation de dispositifs électroniques organiques (OE).

**12.** Procédé de préparation d'un dispositif électronique organique (OE), comprenant les étapes consistant à :

a) déposer la formulation selon une ou plusieurs des revendications 1 à 10 sur un substrat de manière à former un film ou une couche ; et
b) enlever l'au moins un solvant.

**13.** Dispositif électronique organique préparé à partir d'une formulation selon une ou plusieurs des revendications 1 à

10 ou au moyen d’un procédé selon la revendication 12.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1883124 A1
- US 20070103059 A
- US 6818919 B
- US 7115430 B
- US 5952778 A
- US 6277504 B1
- US 6294273 B1
- WO 2005055248 A2
- WO 2007082584 A1
- WO 2011076380 A1
- WO 2011076325 A1
- WO 0070655 A
- WO 0141512 A
- WO 0202714 A
- WO 0215645 A
- EP 1191613 A
- EP 1191612 A
- EP 1191614 A
- WO 04081017 A
- WO 05033244 A
- WO 05042550 A
- WO 05113563 A
- WO 06008069 A
- WO 06061182 A
- WO 06081973 A
- DE 102008027005
- WO 06122630 A
- WO 08006449 A
- WO 07140847 A
- WO 06000388 A
- WO 06058737 A
- WO 06000389 A
- WO 07065549 A
- WO 07115610 A
- DE 102008035413
- JP 6001973 A
- WO 04047499 A
- WO 06098080 A
- WO 07065678 A
- US 20050260442 A
- WO 04092111 A
- EP 676461 A
- WO 04058911 A
- WO 05084081 A
- WO 05084082 A
- WO 06048268 A
- WO 06117052 A
- WO 08145239 A
- WO 04018587 A
- US 5935721 A
- US 20050181232 A
- JP 2000273056 A
- EP 681019 A
- US 20040247937 A
- US 20050211958 A
- EP 1476881 A
- EP 1596445 A
- WO 06100896 A
- EP 1661888 A
- WO 01049806 A
- US 5061569 A
- WO 9509147 A
- JP 2001226331 A
- EP 650955 A
- US 4780536 A
- WO 9830071 A
- EP 891121 A
- JP 2006253445 A
- WO 06073054 A
- JP 2000053957 A
- WO 03060956 A
- WO 04028217 A
- WO 04080975 A
- WO 04013080 A
- WO 04093207 A
- WO 06005627 A
- DE 102008033943
- WO 05039246 A
- US 20050069729 A
- JP 2004288381 A
- EP 1205527 A
- WO 08086851 A
- WO 07063754 A
- WO 08056746 A
- EP 1617710 A
- EP 1617711 A
- EP 1731584 A
- JP 2005347160 A
- WO 07137725 A
- WO 05111172 A
- DE 102008036982
- DE 102007053771

**Non-patent literature cited in the description**


- **ROGER P. WOODWARD, PH.D.** *Surface Tension Measurements Using the Drop Shape Method*
- **C. M. HANSEN.** Hansen Solubility Parameters: A User's Handbook. Taylor and Francis Group, LLC (HSPiP manual), 2007
- **C. M. HANSEN.** Hansen Solubility Parameters: A User's Handbook. Taylor and Francis Group, LLC, 2007
- **Y. SHIROTA et al.** *Chem. Rev.,* 2007, vol. 107 (4), 953-1010
- **M. FISCHER ; F. VÖGTLE.** *Angew. Chem., Int. Ed.,* 1999, vol. 38, 885